# EUROPEAN PATENT APPLICATION

(11) **EP 4 716 437 A1**
(43) Date of publication of application: **25.03.2026**
(21) Application number: 24811327.6
(22) Date of filing: 13.05.2024
(51) Int. Cl.: H10K 59/131, H10K 59/80, H10K 59/35, G09G 3/3233, H10K 59/126, H10K 59/121, H01L 29/786

(54) **DISPLAY DEVICE**

(30) Priority: 19.05.2023 KR 20230064987; 30.06.2023 KR 20230085335
(71) Applicant: Samsung Display Co., Ltd., Yongin-si, Gyeonggi-do 17113 (KR)
(72) Inventor: KIM, Dong Hyun, Yongin-si, Gyeonggi-do 17113 (KR); KIM, Su Jin, Yongin-si, Gyeonggi-do 17113 (KR); KANG, Chul Kyu, Yongin-si, Gyeonggi-do 17113 (KR); MOK, Seon Kyoon, Yongin-si, Gyeonggi-do 17113 (KR)
(74) Representative: Dr. Weitzel & Partner
(86) International application number: PCT/KR2024/006506
(87) International publication number: WO 2024/242388

(57) **Abstract**

Disclosed in an embodiment of the present invention is a display device in which a conductive layer disposed under a semi-conductor layer of a driving transistor corresponds to at least a channel region of the semiconductor layer to thus prevent disconnection of the semiconductor layer caused by a lower step, and a capacitor is formed by a plurality of conductive layers overlapping the channel region of the semiconductor layer and disposed under and on the top of the semiconductor layer to secure large capacitance. A display de vice according to one embodiment includes: a first conductive line; a first electrode disposed on the first conductive line and overlapping the first conductive line; a semiconductor layer disposed on the first electrode and overlapping the first electrode; a second electrode dis posed on the semiconductor layer and overlapping the first electrode; and a third electrode disposed on the second electrode, overlapping the second electrode, and electrically connected to the semiconductor layer and the first electrode, wherein a region of the semiconductor layer overlapping the second electrode overlaps the first conductive line.

## Description

### Technical Field

One or more embodiments relate to a pixel and a display apparatus including the same.

### Background Art

Recently, the usage of display apparatuses has diversified. Moreover, display apparatuses have become thinner and lighter, and thus, the usage thereof has expanded.

As display apparatuses are being used for various purposes, there are various methods of designing the shapes of display apparatuses, and functions which may be connected to or associated with display apparatuses have increased.

### Disclosure of Invention

### Technical Problem

One or more embodiments include a display apparatus having improved display quality. However, this objective is an example, and the scope of the disclosure is not limited thereto.

### Solution to Problem

According to one or more embodiments, a display apparatus includes a first conductive line, a first electrode arranged on the first conductive line and overlapping the first conductive line, a semiconductor layer arranged on the first electrode and overlapping the first electrode, a second electrode arranged on the semiconductor layer and overlapping the first electrode, and a third electrode arranged on the second electrode, overlapping the second electrode, and electrically connected to the semiconductor layer and the first electrode, wherein an area of the semiconductor layer, which overlaps the second electrode, overlaps the first conductive line.

The display apparatus may further include a fourth electrode electrically connected to the second electrode, the fourth electrode and the third electrode being arranged on a same layer, and a fifth electrode arranged on the fourth electrode, overlapping the fourth electrode, and electrically connected to the third electrode.

The display apparatus may further include a sixth electrode, the sixth electrode and the first conductive line being arranged on the same layer, wherein the first electrode, the second electrode, and the third electrode may overlap the sixth electrode, and the second electrode may be electrically connected to the sixth electrode.

An opening overlapping the sixth electrode may be defined in the first electrode, and the second electrode may be electrically connected to the sixth electrode through the opening.

The display apparatus may further include a seventh electrode electrically connected to the second electrode, the seventh electrode and the third electrode being arranged on a same layer, and an eighth electrode arranged on the seventh electrode, overlapping the seventh electrode, and electrically connected to the third electrode.

The display apparatus may further include a second conductive line spaced apart from the first conductive line, the second conductive line and the first conductive line being disposed on a same layer, wherein a voltage applied to the second conductive line may be different from a voltage applied to the first conductive line.

The first electrode may overlap the second conductive line.

According to one or more embodiments, a display apparatus includes a first circuit area where a pixel circuit of a first pixel is arranged and a second circuit area where a pixel circuit of a second pixel is arranged, a first conductive line arranged in the first circuit area and the second circuit area, a first electrode arranged on the first conductive line and overlapping the first conductive line, the first electrode being arranged in each of the first circuit area and the second circuit area, a semiconductor layer arranged on the first electrode and overlapping the first electrode, the semiconductor layer being arranged in each of the first circuit area and the second circuit area, a second electrode arranged on the semiconductor layer and overlapping the first electrode, the second electrode being arranged in each of the first circuit area and the second circuit area, and a third electrode arranged on the second electrode, overlapping the second electrode, and electrically connected to the semiconductor layer and the first electrode, the third electrode being arranged in each of the first circuit area and the second circuit area, wherein an area of the semiconductor layer, which overlaps the second electrode, overlaps the first conductive line.

The display apparatus may further include a fourth electrode electrically connected to the second electrode, the fourth electrode being arranged in each of the first circuit area and the second circuit area, the fourth electrode and the third electrode being arranged on a same layer, and a fifth electrode arranged on the fourth electrode, overlapping the fourth electrode, and electrically connected to the third electrode, the fifth electrode being arranged in each of the first circuit area and the second circuit area.

The display apparatus may further include a sixth electrode, the sixth electrode and the first conductive line being arranged on a same layer in the first circuit area, wherein the first electrode, the second electrode, and the third electrode may overlap the sixth electrode, and the second electrode may be electrically connected to the sixth electrode.

In the first circuit area, an opening overlapping the sixth electrode may be defined in the first electrode, and the second electrode may be electrically connected to the sixth electrode through the opening.

The display apparatus may further include a seventh electrode electrically connected to the second electrode, the seventh electrode being arranged in each of the first circuit area and the second circuit area, the seventh electrode and the third electrode being arranged on a same layer, and an eighth electrode arranged on the seventh electrode, overlapping the seventh electrode, and electrically connected to the third electrode, the eighth electrode being arranged in each of the first circuit area and the second circuit area.

According to one or more embodiments, a display apparatus includes a first circuit area where a pixel circuit of a first pixel is arranged and a second circuit area where a pixel circuit of a second pixel is arranged, a first conductive line arranged in the first circuit area and the second circuit area, a second conductive line spaced apart from the first conductive line, the second conductive line and the first conductive line being disposed on a same layer in the first circuit area and the second circuit area, a first electrode arranged on the first conductive line and overlapping the first conductive line, the first electrode being arranged in each of the first circuit area and the second circuit area, a semiconductor layer arranged on the first electrode and overlapping the first electrode, the semiconductor layer being arranged in each of the first circuit area and the second circuit area, a second electrode arranged on the semiconductor layer and overlapping the first electrode, the second electrode being arranged in each of the first circuit area and the second circuit area, and a third electrode arranged on the second electrode, overlapping the second electrode, and electrically connected to the semiconductor layer and the first electrode, the third electrode being arranged in each of the first circuit area and the second circuit area, wherein an area of the semiconductor layer, which overlaps the second electrode, overlaps the first conductive line.

The display apparatus may further include a fourth electrode electrically connected to the second electrode, the fourth electrode being arranged in each of the first circuit area and the second circuit area, the fourth electrode and the third electrode being arranged on a same layer, and a fifth electrode arranged on the fourth electrode, overlapping the fourth electrode, and electrically connected to the third electrode, the fifth electrode being arranged in each of the first circuit area and the second circuit area.

The display apparatus may further include a sixth electrode, the sixth electrode and the first conductive line being arranged on a same layer, wherein the first electrode, the second electrode, and the third electrode may overlap the sixth electrode, and the second electrode may be electrically connected to the sixth electrode.

In the first circuit area, an opening overlapping the sixth electrode may be defined in the first electrode, and the second electrode may be electrically connected to the sixth electrode through the opening.

The display apparatus may further include a seventh electrode electrically connected to the second electrode, the seventh electrode being arranged in each of the first circuit area and the second circuit area, the seventh electrode and the third electrode being arranged on a same layer, and an eighth electrode arranged on the seventh electrode, overlapping the seventh electrode, and electrically connected to the third electrode, the eighth electrode being arranged in each of the first circuit area and the second circuit area.

The display apparatus may further include a third circuit area where a pixel circuit of a third pixel is arranged. The first conductive line and the second conductive line may extend into the third circuit area, the first conductive line may include a plurality of sub-conductive lines spaced apart from each other, and an area which overlaps the second electrode, of the semiconductor layer arranged in the third circuit area may be located between the sub-conductive lines.

The first electrode may overlap the second conductive line.

An area where the first electrode arranged in the first circuit area overlaps the second conductive line may be different from an area where the first electrode arranged in the second circuit area overlaps the second conductive line.

### Advantageous Effects of Invention

According to the one or more of the above embodiments of the disclosure, a display apparatus having improved display quality may be provided. However, the scope of the disclosure is not limited to the effect as described above.

### Brief Description of Drawings

FIGS. 1a and 1b are schematic views of a display apparatus according to an embodiment.
FIG. 2 is a schematic view of a display apparatus according to an embodiment.
FIG. 3 is a schematic view illustrating an arrangement of emission areas of pixels, according to an embodiment.
FIG. 4 is a schematic diagram of an equivalent circuit of a pixel according to an embodiment.
FIG. 5 is a schematic layout view illustrating locations of transistors and capacitors of pixels, according to an embodiment.
FIGS. 6 to 16 are schematic layout views illustrating elements of a pixel for each layer.
FIG. 17 is a schematic cross-sectional view of elements of a pixel, taken along lines la-la' and IIa-IIa' of FIGS. 5 and 16.
FIG. 18 is a schematic cross-sectional view of elements of a pixel, taken along lines Ib-Ib' and IIb-IIb' of FIGS. 5 and 16.
FIG. 19 is a schematic cross-sectional view of elements of a pixel, taken along lines Ic-Ic' and IIc-IIc' of FIGS. 5 and 16.
FIGS. 20 and 21 are schematic views showing an arrangement relationship between a conductive layer and a semiconductor layer, according to a comparative example.
FIG. 22 is a schematic diagram of an equivalent circuit of a pixel according to an embodiment.
FIG. 23 is a schematic layout view illustrating locations of transistors and capacitors of pixels, according to an embodiment.
FIGS. 24 to 34 are schematic layout views illustrating elements of a pixel for each layer.
FIG. 35 is a schematic cross-sectional view of elements of a pixel, taken along lines IVa-IVa' and Va-Va' of FIGS. 23 and 34.
FIG. 36 is a schematic cross-sectional view of elements of a pixel, taken along lines IVb-IVb' and Vb-Vb' of FIGS. 23 and 34.
FIG. 37 is a schematic cross-sectional view of elements of a pixel, taken along lines IVc-IVc' and Vc-Vc' of FIGS. 23 and 34.
FIG. 38 is a schematic diagram of an equivalent circuit of a pixel according to an embodiment.
FIG. 39 is a schematic layout view illustrating locations of transistors and capacitors of pixels, according to an embodiment.
FIGS. 40 to 50 are schematic layout views illustrating elements of a pixel for each layer.
FIG. 51 is a schematic cross-sectional view of elements of a pixel, taken along lines VI-VI' and VII-VII' of FIGS. 39 and 50.
FIGS. 52a to 53b are schematic cross-sectional views showing a structure of a display element according to an embodiment.
FIG. 54 is a schematic cross-sectional view showing a structure of a pixel of a display apparatus according to an embodiment.

### Best Mode for Carrying out the Invention

According to one or more embodiments, a display apparatus includes a first conductive line, a first electrode arranged on the first conductive line and overlapping the first conductive line, a semiconductor layer arranged on the first electrode and overlapping the first electrode, a second electrode arranged on the semiconductor layer and overlapping the first electrode, and a third electrode arranged on the second electrode, overlapping the second electrode, and electrically connected to the semiconductor layer and the first electrode, wherein an area of the semiconductor layer, which overlaps the second electrode, overlaps the first conductive line.

### Mode for the Invention

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the description.

The term "and/or" includes all combinations of one or more of which associated configurations may define. For example, "A and/or B" may be understood to mean "A, B, or A and B." For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

While the disclosure is capable of various modifications and alternative forms, embodiments thereof are shown by way of example in the drawings and will herein be described in detail. Effects and characteristics of the disclosure, and realizing methods thereof will become apparent by referring to the drawings and embodiments described in detail below. However, the disclosure is not limited to the embodiments disclosed hereinafter and may be realized in various forms.

It will be understood that although the terms "first," "second," etc. may be used herein to describe various elements, these elements should not be limited by these terms. These terms are only used to distinguish one element from another.

As used herein, the singular expressions, e.g., "a" and "an," are intended to include the plural forms as well, unless the context clearly indicates otherwise.

It will be further understood that the terms "includes", "has", "including" and/or "having" used herein specify the presence of stated features or elements, but do not preclude the presence or addition of one or more other features or elements.

It will be understood that when a layer, region, or element is referred to as being formed "on" another layer, area, or element, it can be directly or indirectly formed on the other layer, region, or element. That is, for example, intervening layers, regions, or elements may be present.

In an embodiment described hereinafter, when X and Y are referred to as being connected to each other, it may include a case where X and Y are electrically connected to each other, a case where X and Y are functionally connected to each other, and a case where X and Y are physically connected to each other. And when X and Y are referred to as being connected to each other, it may indicate cases where X and Y are directly connected to each other, or X and Y are indirectly connected to each other. Here, X and Y may be an object (e.g., an apparatus, a device, a circuit, a line, an electrode, a terminal, a conductive layer, a layer, etc.). Thus, X and Y are not limited to a certain connection relationship, for example, a connection relationship indicated in the drawings or the detailed description. Rather, X and Y may include other connection relationships in addition to the connection relationship indicated in the drawings or the detailed description.

A case where X and Y are electrically connected to each other may include, for example, a case where X and Y are electrically and directly connected to each other, and a case where at least one device (e.g., a switch, a transistor, a capacitance device, an inductor, a resistance device, a diode, etc.) for electrical connection between X and Y is connected between X and Y.

In an embodiment described hereinafter, the terms "on" and "off" used in relation to a device state refer to an activated state of the device and a non-activated state of the device, respectively. The terms "on" and "off" used in relation to a signal received by a device may refer to a signal configured to activate the device and a signal configured to non-activate the device, respectively. The device may be activated by a high-level voltage or a low-level voltage. For example, a P-channel transistor (a P-type transistor) may be activated by a low-level voltage, and an N-channel transistor (an N-type transistor) may be activated by a high-level voltage. Thus, it shall be understood that the "on" voltages with respect to the P-type transistor and the N-type transistor may have voltage levels which are the opposite to each other (row versus high).

In an embodiment described hereinafter, an x direction, a y direction, and a z direction are not limited to directions in three axes on a rectangular coordinate system and may be interpreted in a broader sense. For example, the x direction, the y direction, and the z direction may be perpendicular to one another or may refer to different directions that are not perpendicular to one another.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

A display apparatus according to some embodiments of the disclosure may be an apparatus displaying a video or a static image. The electronic apparatus may be used as a display screen of various devices, such as a television, a notebook computer, a monitor, a broadcasting panel, and an Internet of things (IOT) device, as well as portable electronic devices, such as a mobile phone, a smart phone, a tablet personal computer (PC), a mobile communication terminal, an electronic notebook, an electronic book, a portable multimedia player (PMP), a navigation device, and an ultra-mobile PC (UMPC). Also, the display apparatus according to an embodiment may be used in wearable devices, such as a smart watch, a watch phone, a glasses-type display, and a head-mounted display (HMD). Also, the display apparatus according to an embodiment may be used as a center information display (CID) on a dashboard of a vehicle or a center fascia or a dashboard of the vehicle, a room mirror display substituting a side-view mirror of a vehicle, or a display disposed on a rear surface of a front seat, as an entertainment device for a backseat of a vehicle. Also, the display apparatus may be a flexible device.

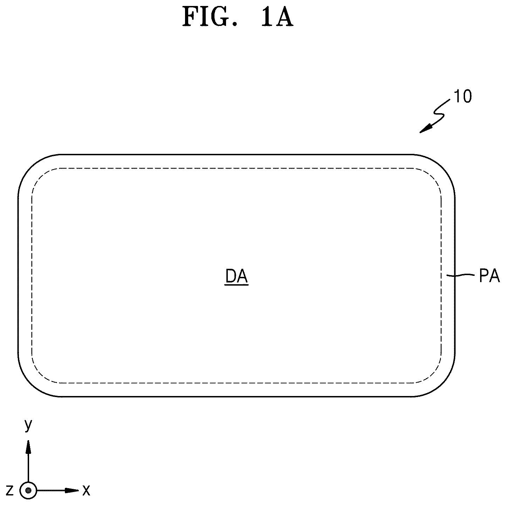

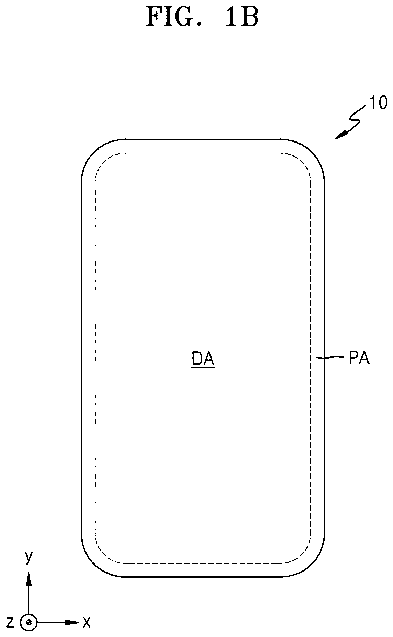

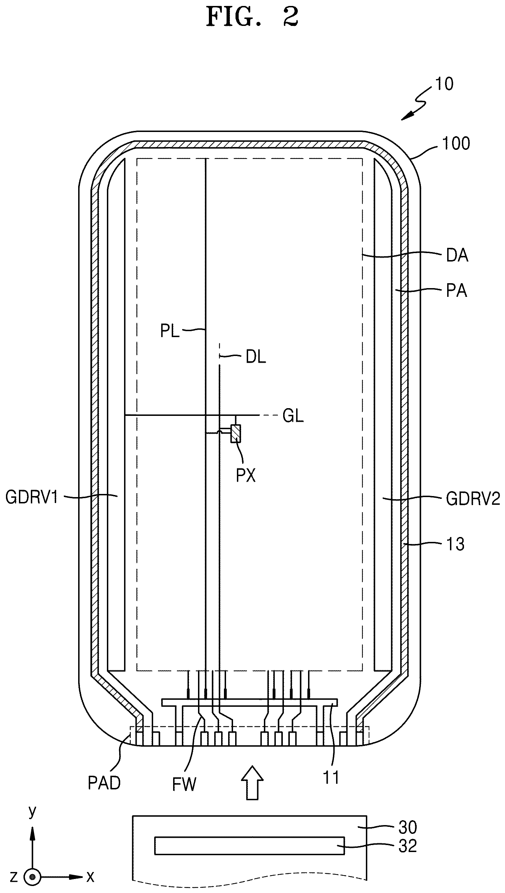

FIGS. 1a and 1b are schematic views of a display apparatus 1 according to an embodiment. FIG. 2 is a schematic view of a display panel 10 according to an embodiment.

Referring to FIGS. 1a and 1b, the display apparatus 1 may include a display area DA for displaying an image and a peripheral area PA outside the display area DA. The display area DA may be entirely surrounded by the peripheral area PA.

In a plan view, the display area DA may have a rectangular shape. According to another embodiment, the display area DA may have a polygonal shape, such as a triangular shape, a pentagonal shape, a hexagonal shape, etc., a circular shape, an oval shape, an amorphous shape, etc. The display area DA may have a rounded corner. In an embodiment, the display apparatus 1 may have the display area DA, a length of which in an x direction is greater than a length of which in a y direction, as illustrated in FIG. 1a. In another embodiment, the display apparatus 1 may have the display area DA, a length of which in a y direction is greater than a length of which in an x direction, as illustrated in FIG. 1b.

The display apparatus 1 may include a display panel 10, and a cover window (not shown) protecting the display panel 10 may be arranged above the display panel 10.

Various elements included in the display panel 10 may be arranged on a substrate 100. The substrate 100 and/or the display panel 10 may include the display area DA and a peripheral area PA surrounding the display area DA.

The substrate 100 may include at least one of various materials, e.g., a glass material, a ceramic material, a metal material, or a flexible or bendable material. The substrate 100 may have a single-layered structure including an organic layer or a multilayered structure including an organic layer and an inorganic layer. For example, the substrate 100 may have a stacked structure of a first base layer/a barrier layer/a second base layer. Each of the first base layer and the second base layer may be an organic layer including polymer resins. The first base layer and the second base layer may include transparent polymer resins. The barrier layer may be configured to prevent the penetration of external impurities and may include a single layer or layers including an inorganic material, such as SiNₓ or SiOₓ.

Pixels PX may be arranged in the display area DA. Gate lines GL, data lines DL, and pixels connected to the gate lines GL and the data lines DL may be arranged in the display area DA. The pixels PX may be arranged in various arrangement forms, for example, a stripe form, a pentile form, a diamond form, a mosaic form, etc., to realize an image. Each pixel PX may include an organic light-emitting diode as a display element (a light-emitting device), and the organic light-emitting diode may be connected to a pixel circuit. The pixel circuit may include transistors and at least one capacitor. The pixel PX may emit, for example, red, green, blue, or white light through the organic light-emitting diode. Each pixel PX may be connected to a gate line corresponding to the pixel PX among the gate lines GL and a data line corresponding to the pixel PX among the data lines DL.

Each of the gate lines GL may extend in the x direction (a row direction) and may be connected to the pixels PX arranged in the same row. Each of the gate lines GL may be configured to transmit a gate signal to the pixels PX arranged in the same row. Each of the data lines DL may extend in the y direction (a column direction) and may be connected to the pixels PX arranged in the same column. Each of the data lines DL may be synchronized to the gate signal and may be configured to transmit a data signal to each of the pixels PX in the same column. Each pixel PX may be connected to a driving voltage line PL and may be supplied with a driving voltage ELVDD. Each of the driving voltage lines PL may extend in the y direction (the column direction) and may be connected to the pixels PX arranged in the same column.

FIG. 2 illustrates an example in which the pixel PX is connected to a gate line GL. However, an embodiment of the disclosure is not limited thereto. The pixel PX may be connected to one or more gate lines GL.

Each of the pixel circuits configured to drive the pixels PX may be electrically connected to outer circuits arranged in the peripheral area PA. In an embodiment, a first gate driving circuit GDRV1, a second gate driving circuit GDRV2, a terminal portion PAD, a driving voltage supply line 11, a common voltage supply line 13, etc. may be arranged in the peripheral area PA.

In an embodiment, the peripheral area PA may be a non-display area in which the pixels PX are not arranged. In another embodiment, the pixels PX may be arranged in at least one corner of the peripheral area PA to overlap the outer circuit. Thus, a dead space may be reduced, and the display area DA may be expanded.

The first gate driving circuit GDRV1 may be connected to the gate lines GL and may be configured to apply, through the gate lines GL, the gate signal to each of the pixel circuits configured to drive the pixels PX. The second gate driving circuit GDRV2 may be arranged on an opposite side of the first gate driving circuit DRV1 with respect to the display area DA and may be approximately in parallel with the first gate driving circuit GDRV1. In an embodiment, the pixel circuits of the pixels PX of the display area DA may be electrically connected to the first gate driving circuit GDRV1 and the second gate driving circuit GDRV2. In another embodiment, some of the pixel circuits of the pixels PX of the display area DA may be electrically connected to the first gate driving circuit GDRV1 and the others may be electrically connected to the second gate driving circuit GDRV2. The second gate driving circuit GDRV2 may be omitted.

The terminal portion PAD may be arranged at a side of the substrate 100. The terminal portion PAD may not be covered by an insulating layer to be exposed and may be connected to a display circuit board 30. A display driver 32 may be arranged on the display circuit board 30.

The display driver 32 may include a data driving circuit. The data driving circuit may be connected to the data lines DL and may be configured to generate the data signal. The generated data signal may be transmitted to the pixel circuits of the pixels PX through a fanout line FW and the data line DL connected to the fanout line FW.

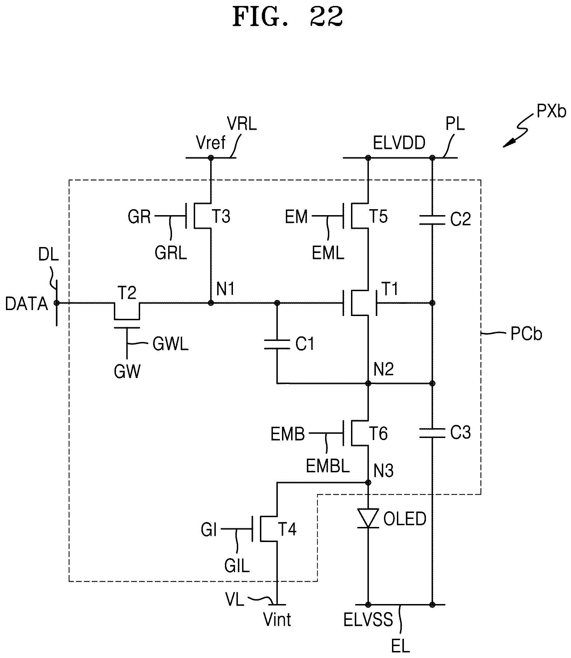

The display driver 32 may include a power supply circuit, and the power supply circuit may be configured to supply the driving voltage ELVDD to the driving voltage supply line 11 and a common voltage ELVSS to the common voltage supply line 13. The driving voltage ELVDD may be applied to the pixel circuits of the pixels PX through the driving voltage line PL of the display area DA connected to the driving voltage supply line 11, and the common voltage ELVSS may be applied to an opposite electrode of a display element through the common voltage supply line 13. In an embodiment, the common voltage supply line 13 and/or the opposite electrode may be connected to a common voltage line EL (see FIG. 22) of the display area DA, and the common voltage ELVSS may be applied to the common voltage line EL.

The display driver 32 may include a controller, and the controller may be configured to generate a control signal transmitted to the first gate driving circuit GDRV1, the second gate driving circuit GDRV2, the data driving circuit, and/or the power supply circuit.

The driving voltage supply line 11 may be connected the terminal portion PAD and may extend in the x direction at a lower portion of the display area DA. The common voltage supply line 13 may be connected to the terminal portion PAD and may have a loop shape having an open side to partially surround the display area DA.

Part or whole of the first gate driving circuit GDRV1 and the second gate driving circuit GDRV2 may be directly formed in the peripheral area PA of the substrate 100, during a process of forming the pixel circuit in the display area DA of the substrate 100. The display driver 32 may be formed as an integrated circuit chip and may be arranged on the display circuit board 30 electrically connected to the terminal potion PAD arranged at a side of the substrate 100. The display circuit board 30 may include a flexible printed circuit board (FPCB). In another embodiment, the display driver 32 may be directly arranged on the substrate 100 as a chip-on-glass (COG) or a chip-on-plastic (COP).

In an embodiment, the transistors included in the pixel circuits of the display area DA and transistors included in the outer circuit of the peripheral area PA, for example, the first gate driving circuit GDRV1 and the second gate driving circuit GDRV2, may be N-type oxide thin-film transistors. The transistors included in the outer circuit of the peripheral area PA may be simultaneously formed with the transistors included in the pixel circuits of the display area DA during the same process. In another embodiment, the transistors included in the pixel circuits of the display area DA may be N-type oxide thin-film transistors, and the transistors included in the outer circuit of the peripheral area PA may be P-type silicon thin-film transistors.

The oxide thin-film transistor may include a semiconductor layer including an oxide. The oxide semiconductor may include a Zn oxide-based material, such as a Zn oxide, an In-Zn oxide, a Ga-In-Zn oxide, etc. In some embodiments, the oxide semiconductor may include an In-Ga-Zn-O (IGZO) semiconductor in which metals including In and Ga are contained in ZnO. In some embodiments, the oxide semiconductor may include an In-Sn-Ga-Zn-O (ITGZO) semiconductor. In an embodiment, the oxide thin-film transistor may include a low-temperature polycrystalline oxide (LTPO) thin-film transistor. The silicon thin-film transistor may include a low-temperature poly-silicon (LTPS) thin-film transistor in which a semiconductor layer includes amorphous silicon, poly silicon, etc.

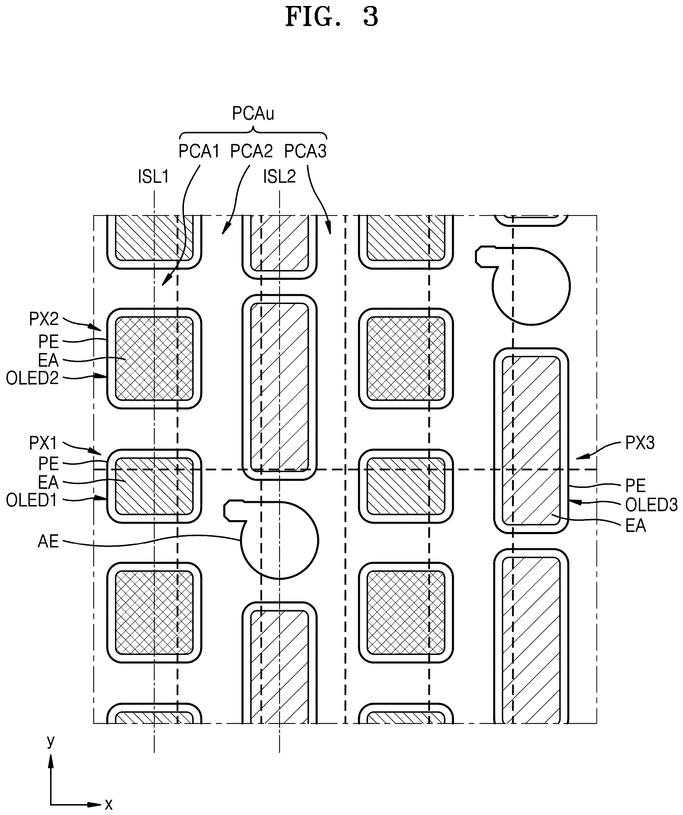

FIG. 3 is a schematic view illustrating an arrangement of emission areas of pixels according to an embodiment.

Referring to FIG. 3, the pixels PX arranged in the display area DA may include a first pixel PX1 emitting a first color, a second pixel PX2 emitting a second color, and a third pixel PX3 emitting a third color. For example, the first pixel PX1 may be a red pixel, the second pixel PX2 may be a green pixel, and the third pixel PX3 may be a blue pixel. The first pixel PX1, the second pixel PX2, and the third pixel PX3 may be repeatedly arranged in a certain pattern in an x direction and a y direction. Each of the first pixel PX1, the second pixel PX2, and the third pixel PX3 may include a pixel circuit and an organic light-emitting diode OLED as a display element electrically connected to the pixel circuit.

The display area DA defined on the substrate 100 may include pixel rows and pixel columns crossing (or intersecting) each other and may include circuit areas. A pixel row and a pixel column may cross each other, and the pixel circuit may be arranged in each circuit area. In an embodiment, a unit circuit area PCAu including two or more circuit areas adjacent to each other in the x direction may be defined. For example, the unit circuit area PCAu may include three circuit areas, e.g.,, a first circuit area PCA1, a second circuit area PCA2, and a third circuit area PCA3, which are adjacent to each other in the x direction. The first circuit area PCA1 may be an area in which the pixel circuit of the first pixel PX1 is arranged. The second circuit area PCA2 may be an area in which the pixel circuit of the second pixel PX2 is arranged. The third circuit area PCA3 may be an area in which the pixel circuit of the third pixel PX3 is arranged.

The pixel circuits PC arranged in the first to third circuit areas PCA1 to PCA3 may be electrically connected to the display elements emitting light of different colors from each other. Each of the pixel circuits PC arranged in the first to third circuit areas PCA1 to PCA3 may be configured to drive the display elements electrically connected thereto. For example, the display element electrically connected to the pixel circuit arranged in the first circuit area PCA1 may emit red light. The display element electrically connected to the pixel circuit arranged in the second circuit area PCA2 may emit green light. The display element electrically connected to the pixel circuit arranged in the third circuit area PCA3 may emit blue light.

FIG. 3 illustrates a pixel electrode PE and an emission area EA of each of the first to third pixels PX1 to PX3. The emission area EA may be an area in which an emission layer EL of the organic light-emitting diode OLED is arranged. The emission area EA may be defined by an opening of a pixel-defining layer. Because the emission layer is arranged on the pixel electrode PE, the arrangement of the emission area EA illustrated in FIG. 3 may be understood as the arrangement of the pixel electrode PE or the arrangement of the pixel PX.

The emission area EA may have a polygonal shape, such as a quadrangular shape or an octagonal shape, a circular shape, an oval shape, etc., and the polygonal shape may include shapes having rounded corners (vertexes).

The emission area EA of the first pixel PX1 and the emission area EA of the second pixel PX2 may be arranged to be adjacent to each other in the y direction, and the emission area EA of the third pixel PX3 may be arranged to be adjacent to the emission area EA of the first pixel PX1 and the emission area EA of the second pixel PX2 in the x direction. Accordingly, the emission area EA of the first pixel PX1 and the emission area EA of the second pixel PX2 may be alternately arranged in the y direction in a virtual straight line ISL1, and the emission area EA of the third pixel PX3 may be repeatedly arranged in the y direction in a virtual straight line ISL2.

A length in the x direction and a length in the y direction of each of the emission areas EA of the first to third pixels PX1 to PX3 may be the same as or different from each other. For example, the emission area EA of the first pixel PX1 may have a square shape, and the emission area EA of the second pixel PX2 and the emission area EA of the third pixel PX3 may have a rectangular shape having a long side in the y direction. The length in the y direction of the emission area EA of the third pixel PX3 may be equal to or greater than the sum of the length in the y direction of the emission area EA of the first pixel PX1 and the length in the y direction of the emission area EA of the second pixel PX2.

The emission area EA of the first pixel PX1, the emission area EA of the second pixel PX2, and the emission area EA of the third pixel PX3 may have different areas (sizes) from each other. In an embodiment, the emission area EA of the third pixel PX3 may have a greater area than the emission area EA of the first pixel PX1. The emission area EA of the third pixel PX3 may have a greater area than the emission area EA of the second pixel PX2. The emission area EA of the second pixel PX2 may have a greater area than the emission area EA of the first pixel PX1.

An auxiliary electrode AE may be further arranged between the emission areas EA. The auxiliary electrode AE may be arranged between the emission areas EA of the third pixel PX3. The auxiliary electrode AE may contact the opposite electrode and/or the common voltage line in the display area DA.

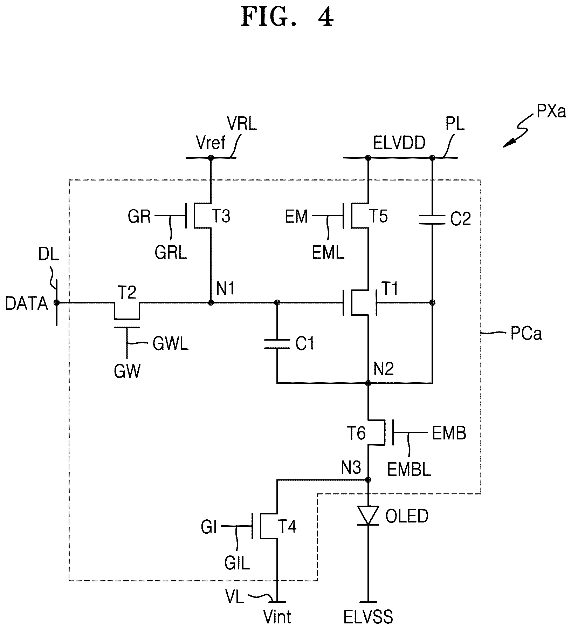

FIG. 4 is a schematic diagram of an equivalent circuit of a pixel PXa according to an embodiment.

Referring to FIG. 4, the pixel PXa may include a pixel circuit PCa and an organic light-emitting diode OLED as a display element connected to the pixel circuit PCa.

The pixel PXa may be connected to a first gate line GWL configured to transmit a first gate signal GW, a second gate line GIL configured to transmit a second gate signal GI, a third gate line GRL configured to transmit a third gate signal GR, a fourth gate line EML configured to transmit a fourth gate signal EM, a fifth gate line EMBL configured to transmit a fifth gate signal EMB, and a data line DL configured to transmit a data signal. Emission of the pixel PX may be controlled by the fourth gate signal EM and the fifth gate signal EMB, and thus, the fourth gate signal EM and the fifth gate signal EMB may also be referred to as emission control signals, and the fourth gate line EML and the fifth gate line EMBL may also be referred to as emission control lines. The pixel PX may be connected to a driving voltage line PL configured to transmit a driving voltage ELVDD, a reference voltage line VRL configured to transmit a reference voltage Vref, and an initialization voltage line VL configured to transmit an initialization voltage Vint.

In an embodiment, transistors included in the pixel circuit PCa may include N-type oxide thin-film transistors. The oxide thin-film transistor may include an LTPO thin-film transistor including a semiconductor layer including an oxide. However, the LTPO thin-film transistor is only an example, and the N-type transistors are not limited thereto. For example, the semiconductor layer included in the N-type transistor may include an inorganic semiconductor (e.g., amorphous silicon, poly silicon, etc.) or an organic semiconductor.

The pixel circuit PCa may include first to sixth transistors T1 to T6 and first and second capacitors C1 and C2. The first transistor T1 may be a driving transistor configured to output a driving current corresponding to a data signal DATA, and the second to sixth transistors T2 to T6 may be switching transistors configured to transmit signals. A first terminal (a first electrode) and a second terminal (a second electrode) of each of the first to sixth transistors T1 to T6 may be a source (or a source electrode) or a drain (or a drain electrode) according to voltages of the first terminal and the second terminal. For example, according to the voltages of the first terminal and the second terminal, the first terminal may be a drain, and the second terminal may be a source; or the first terminal may be a source, and the second terminal may be a drain. Hereinafter, a node to which a first gate of the first transistor T1 is connected may be defined as a first node N1, and a node to which the second terminal of the first transistor T1 is connected may be defined as a second node N2.

The first transistor T1 may be connected to the driving voltage line PL and the organic light-emitting diode OLED. The first transistor T1 may be connected between the fifth transistor T5 and the sixth transistor T6. The first transistor T1 may include a gate, the first terminal, and the second terminal that is connected to the second node N2. The first transistor T1 may include the first gate connected to the first node N1. The first transistor T1 may further include a second gate connected to the second terminal of the first transistor T1. The first gate and the second gate may be arranged on different layers from each other to face each other. For example, the first gate and the second gate of the first transistor T1 may be arranged to face each other with the semiconductor layer therebetween. Hereinafter, a gate (or a gate electrode) of the first transistor T1 may denote the first gate involved in the turning on and turning off of the first transistor T1.

The first gate of the first transistor T1 may be connected to the second terminal of the second transistor T2, the first terminal of the third transistor T3, and the first capacitor C1. The second gate of the first transistor T1 may be connected to the first terminal of the sixth transistor T6, the first capacitor C1, and the second capacitor C2. The first terminal of the first transistor T1 may be connected to the driving voltage line PL through the fifth transistor T5, and the second terminal of the first transistor T1 may be connected to a pixel electrode of the organic light-emitting diode OLED through the sixth transistor T6. The first terminal of the first transistor T1 may be connected to the second terminal of the fifth transistor T5. The second terminal of the first transistor T1 may be connected to the first terminal of the sixth transistor T6, the first capacitor C1, and the second capacitor C2. The first transistor T1 may be configured to receive a data signal DATA according to a switching operation of the second transistor T2 and may be configured to control a current amount of a driving current flowing to the organic light-emitting diode OLED.

The second transistor T2 (a write transistor) may be connected to the data line DL and the first gate of the first transistor T1. The second transistor T2 may include a gate connected to the first gate line GWL, the first terminal connected to the data line DL, and the second terminal connected to the first node N1. The second terminal of the second transistor T2 may be connected to the first gate of the first transistor T1, the first terminal of the third transistor T3, and the first capacitor C1. The second transistor T2 may be turned on by the first gate signal GW transmitted through the first gate line GWL and may be configured to electrically connect the data line DL with the first node N1 and transmit the data signal DATA transmitted through the data line DL to the first node N1.

The third transistor T3 (a first initialization transistor) may be connected to the first gate of the first transistor T1 and the reference voltage line VRL. The third transistor T3 may include a gate connected to the third gate line GRL, the first terminal connected to the first node N1, and the second terminal connected to the reference voltage line VRL. The first terminal of the third transistor T3 may be connected to the first gate of the first transistor T1, the second terminal of the second transistor T2, and the first capacitor C1. The third transistor T3 may be turned on by the third gate signal GR transmitted through the third gate line GRL and may be configured to transmit the reference voltage Vref transmitted through the reference voltage line VRL to the first node N1.

The fourth transistor T4 (a second initialization transistor) may be connected to the sixth transistor T6 and the initialization voltage line VL. The fourth transistor T4 may be connected between the organic light-emitting diode OLED and the initialization voltage line VL. The fourth transistor T4 may include a gate connected to the second gate line GIL, the first terminal connected to a third node N3, and the second terminal connected to the initialization voltage line VL. The first terminal of the fourth transistor T4 may be connected to the second terminal of the sixth transistor T6 and the pixel electrode of the organic light-emitting diode OLED. The fourth transistor T4 may be turned on by the second gate signal GI transmitted through the second gate line GIL and may be configured to transmit the initialization voltage Vint transmitted through the initialization voltage line VL to the third node N3.

The fifth transistor T5 (a first emission control transistor) may be connected to the driving voltage line PL and the first transistor T1. The fifth transistor T5 may include a gate connected to the fourth gate line EML, the first terminal connected to the driving voltage line PL, and the second terminal connected to the first terminal of the first transistor T1. The fifth transistor T5 may be turned on or turned off according to the fourth gate signal EM transmitted through the fourth gate line EML.

The sixth transistor T6 (a second emission control transistor) may be connected to the first transistor T1 and the organic light-emitting diode OLED. The sixth transistor T6 may be connected between the second node N2 and the third node N3. The sixth transistor T6 may include a gate connected to the fifth gate line EMBL, the first terminal connected to the second node N2, and the second terminal connected to the third node N3. The first terminal of the sixth transistor T6 may be connected to the second terminal of the first transistor T1, the first capacitor C1, and the second capacitor C2. The second terminal of the sixth transistor T6 may be connected to the first terminal of the fourth transistor T4 and the pixel electrode of the organic light-emitting diode OLED. The sixth transistor T6 may be turned on or turned off according to the fifth gate signal EMB transmitted through the fifth gate line EMBL.

The first capacitor C1 may be connected between the first gate of the first transistor T1 and the second terminal of the first transistor T1. A first electrode of the first capacitor C1 may be connected to the first node N1, and a second electrode of the first capacitor C1 may be connected to the second node N2. The first electrode of the first capacitor C1 may be connected to the first gate of the first transistor T1, the second terminal of the second transistor T2, and the first terminal of the third transistor T3. The second electrode of the first capacitor C1 may be connected to the second terminal and the second gate of the first transistor T1, a second electrode of the second capacitor C2, and the first terminal of the sixth transistor T6. The first capacitor C1 may be a storage capacitor and may be configured to store a threshold voltage of the first transistor T1 and a voltage corresponding to the data signal DATA.

In case that the third transistor T3 and the fifth transistor T5 are turned on together, the first transistor T1 may be turned on. In case that a voltage of the second terminal of the first transistor T1 reaches to a value of a difference Vref-Vth between the reference voltage Vref and a threshold voltage Vth of the first transistor T1, the first transistor T1 may be turned off, and a voltage corresponding to the threshold voltage Vth of the first transistor T1 may be stored in the first capacitor C1, so that the threshold voltage Vth of the first transistor T1 may be compensated for.

The second capacitor C2 may be connected between the driving voltage line PL and the second node N2. A first electrode of the second capacitor C2 may be connected to the driving voltage line PL. A second electrode of the second capacitor C2 may be connected to the second terminal and the second gate of the first transistor T1, the second electrode of the first capacitor C1, and the first terminal of the sixth transistor T6.

A capacitance of each of the first capacitor C1 and the second capacitor C2 may vary according to a color of light emitted by the pixel PX.

The organic light-emitting diode OLED may be connected to the first transistor T1 through the sixth transistor T6. The organic light-emitting diode OLED may include the pixel electrode (an anode) connected to the third node N3 and an opposite electrode (a cathode) facing the pixel electrode, and the opposite electrode may receive a common voltage EVLSS. The opposite electrode may be a common electrode, which is common to pixels PX. In case that the fifth transistor T5 and the sixth transistor T6 are turned on, the first transistor T1 may output a driving current, which may flow through the organic light-emitting diode OLED, and the organic light-emitting diode OLED may emit light with a brightness or luminance corresponding to a magnitude of the driving current.

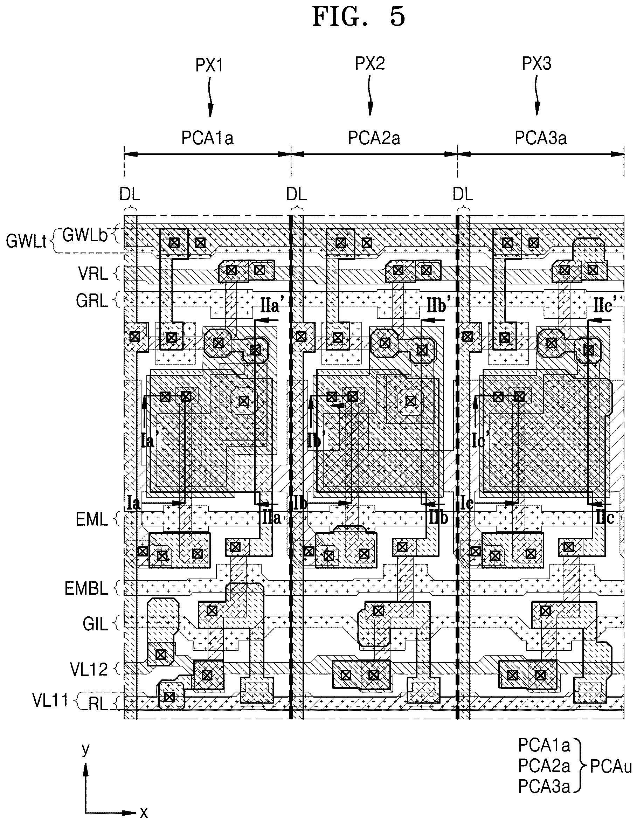

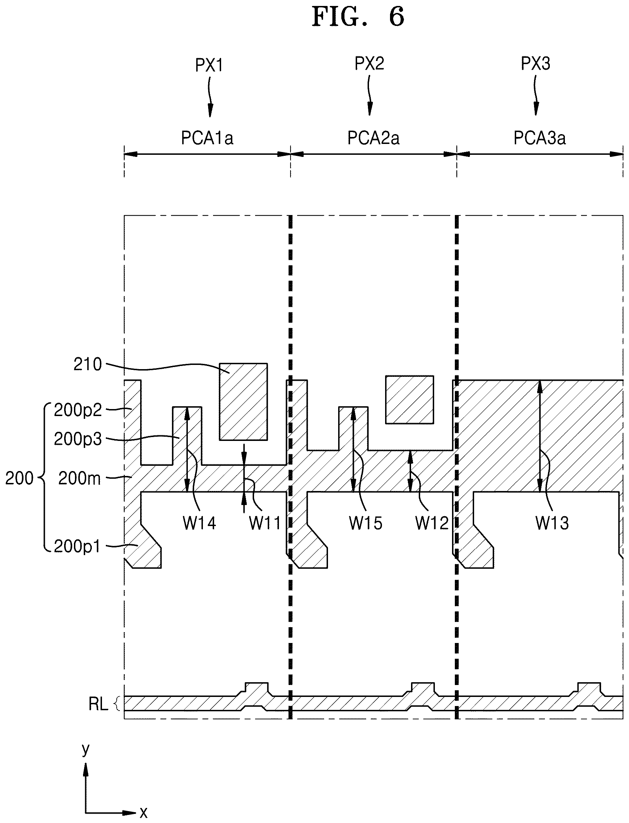

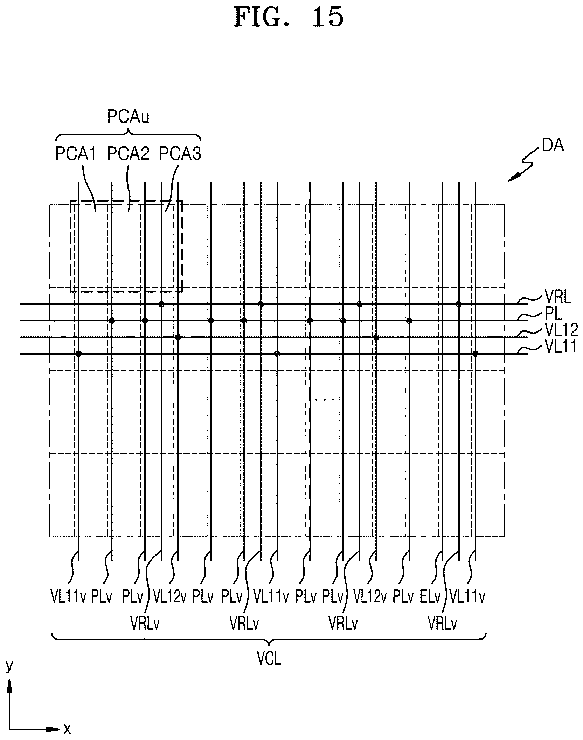

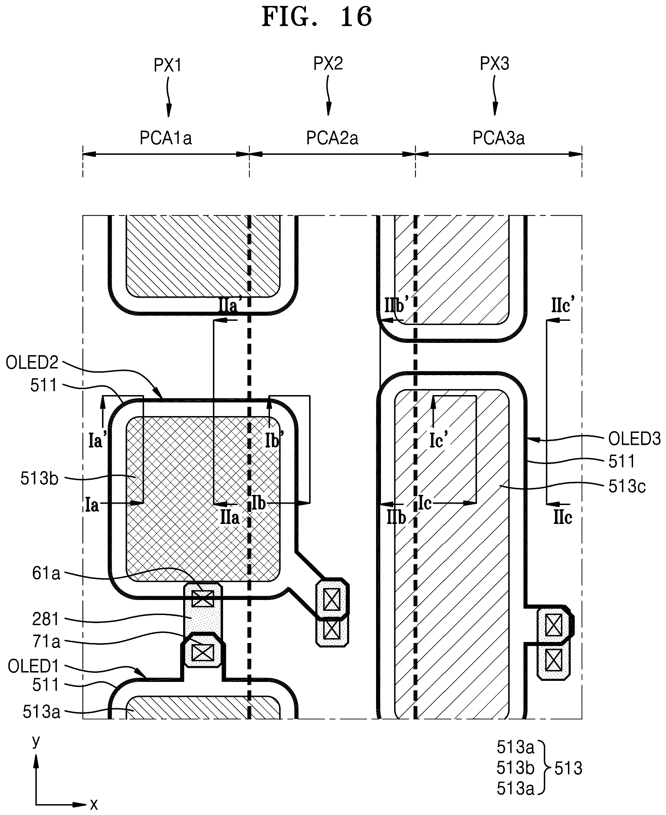

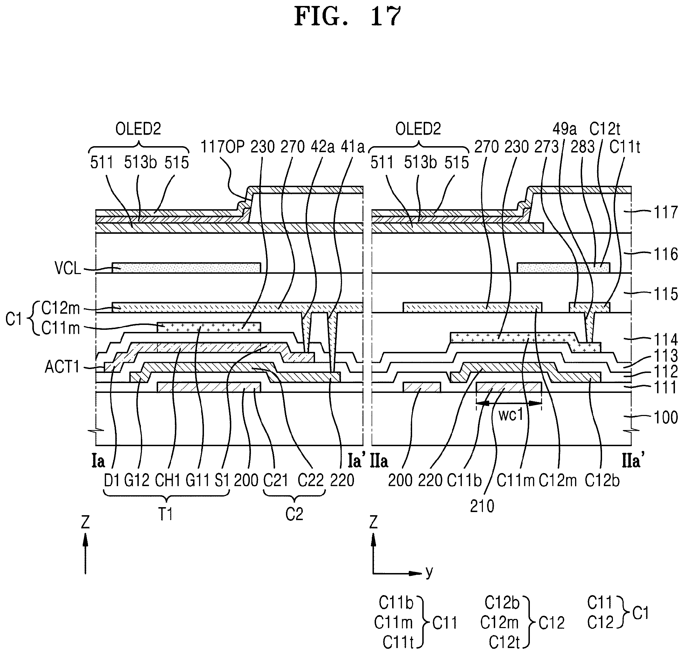

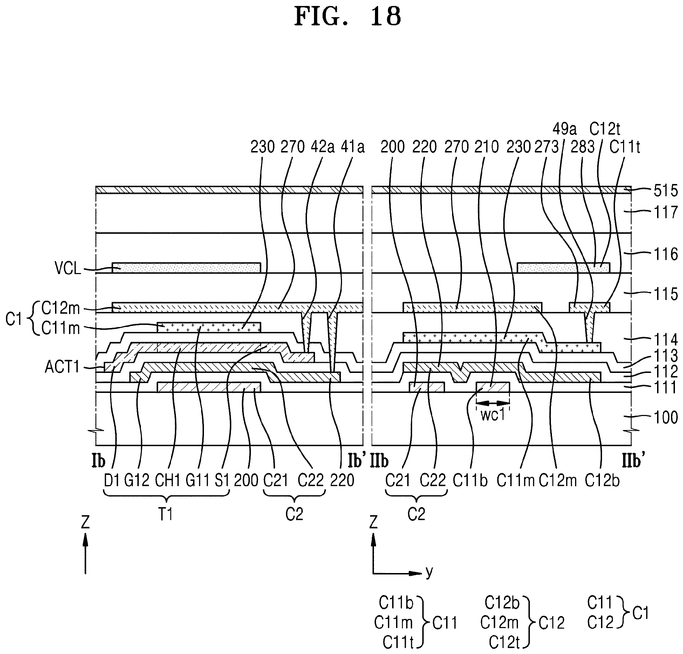

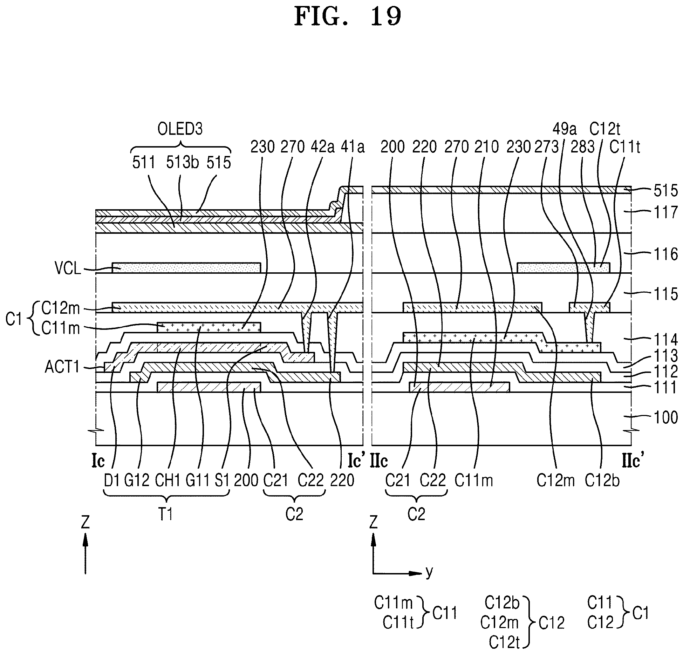

FIG. 5 is a schematic layout view illustrating locations of transistors and capacitors of pixels according to an embodiment. FIGS. 6 to 16 are schematic layout views illustrating elements of a pixel for each layer. FIG. 15 is a schematic view illustrating an arrangement of vertical conductive lines according to an embodiment. FIG. 17 is a schematic cross-sectional view of the elements of the pixel, taken along lines la-la' and IIa-IIa' of FIGS. 5 and 16. FIG. 18 is a schematic cross-sectional view of the elements of the pixel, taken along lines Ib-Ib' and IIb-IIb' of FIGS. 5 and 16. FIG. 19 is a schematic cross-sectional view of the elements of the pixel, taken along lines Ic-Ic' and IIc-IIc' of FIGS. 5 and 16.

In FIG. 5, pixel circuits arranged in a first circuit area PCA1a, a second circuit area PCA2a, and a third circuit area PCA3a may correspond to the pixel circuit PCa of the pixel shown in FIG. 4.

In an embodiment, in consideration of the emission characteristics of the first to third pixels PX1 to PX3, initialization voltages Vint supplied to the first to third pixels PX1 to PX3 may be different from each other. For example, the pixel circuit PCa of the first pixel PX1 may be connected to a 1-1-th initialization voltage line VL11, and the pixel circuit PCa of the second pixel PX2 and the pixel circuit PCa of the third pixel PX3 may be connected to a 1-2-th initialization voltage line VL12. The initialization voltage supplied to the 1-1-th initialization voltage line VL11 and the initialization voltage supplied to the 1-2-th initialization voltage line VL12 may be different from each other.

The same devices may be arranged on each layer of the first to third circuit areas PCA1a to PCA3a. Hereinafter, for convenience of illustration and explanation, reference numerals are assigned to the devices of the pixel circuit PCa arranged in the first circuit area PCA1a, and the description is given based on the first circuit area PCA1a. However, the description may be likewise applied to the same elements of the second and third circuit areas PCA2a and PCA3a. Hereinafter, descriptions will be provided with reference to FIGS. 6 to 19. Hereinafter, a connection electrode may be an electrode configured to electrically connect conductive lines or electrodes (conductive patterns) arranged on different layers from each other and transmit a signal.

A first conductive layer may be arranged on the substrate 100. As illustrated in FIG. 6, the first conductive layer may include a conductive line 200, a first electrode 210, and a repair line RL. In an embodiment, a barrier layer may be further arranged between the substrate 100 and the first conductive layer.

The first electrode 210 may be provided as an island type. The first electrode 210 may be arranged to be adjacent to the conductive line 200 in the first circuit area PCA1a and the second circuit area PCA2a and may not be arranged in the third circuit area PCA3a. In an embodiment, the area of the first electrode 210 of the first circuit area PCA1a may be greater than the area of the first electrode 210 of the second circuit area PCA2a.

The conductive line 200 may extend in the x direction and may be arranged to cross the first circuit area PCA1a, the second circuit area PCA2a, and the third circuit area PCA3a. The conductive line 200 may be a driving voltage line PL to which the driving voltage ELVDD is applied. Hereinafter, the conductive line 200 and the driving voltage line PL may be used interchangeably. The conductive line 200 may include a main line 200m extending in the x direction in each circuit area and a protrusion portion 200p1 protruding in a -y direction from the main line 200m. The conductive line 200 may further include a protrusion portion 200p2 and a protrusion portion 200p3, which protrude in a +y direction, in each of the first circuit area PCA1a and the second circuit area PCA2a.

The area of the conductive line 200 may be different for each circuit area. The area of the conductive line 200 may be adjusted according to the y direction width of the main line 200m, the x direction and y direction widths (lengths) of the protrusion portion, and the like. In an embodiment, the area of the conductive line 200 in the third circuit area PCA3a may be greater than the area of the conductive line 200 in the first circuit area PCA1a and the second circuit area PCA2a. The area of the conductive line 200 in the second circuit area PCA2a may be greater than the area of the conductive line 200 in the first circuit area PCA1a. A y direction width w13 of the main line 200m in the third circuit area PCA3a may be greater than a y direction width w12 of the main line 200m in the second circuit area PCA2a, and the y direction width w12 of the main line 200m in the second circuit area PCA2a may be greater than a y direction width w11 of the main line 200m in the first circuit area PCA1a. The y direction width w13 of the main line 200m in the third circuit area PCA3a may be at least greater than or equal to a y direction length of a channel region of the first transistor T1.

In the first circuit area PCA1a and the second circuit area PCA2a, the protrusion portion 200p2 may overlap the data line DL. In the first circuit area PCA1a and the second circuit area PCA2a, the protrusion portion 200p3 may overlap the channel region of the first transistor T1. A y direction width w14 of the main line 200m and the protrusion portion 200p3 in the first circuit area PCA1a and a y direction width w15 of the main line 200m and the protrusion portion 200p3 in the second circuit area PCA2a may be equal to each other and may be at least greater than or equal to the y direction length of the channel region of the first transistor T1.

The repair line RL may extend in the x direction and may be arranged to cross the first circuit area PCA1a, the second circuit area PCA2a, and the third circuit area PCA3a.

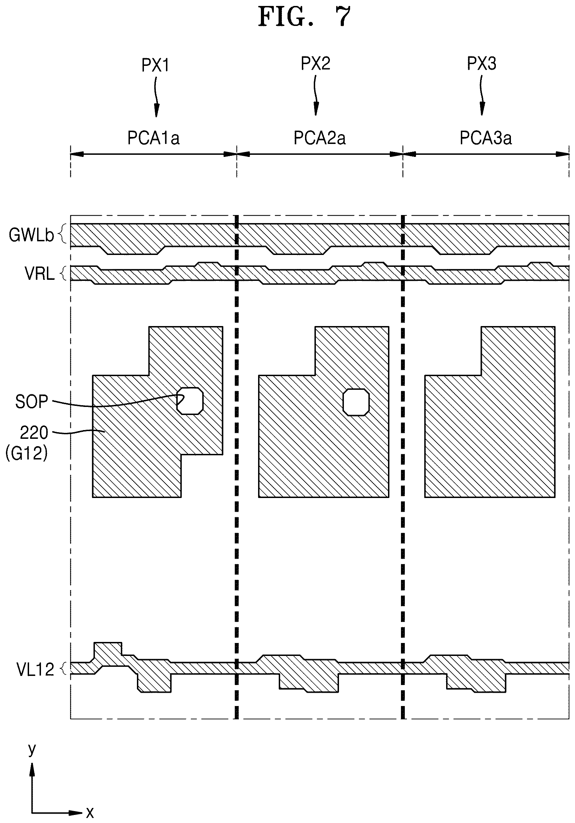

A first insulating layer 111 may be arranged on the substrate 100 to cover or overlap the first conductive layer, and a second conductive layer may be arranged on the first insulating layer 111. As illustrated in FIG. 7, the second conductive layer may include a second electrode 220, a lower first gate line GWLb, a reference voltage line VRL, a 1-2-th initialization voltage line VL12.

The second electrode 220 may be provided as an island type. The second electrode 220 may overlap the first electrode 210 and the conductive line 200. The second electrode 220 may include a second gate electrode G12 and a source electrode of the first transistor T1. An opening SOP overlapping the first electrode 210 may be defined in the second electrode 220 in the first circuit area PCA1a and the second circuit area PCA2a. The area of the second electrode 220 may be different for each circuit area. For example, the area of the second electrode 220 in the second circuit area PCA2a and the third circuit area PCA3a may be greater than the area of the second electrode 220 in the first circuit area PCA1a. The area where the second electrode 220 overlaps the conductive line 200 in the second circuit area PCA2a may be greater than the area where the second electrode 220 overlaps the conductive line 200 in the first circuit area PCA1a. The area where the second electrode 220 overlaps the conductive line 200 in the third circuit area PCA3a may be greater than the area where the second electrode 220 overlaps the conductive line 200 in the first circuit area PCA1a and the second circuit area PCA2a.

The lower first gate line GWLb, the reference voltage line VRL, and the 1-2-th initialization voltage line VL12 may extend in the x direction and may be arranged to cross the first to third circuit areas PCA1a to PCA3a.

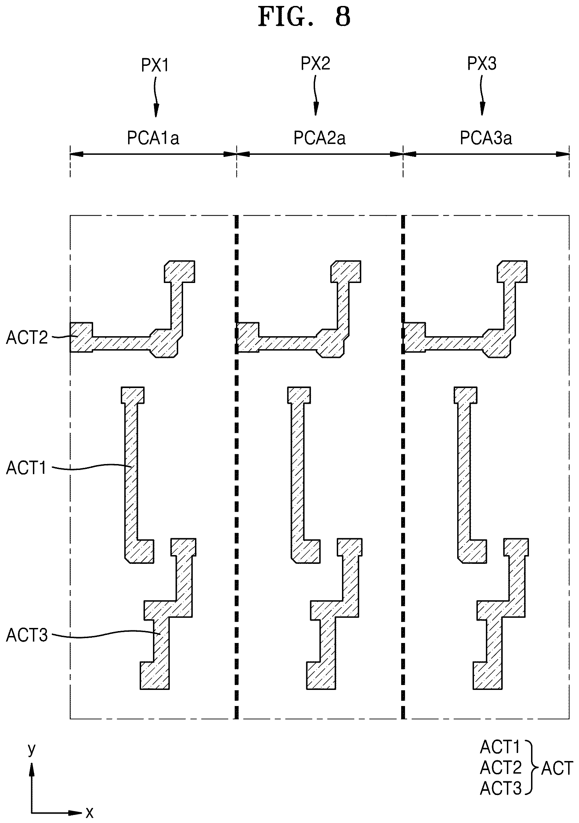

A second insulating layer 112 may be arranged on the first insulating layer 111 to cover or overlap the second conductive layer, and a semiconductor layer ACT including an oxide semiconductor may be arranged on the second insulating layer 112 as illustrated in FIG. 8. The semiconductor layer ACT may include a first semiconductor layer ACT1, a second semiconductor layer ACT2, and a third semiconductor layer ACT3. The semiconductor layer ACT may include a source region, a drain region and a channel region between the source region and the drain region of each of the first to sixth transistors T1 to T6. The source region or the drain region may also be interpreted as a source electrode or a drain electrode of the transistor, according to embodiments.

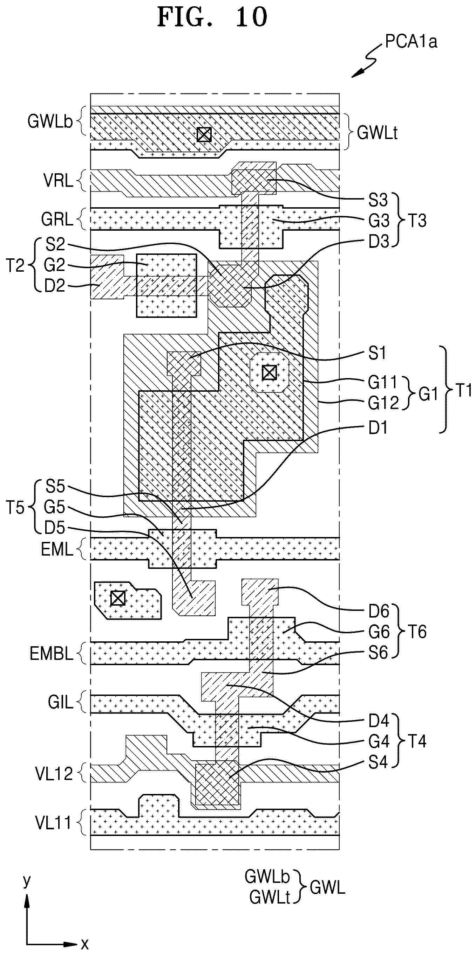

FIG. 10 illustrates the transistors of the first circuit area PCA1a. Referring to FIG. 10, the first semiconductor layer ACT1 may include a source region S1 and a drain region D1 of the first transistor T1 and a source region S5 and a drain region D5 of the fifth transistor T5. The second semiconductor layer ACT2 may include a source region S2 and a drain region D2 of the second transistor T2 and a source region S3 and a drain region D3 of the third transistor T3. The third semiconductor layer ACT3 may include a source region S4 and a drain region D4 of the fourth transistor T4 and a source region S6 and a drain region D6 of the sixth transistor T6.

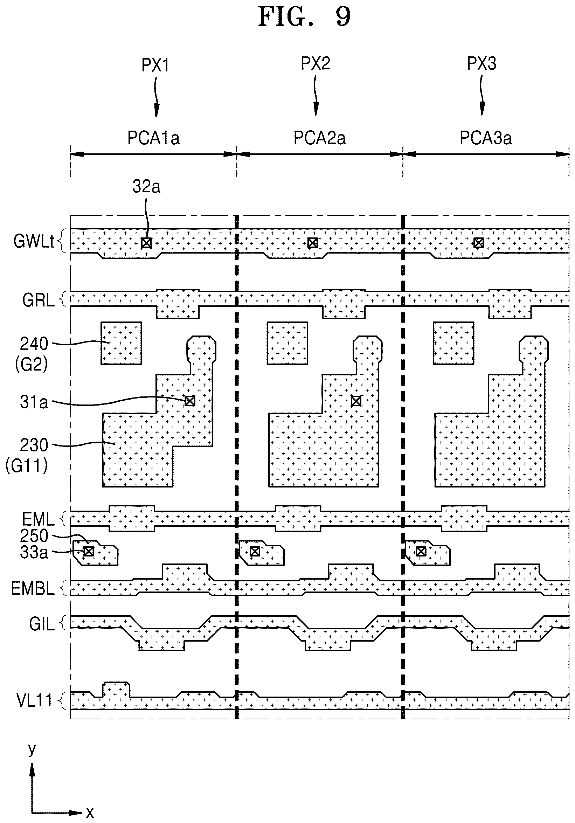

A third insulating layer 113 may be arranged on the second insulating layer 112 to cover or overlap the semiconductor layer ACT, and a third conductive layer may be arranged on the third insulating layer 113. As illustrated in FIG. 9, the third conductive layer may include a third electrode 230, a fourth electrode 240, a connection electrode 250, an upper first gate line GWLt, the second gate line GIL, the third gate line GRL, the fourth gate line EML, the fifth gate line EMBL, and/or the 1-1-th initialization voltage line VL11.

The third electrode 230, the fourth electrode 240, and the connection electrode 250 may be provided as an island type. The third electrode 230, the fourth electrode 240, and the connection electrode 250 may be arranged in each of the first to third circuit areas PCA1a to PCA3a.

The area of the third electrode 230 may be different for each circuit area. For example, the area of the third electrode 230 in the second circuit area PCA2a and the third circuit area PCA3a may be greater than the area of the third electrode 230 in the first circuit area PCA1a. The area where the third electrode 230 overlaps the second electrode 220 in the second circuit area PCA2a and the third circuit area PCA3a may be greater than the area where the third electrode 230 overlaps the second electrode 220 in the first circuit area PCA1a.

In the first and second circuit areas PCA1a and PCA2a, the third electrode 230 may be electrically connected to the first electrode 210 through a contact hole 31a passing through the first to third insulating layers 111 to 113. The contact hole 31a may be insulated from the opening SOP of the second electrode 220 and may be arranged in the opening SOP.

In the first to third circuit areas PCA1a to PCA3a, the connection electrode 250 may be electrically connected to the protrusion portion 200p1 of the conductive line 200 through a contact hole 33a passing through the first to third insulating layers 111 to 113.

The upper first gate line GWLt, the second gate line GIL, the third gate line GRL, the fourth gate line EML, the fifth gate line EMBL, and the 1-1-th initialization voltage line VL11 may extend in the x direction and may be arranged to cross the first to third circuit areas PCA1a to PCA3a.

The upper first gate line GWLt may overlap the lower first gate line GWLb and may be electrically connected to the lower first gate line GWLb through a contact hole 32a passing through the second and third insulating layers 112 and 113.

As illustrated in FIG. 10, the third conductive layer may include gate electrodes G1 to G6 of the first to sixth transistors T1 to T6. The gate electrodes G1 to G6 may overlap the channel regions of the semiconductor layer ACT.

Referring to FIG. 10, the third electrode 230 may include a first gate electrode G11 of the first transistor T1. The first gate electrode G11 may overlap the first semiconductor layer ACT1. The fourth electrode 240 may correspond to a gate electrode G2 of the second transistor T2. The fourth electrode 240 may overlap the second semiconductor layer ACT2. A gate electrode G3 of the third transistor T3 may be a portion of the third gate line GRL overlapping the second semiconductor layer ACT2. A gate electrode G4 of the fourth transistor T4 may be a portion of the second gate line GIL overlapping the third semiconductor layer ACT3. A gate electrode G5 of the fifth transistor T5 may be a portion of the fourth gate line EML overlapping the first semiconductor layer ACT1. A gate electrode G6 of the sixth transistor T6 may be a portion of the fifth gate line EMBL overlapping the third semiconductor layer ACT3.

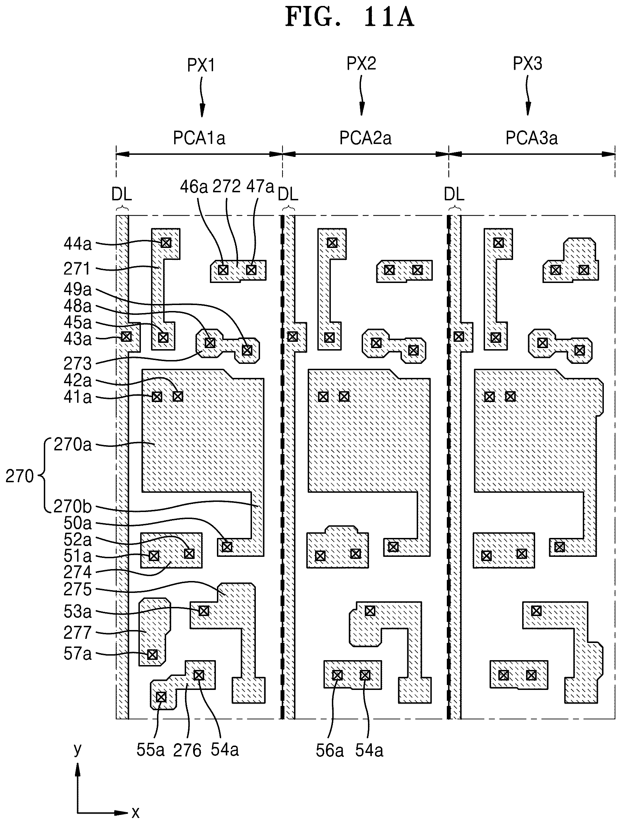

A fourth insulating layer 114 may be arranged on the third insulating layer 113 to cover or overlap the third conductive layer, and a fourth conductive layer may be arranged on the fourth insulating layer 114. As illustrated in FIG. 11a, the fourth conductive layer may include a data line DL and connection electrodes 270, 271, 272, 273, 274, 275, 276, and 277.

The data line DL may be arranged to extend in the y direction for each circuit area. The data line DL may be electrically connected to the drain region D2 of the second transistor T2 through a contact hole 43a passing through the third insulating layer 113 and the fourth insulating layer 114.

The connection electrode 270 may include a first area 270a overlapping the first to third electrodes 210 to 230 and a second area 270b protruding from the first area 270a in the -y direction. The connection electrode 270 may electrically connect the source region S1 of the first transistor T1 to the second gate electrode G12 of the first transistor T1 and the sixth transistor T6.

The first area 270a of the connection electrode 270 may be electrically connected to the source region S1 of the first transistor T1 through a contact hole 42a passing through the third and fourth insulating layers 113 and 114. The first area 270a of the connection electrode 270 may be electrically connected to the second electrode 220 through a contact hole 41a passing through the second to fourth insulating layers 112 to 114. Accordingly, the connection electrode 270 may correspond to a source electrode electrically connected to the source region S1 of the first transistor T1. The second electrode 220 may correspond to the second gate electrode G12 of the first transistor T1, and the second gate electrode G12 may face the first gate electrode G11 of the first transistor T1 and overlap the channel region of the first transistor T1. With the connection electrode 270 connected to the second electrode 220, the second gate electrode G12 of the first transistor T1 may be electrically connected to the source region S1 of the first transistor T1.

The second area 270b of the connection electrode 270 may be electrically connected to the drain region D6 of the sixth transistor T6 through a contact hole 50a passing through the third and fourth insulating layers 113 and 114.

The connection electrode 271 may be electrically connected to the gate electrode G2 of the second transistor T2 through a contact hole 45a passing through the fourth insulating layer 114. The connection electrode 271 may be electrically connected to the upper first gate line GWLt through a contact hole 44a passing through the fourth insulating layer 114.

The connection electrode 272 may be electrically connected to the source region S3 of the third transistor T3 through a contact hole 46a passing through the third and fourth insulating layers 113 and 114 and may be electrically connected to the reference voltage line VRL through a contact hole 47a passing through the second to fourth insulating layers 112 to 114.

The connection electrode 273 may be electrically connected to the source region S2 of the second transistor T2 and the drain region D3 of the third transistor T3 through a contact hole 48a passing through the third and fourth insulating layers 113 and 114. The connection electrode 273 may be electrically connected to the third electrode 230 through a contact hole 49a passing through the fourth insulating layer 114 and may be electrically connected to the first gate electrode G11 of the first transistor T1. The connection electrode 273 may correspond to a node electrode corresponding to the first node N1 of FIG. 4. The connection electrode 273 may correspond to a bridge electrode electrically connecting at least two transistors. For example, the connection electrode 273 may correspond to the bridge electrode connecting the first gate electrode G11 of the first transistor T1, the source region S2 of the second transistor T2, and the drain region D3 of the third transistor T3.

The connection electrode 274 may be electrically connected to the protrusion portion 200p1 of the conductive line 200 through a contact hole 51a passing through the first to fourth insulating layers 111 to 114. The connection electrode 274 may be electrically connected to the drain region D5 of the fifth transistor T5 through a contact hole 52a passing through the third and fourth insulating layers 113 and 114. Thus, the drain region D5 of the fifth transistor T5 may be electrically connected to the conductive line 200.

The connection electrode 275 may be electrically connected to the source region S6 of the sixth transistor T6 and the drain region D4 of the fourth transistor T4 through a contact hole 53a passing through the third and fourth insulating layers 113 and 114. The connection electrode 275 may overlap a portion of the repair line RL. The connection electrode 275 may be insulated from the repair line RL, and in case that defects occur later in the pixel circuit arranged in the circuit area, the connection electrode 275 may be electrically connected to the repair line RL.

In the first circuit area PCA1a, the connection electrode 276 may be electrically connected to the source region S4 of the fourth transistor T4 through a contact hole 54a passing through the third and fourth insulating layers 113 and 114. The connection electrode 276 may be connected to the 1-1-th initialization voltage line VL11 through a contact hole 55a passing through the fourth insulating layer 114.

In the second and third circuit area PCA2a and PCA3a, the connection electrode 276 may be electrically connected to the source region S4 of the fourth transistor T4 through the contact hole 54a passing through the third and fourth insulating layers 113 and 114. The connection electrode 276 may be electrically connected to the 1-2-th initialization voltage line VL12 through a contact hole 56a passing through the second to fourth insulating layers 112 to 114.

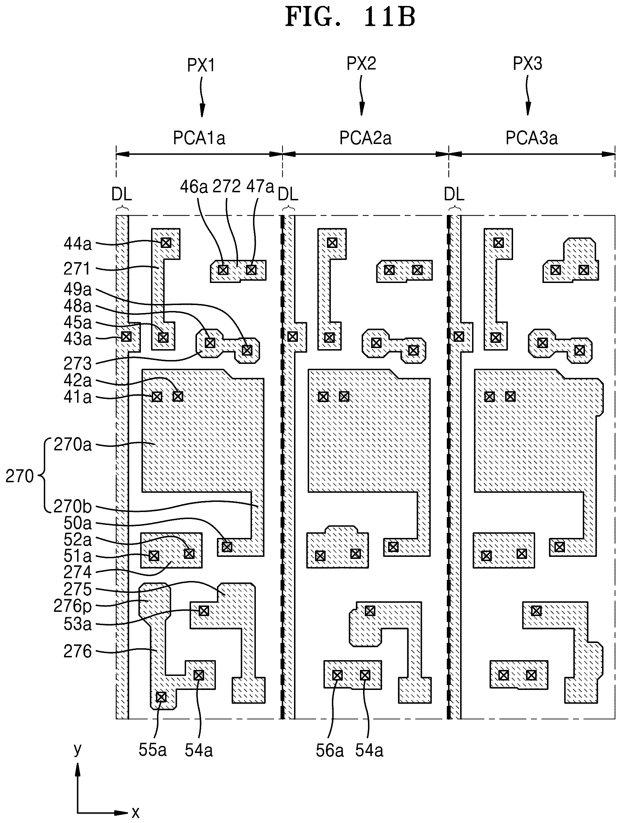

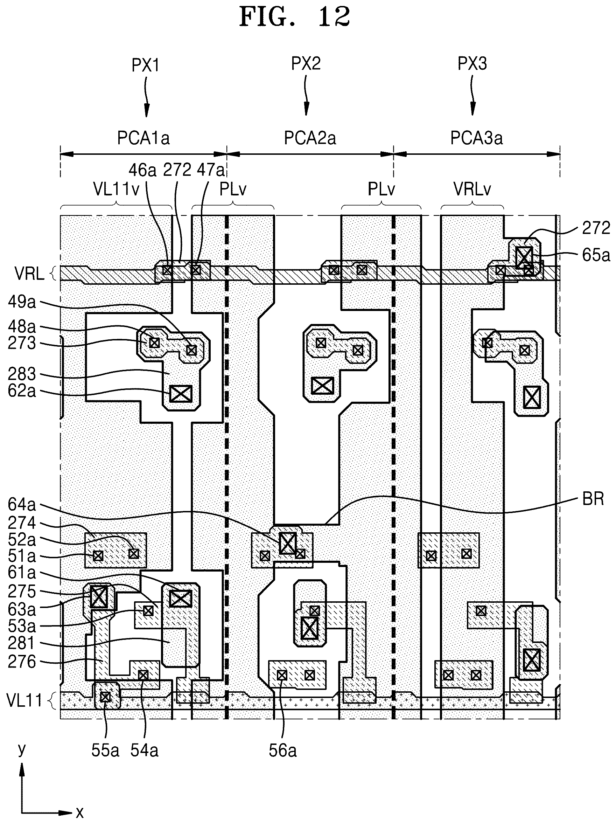

In some of the first circuit areas PCA1a, the connection electrode 276 may further have a protrusion portion 276p, as shown in FIG. 11b. For example, the protrusion portion 276p of the connection electrode 276 may be formed only in the first circuit areas PCA1a where a first vertical initialization voltage line VL11v (see FIG. 12) among the vertical conductive lines described below is arranged.

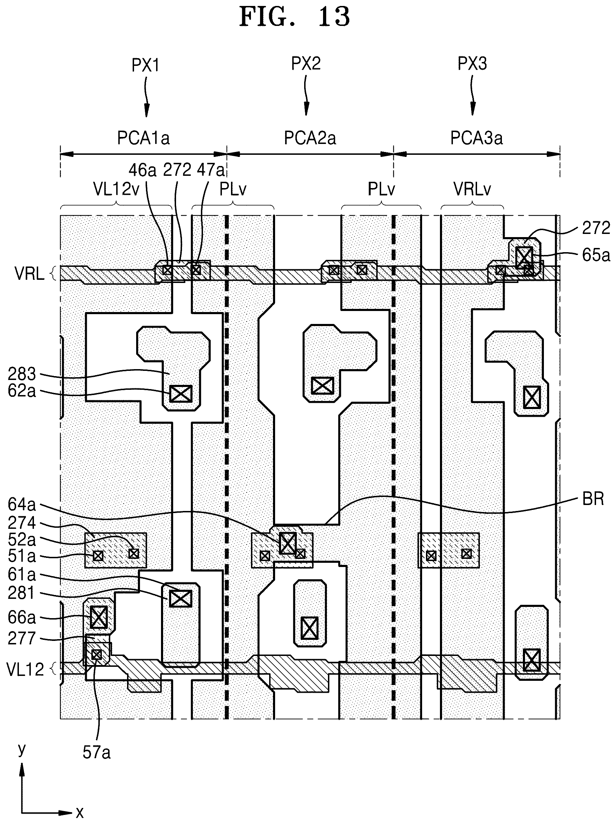

In the first circuit area PCA1a, the connection electrode 277 may be electrically connected to the 1-2-th initialization voltage line VL12 through a contact hole 57a passing through the second to fourth insulating layers 112 to 114. The connection electrode 277 may be arranged in some first circuit areas PCA1a of the first circuit areas PCA1a. For example, the connection electrode 277 may be arranged in only the first circuit areas PCA1a in which a second vertical initialization voltage line VL12v (see FIG. 13) among vertical conductive lines described below is arranged.

A fifth insulating layer 115 may be arranged above the fourth insulating layer 114 to cover or overlap the fourth conductive layer, and a fifth conductive layer may be arranged above the fifth insulating layer 115. As illustrated in FIGS. 12 to 15, the fifth conductive layer may include vertical conductive lines VCL and connection electrodes 281 and 283. FIGS. 12 to 14 illustrate only some of lower conductive lines connected to the fifth conductive layer, for convenience of illustration and explanation.

The connection electrode 281 may be electrically connected to the connection electrode 275 through a contact hole 61a passing through the fifth insulating layer 115 and may be electrically connected to the source region S6 of the sixth transistor T6.

The connection electrode 283 may be electrically connected to the connection electrode 270 through a contact hole 62a passing through the fifth insulating layer 115. The connection electrode 283 may be arranged to cover and overlap the connection electrode 273, which is a node electrode. The second electrode 220 may be arranged below the connection electrode 273, and the connection electrode 283 may be arranged above the connection electrode 273. The connection electrode 283 may entirely cover the connection electrode 273, and the second electrode 220 may entirely cover the connection electrode 273. The connection electrode 283 may function as an upper shielding layer of the connection electrode 273, and the second electrode 220 may function as a lower shielding layer of the connection electrode 273.

The vertical conductive lines VCL may include a vertical driving voltage line PLv, a first vertical initialization voltage line VL11v, the second vertical initialization voltage line VL12v, a vertical common voltage line ELv, and/or a vertical reference voltage line VRLv. The vertical conductive lines VCL each may extend in the y direction and may be arranged to be spaced apart from each other in the x direction in the first to third circuit areas PCA1a to PCA3a.

Four vertical conductive lines may be arranged to be spaced apart from each other in the x direction in the first to third circuit areas PCA1a to PCA3a. For example, four vertical conductive lines among the first vertical initialization voltage line VL11v, the second vertical initialization voltage line VL12v, the vertical driving voltage line PLv, the vertical common voltage line ELv, and the vertical reference voltage line VRLv may be arranged to be spaced apart from each other in the x direction. The vertical conductive lines VCL may be electrically connected to horizontal conductive lines extending in the x direction. The horizontal conductive lines may include the conductive line 200 that is the driving voltage line PL, the 1-1-th initialization voltage line VL11, the 1-2-th initialization voltage line VL12, and the reference voltage line VRL.

FIG. 12 illustrates an example in which a first vertical initialization voltage line VL11v, a pair of vertical driving voltage lines PLv, and a vertical reference voltage line VRLv are sequentially arranged in the x direction in the first to third circuit areas PCA1a to PCA3a.

FIG. 13 illustrates an example in which a second vertical initialization voltage line VL12v, a pair of vertical driving voltage lines PLv, and a vertical reference voltage line VRLv are sequentially arranged in the x direction in the first to third circuit areas PCA1a to PCA3a.

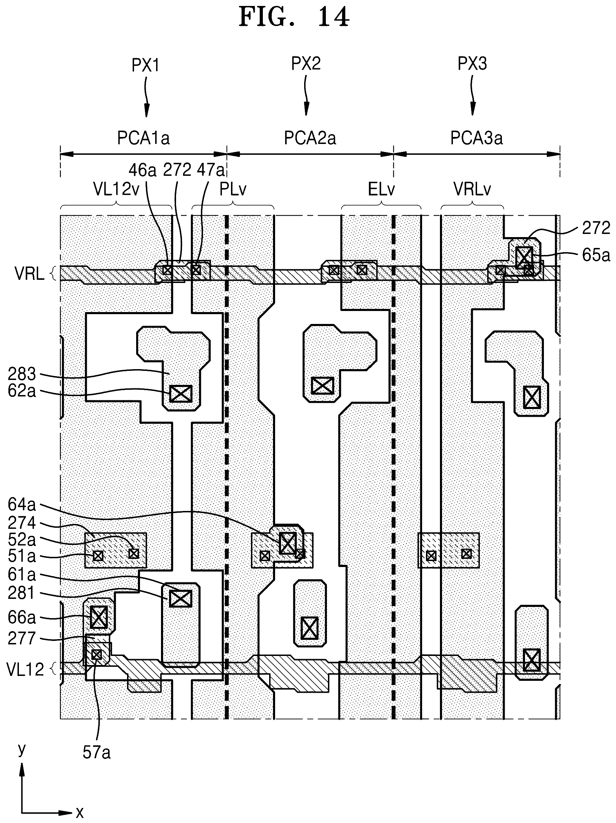

FIG. 14 illustrates an example in which a second vertical initialization voltage line VL12v, a vertical driving voltage line PLv, a vertical common voltage line ELv, and a vertical reference voltage line VRLv are sequentially arranged in the x direction in the first to third circuit areas PCA1a to PCA3a.

The pair of vertical driving voltage lines PLv adjacent to each other may be connected by a connection portion BR. The pair of vertical driving voltage lines PLv may be integral with each other. In an embodiment, the connection portion BR may be located every two rows. For example, as illustrated in FIG. 13, the pair of vertical driving voltage lines PLv may be connected to each other by the connection portion BR in odd-numbered rows or even-numbered rows and may be spaced apart from each other without the connection portion BR in even-numbered rows or odd-numbered rows.

In an embodiment, as shown in FIG. 15, a first vertical conductive line VCL of the unit circuit area PCAu may be the first vertical initialization voltage line VL11v or a second vertical initialization voltage line VL12v. A fourth vertical conductive line VCL of the unit circuit area PCAu may be the vertical reference voltage line VRLv. Second and third vertical conductive lines VCL of the unit circuit area PCAu may be the pair of vertical driving voltage lines PLv or the pair of vertical driving voltage lines PLv and the vertical common voltage line ELv.

As illustrated in FIG. 12, the first vertical initialization voltage line VL11v may be electrically connected to the connection electrode 276 arranged in the first circuit area PCA1a through a contact hole 63a passing the fifth insulating layer 115. The connection electrode 276 may be electrically connected to the 1-1-th initialization voltage line VL11, and the 1-1-th initialization voltage line VL11 may have a mesh structure in the display area DA.

As illustrated in FIG. 13, the second vertical initialization voltage line VL12v may be electrically connected to the connection electrode 277 arranged in the first circuit area PCA1a through a contact hole 66a passing through the fifth insulating layer 115. The connection electrode 277 may be electrically connected to the 1-2-th initialization voltage line VL12, and the 1-2-th initialization voltage line VL12 may have a mesh structure in the display area DA.

As illustrated in FIGS. 12 to 14, the vertical driving voltage line PLv may be electrically connected to the connection electrode 274 arranged in the second circuit area PCA2a through a contact hole 64a passing through the fifth insulating layer 115. The connection electrode 274 may be electrically connected to the conductive line 200, and the driving voltage line PL may have a mesh structure in the display area DA.

As illustrated in FIG. 14, the vertical common voltage line ELv may be electrically connected to the common voltage supply line 13 (see FIG. 2) arranged in the peripheral area PA.

As illustrated in FIGS. 12 to 14, the vertical reference voltage line VRLv may be electrically connected to the connection electrode 272 arranged in the third circuit area PCA3a through a contact hole 65a passing through the fifth insulating layer 115. The connection electrode 272 may be electrically connected to the reference voltage line VRL, and the reference voltage line VRL may have a mesh structure in the display area DA.

Although not shown in the drawings, voltage supply lines electrically connected to the horizontal conductive lines and/or the vertical conductive lines may be further arranged in the peripheral area PA. The voltage supply lines may be arranged on at least one of an upper side, a lower side, a left side, and a right side of the display area DA.

The connection electrodes having the same functions and corresponding to the first to third circuit areas PCA1a to PCA3a may have different shapes and locations from each other according to locations of the lines arranged in the first to third circuit areas PCA1a to PCA3a.

A sixth insulating layer 116 may be arranged above the fifth insulating layer 115 to cover or overlap the fifth conductive layer, and an organic light-emitting diode OLED may be arranged above the sixth insulating layer 116 as a display element. The organic light-emitting diode OLED may include a pixel electrode 511, an opposite electrode 515, and an intermediate layer (or intervening layer) between the pixel electrode 511 and the opposite electrode 515.

The pixel electrode 511 may be electrically connected to the connection electrode 281, which is a lower conductive pattern, through a contact hole 71a of the sixth insulating layer 116, and thus may be electrically connected to the first transistor T1. As illustrated in FIG. 16, the pixel electrode 511 connected to the pixel circuit of the first pixel PX1 may be electrically connected to the connection electrode 281 arranged in the first circuit area PCA1a, and thus may be electrically connected to the first transistor T1. The pixel electrode 511 connected to the pixel circuit of the second pixel PX2 may be electrically connected to the connection electrode 281 arranged in the second circuit area PCA2a, and thus may be electrically connected to the first transistor T1. The pixel electrode 511 connected to the pixel circuit of the third pixel PX3 may be electrically connected to the connection electrode 281 arranged in the third circuit area PCA3a, and thus may be electrically connected to the first transistor T1.

As illustrated in FIG. 3, an auxiliary electrode AE may be further arranged on the same layer as the pixel electrode 511. The auxiliary electrode AE may be arranged between the pixel electrodes 511 of the third pixel PX3. The auxiliary electrode AE may contact the opposite electrode 515 in the display area DA. In an embodiment, the auxiliary electrode AE may be electrically connected to the vertical common voltage line ELv in the display area DA.

As illustrated in FIGS. 17 to 19, a seventh insulating layer 117, which is a pixel-defining layer covering an edge of the pixel electrode 511, may be arranged above the pixel electrode 511. An opening 117OP exposing a portion of the pixel electrode 511 and defining an emission area may be defined in the seventh insulating layer 117. The seventh insulating layer 117 may be a single organic insulating layer or organic insulating layers and/or a single inorganic insulating layer or inorganic insulating layers.

The intermediate layer may include an emission layer 513 and a first functional layer below the emission layer 513 and/or a second functional layer above the emission layer 513. The first functional layer may be a hole transport layer HTL. As another example, the first functional layer may include a hole injection layer HIL and a hole transport layer HTL. The second functional layer may include an electron transport layer ETL and/or an electron injection layer EIL. The first functional layer and the second functional layer may be integral with each other to correspond to the organic light-emitting diodes OLED included in the display area DA. The first functional layer or the second functional layer may be omitted. FIG. 16 illustrates an emission layer 513a of an organic light-emitting diode OLED1 electrically connected to the pixel circuit arranged in the first circuit area PCA1a, an emission layer 513b of an organic light-emitting diode OLED2 electrically connected to the pixel circuit arranged in the second circuit area PCA2a, and an emission layer 513c of an organic light-emitting diode OLED3 electrically connected to the pixel circuit arranged in the third circuit area PCA3a.

The opposite electrode 515 may be integral with each other to correspond to the organic light-emitting diodes OLED arranged in the display area DA.

Referring to FIGS. 17 to 19, the conductive line 200 may correspond to the entire channel region CH1 of the first transistor T1 in each circuit area, and the entire channel region CH1 of the first transistor T1 may overlap the conductive line 200.

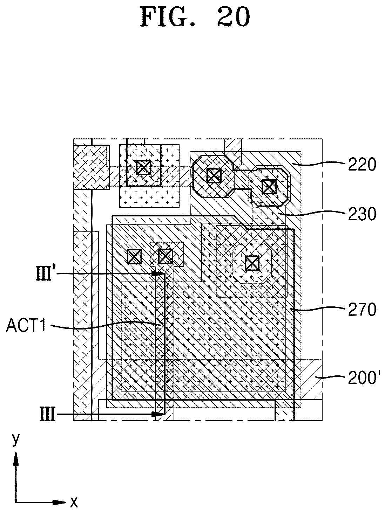

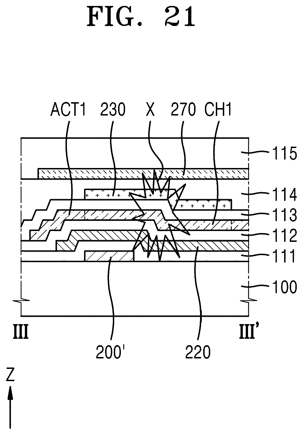

FIGS. 20 and 21 are schematic diagrams illustrating an arrangement relationship between a conductive layer and a semiconductor layer according to a comparative example. In the case of the comparative example shown in FIGS. 20 and 21, a conductive line 200' may correspond to a portion of the channel region CH1 of the first transistor T1, and the portion of the channel region CH1 of the first transistor T1 may overlap the conductive line 200'. The channel region CH1 of the first transistor T1 included in the first semiconductor layer ACT1 may be completely or partially disconnected in an area X due to a step formed between an area where the conductive line 200' is arranged and an area where the conductive line 200' is not arranged. Because the amount of output current of the first transistor T1 varies according to the degree of disconnection of the channel region CH1 of the first transistor T1, short-range uniformity (SRU) deterioration and sand grain-shaped stains or dark spots may appear.

According to an embodiment of the disclosure, as the conductive line 200 is arranged to correspond to at least the channel region CH1 of the first transistor T1, the disconnection of the channel region CH1 of the first transistor T1 may be minimized (prevented).

According to an embodiment of the disclosure, the ratio of the first capacitor C1 to the second capacitor C2 may be optimized for each pixel by adjusting the degree of overlap between the conductive line 200 and the second electrode 220, the separation distance between the conductive line 200 and the first electrode 210, and the size of the conductive line 200 and/or the first electrode 210 and/or the width in the y direction of the conductive line 200 and/or the first electrode 210.

Referring back to FIGS. 17 and 18, the first capacitor C1 of the first pixel PX1 and the second pixel PX2 may include a first electrode C11 and a second electrode C12. The first electrode C11 may include a lower first electrode C11b formed by the first electrode 210, an intermediate first electrode (or intervening first electrode) C11m formed by the third electrode 230, and an upper first electrode C11t formed by the connection electrode 273. The lower first electrode C11b and the intermediate first electrode C11m may be electrically connected to each other through the contact hole 31a, and the intermediate first electrode C11m and the upper first electrode C11t may be electrically connected to each other through the contact hole 49a. The second electrode C12 may include a lower second electrode C12b formed by the second electrode 220, an intermediate second electrode (or intervening second electrode) C12m formed by the connection electrode 270, and an upper second electrode C12t formed by the connection electrode 283. The lower second electrode C12b and the intermediate second electrode C12m may be electrically connected to each other through the contact hole 41a, and the intermediate second electrode C12m and the upper second electrode C12t may be electrically connected to each other through the contact hole 62a.

A capacitance of the first capacitor C1 may be the sum of a capacitance formed by the lower first electrode C11b and the lower second electrode C12b, a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus may have (obtain) an increased capacitance without an increase of the area in the x direction and the y direction.

A y direction width wc1 of the lower first electrode C11b of the first capacitor C1 of the first pixel PX1 may be greater than a y direction width wc1 of the lower first electrode C11b of the first capacitor C1 of the second pixel PX2. The overlapping area between the lower first electrode C11b and the lower second electrode C12b of the first capacitor C1 of the second pixel PX2 may be greater than the overlapping area between the lower first electrode C11b and the lower second electrode C12b of the first capacitor C1 of the first pixel PX1. The sum of the overlapping area between the lower second electrode C12b and the intermediate first electrode C11m of the first capacitor C1 of the second pixel PX2 and the overlapping area between the intermediate first electrode C11m and the intermediate second electrode C12m of the first capacitor C1 of the second pixel PX2 may be greater than the sum of the overlapping area between the lower second electrode C12b and the intermediate first electrode C11m of the first capacitor C1 of the first pixel PX1 and the overlapping area between the intermediate first electrode C11m and the intermediate second electrode C12m of the first capacitor C1 of the first pixel PX1.

The second capacitor C2 of the first pixel PX1 and the second pixel PX2 may include a first electrode C21 formed by the conductive line 200 and a second electrode C22 formed by the second electrode 220. The area where the second electrode 220 overlaps the conductive line 200 in the second circuit area PCA2a may be greater than the area where the second electrode 220 overlaps the conductive line 200 in the first circuit area PCA1a. Therefore, the capacitance of the second capacitor C2 of the second pixel PX2 may be greater than the capacitance of the second capacitor C2 of the first pixel PX1.

Referring to FIG. 19, the first capacitor C1 of the third pixel PX3 may be formed between the third electrode 230 and the connection electrode 270, between the second electrode 220 and the third electrode 230, and between the connection electrode 273 and the connection electrode 283. The first capacitor C1 of the first pixel PX1 may include a first electrode C11 and a second electrode C12. The first electrode C11 may include an intermediate first electrode C11m formed by the third electrode 230 and an upper first electrode C11t formed by the connection electrode 273. The intermediate first electrode C11m and the upper first electrode C11t may be electrically connected to each other through the contact hole 49a. The second electrode C12 may include the lower second electrode C12b formed by the second electrode 220, the intermediate second electrode C12m formed by the connection electrode 270, and the upper second electrode C12t formed by the connection electrode 283. The lower second electrode C12b and the intermediate second electrode C12m may be electrically connected to each other through the contact hole 41a, and the intermediate second electrode C12m and the upper second electrode C12t may be electrically connected to each other through the contact hole 62a.

A capacitance of the first capacitor C1 may be the sum of a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus may have (obtain) an increased capacitance without an increase of the area in the x direction and the y direction.

The second capacitor C2 of the third pixel PX3 may include a first electrode C21 formed by the conductive line 200 and a second electrode C22 formed by the second electrode 220. The area where the second electrode 220 overlaps the conductive line 200 in the third circuit area PCA3a may be greater than the area where the second electrode 220 overlaps the conductive line 200 in the first circuit area PCA1a and the second circuit area PCA2a. Therefore, the capacitance of the second capacitor C2 of the third pixel PX3 may be greater than the capacitance of the second capacitor C2 of the first pixel PX1 and the second pixel PX2.

FIG. 22 is a schematic diagram of an equivalent circuit of a pixel PXb according to an embodiment.

Referring to FIG. 22, a pixel circuit PCb of the pixel PXb may further include a third capacitor C3 in addition to the pixel circuit PCa of the pixel PXa shown in FIG. 4. Other configurations and operations may be substantially the same as those of the pixel PXa shown in FIG. 4.

The third capacitor C3 may be connected between the second node N2 and the common voltage line EL to which the common voltage ELVSS is supplied. A first electrode of the third capacitor C3 may be connected to the common voltage line EL. A second electrode of the third capacitor C3 may be connected to the second terminal and the second gate of the first transistor T1, the second electrode of the first capacitor C1, the second electrode of the second capacitor C2, the first terminal of the fourth transistor T4, and the first terminal of the sixth transistor T6.

The capacitance of each of the first capacitor C1, the second capacitor C2, and the third capacitor C3 may vary according to the color of light emitted from the pixel PXb.

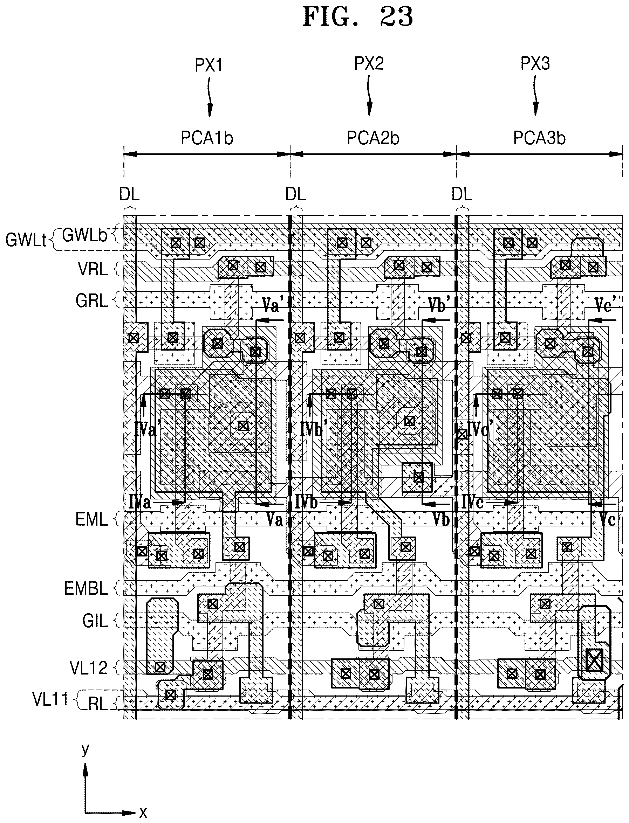

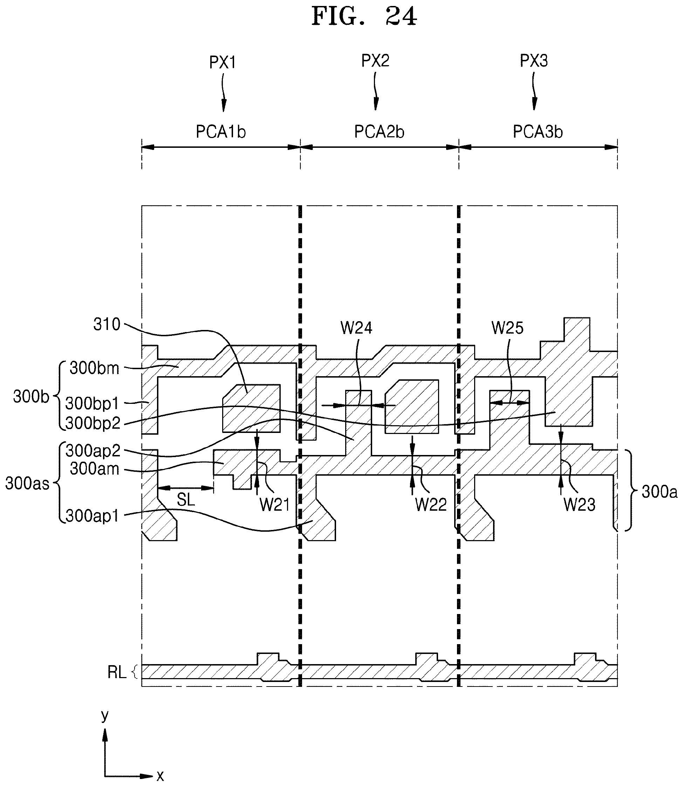

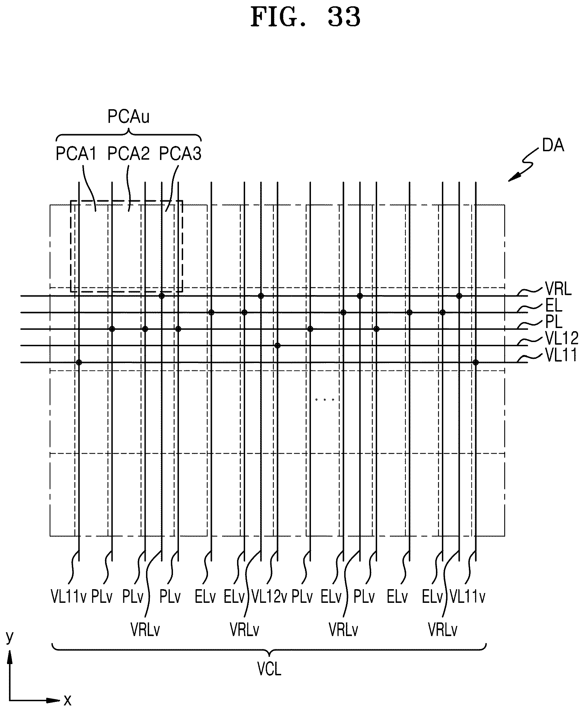

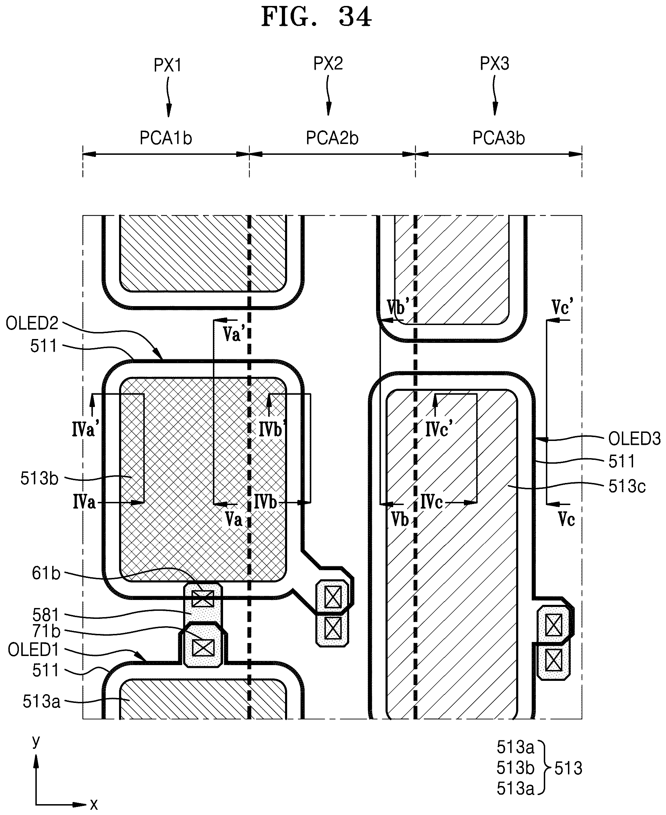

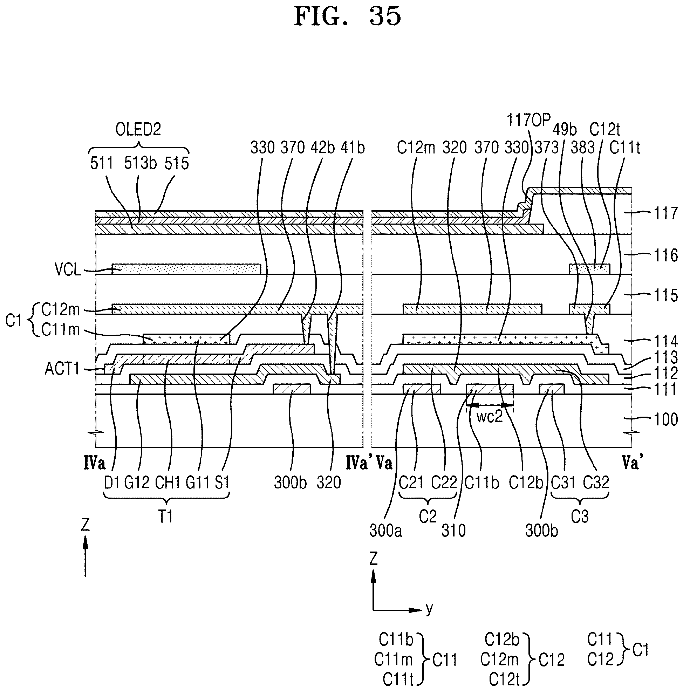

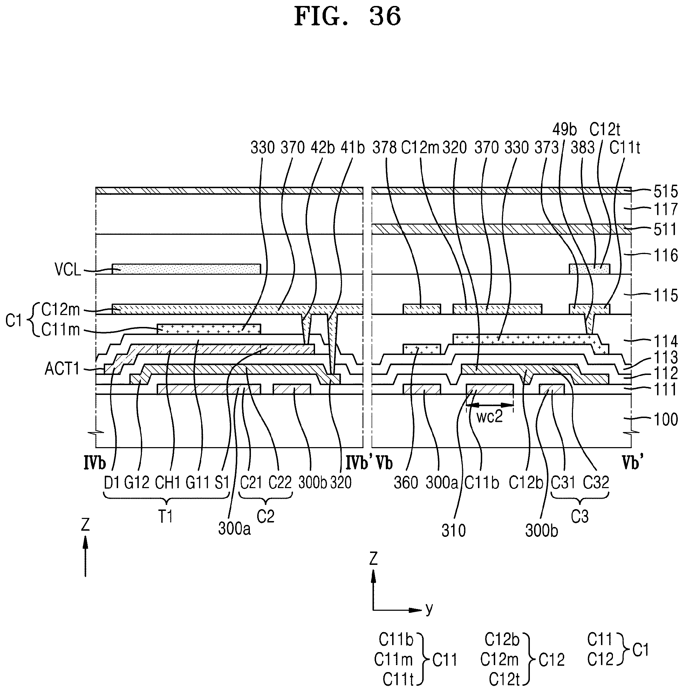

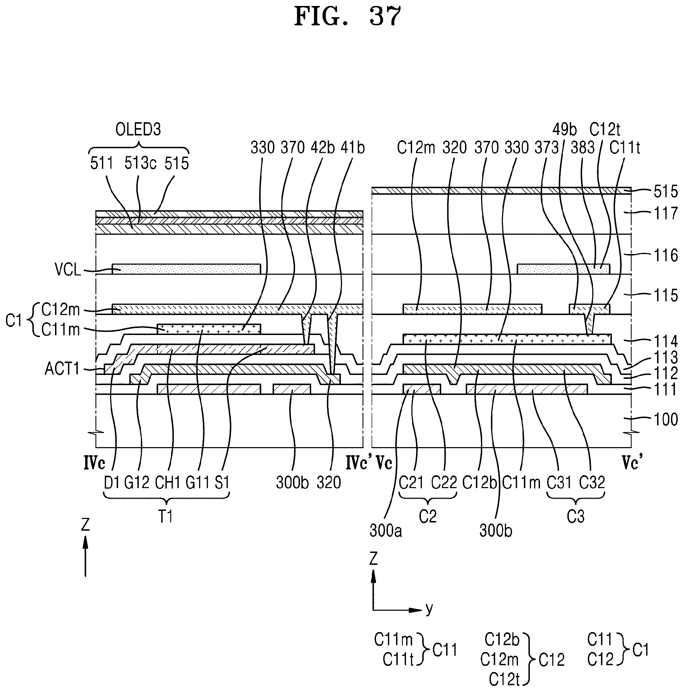

FIG. 23 is a schematic layout view illustrating locations of transistors and capacitors of pixels according to an embodiment. FIGS. 24 to 34 are schematic layout views illustrating elements of a pixel for each layer. FIG. 33 is a schematic view illustrating an arrangement of vertical conductive lines according to an embodiment. FIG. 35 is a schematic cross-sectional view of the elements of the pixel, taken along lines IVa-IVa' and Va-Va' of FIGS. 23 and 34. FIG. 36 is a schematic cross-sectional view of the elements of the pixel, taken along lines IVb-IVb' and Vb-Vb' of FIGS. 23 and 34. FIG. 37 is a schematic cross-sectional view of the elements of the pixel, taken along lines IVc-IVc' and Vc-Vc' of FIGS. 23 and 34.

In FIG. 23, pixel circuits arranged in a first circuit area PCA1b, a second circuit area PCA2b, and a third circuit area PCA3b may correspond to the pixel circuit PCb of the pixel shown in FIG. 22.

In an embodiment, the pixel circuit PCb of the first pixel PX1 may be connected to a 1-1-th initialization voltage line VL11, and the pixel circuit PCb of the second pixel PX2 and the pixel circuit PCb of the third pixel PX3 may be connected to a 1-2-th initialization voltage line VL12. The initialization voltage supplied to the 1-1-th initialization voltage line VL11 and the initialization voltage supplied to the 1-2-th initialization voltage line VL12 may be different from each other.

Hereinafter, for convenience of illustration and explanation, reference numerals are assigned to the devices of the pixel circuit PCb arranged in the first circuit area PCA1b, and the description is given based on the first circuit area PCA1b. However, the description may be likewise applied to the same elements of the second and third circuit areas PCA2b and PCA3b. Hereinafter, descriptions will be provided with reference to FIGS. 24 to 37.

A first conductive layer may be arranged on the substrate 100. As illustrated in FIG. 24, the first conductive layer may include a first conductive line 300a, a second conductive line 300b, a first electrode 310, and a repair line RL. In an embodiment, a barrier layer may be further arranged between the substrate 100 and the first conductive layer.

The first electrode 310 may be provided as an island type. The first electrode 310 may be arranged between the first conductive line 300a and the second conductive line 300b in a plan view in the first circuit area PCA1b and the second circuit area PCA2b and may not be arranged in the third circuit area PCA3b. The area of the first electrode 310 of the second circuit area PCA2b may be different from the area of the first electrode 310 of the first circuit area PCA1b. In an embodiment, the area of the first electrode 310 of the second circuit area PCA2b may be greater than the area of the first electrode 310 of the first circuit area PCA1b.

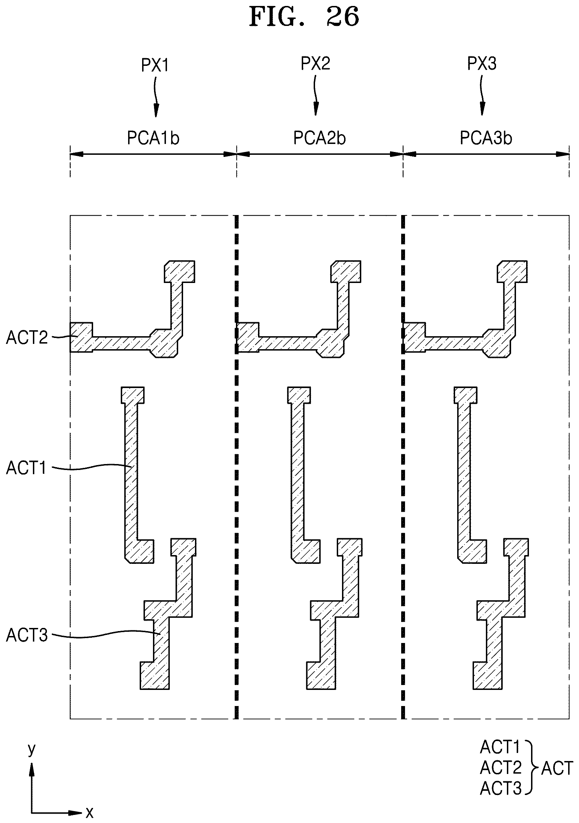

The first conductive line 300a may extend in the x direction and be arranged to cross the first circuit area PCA1b, the second circuit area PCA2b, and the third circuit area PCA3b. The first conductive line 300a may be a driving voltage line PL to which the driving voltage ELVDD is applied. The first conductive line 300a may include sub-lines 300as disconnected and separated from each other at certain intervals. The sub-lines 300as may be spaced apart from each other in the x direction. In an embodiment, the sub-lines 300as may be spaced apart from each other by a certain distance SL with a first semiconductor layer ACT1 (see FIG. 26) therebetween in a plan view in the first circuit area PCA1b. Accordingly, the sub-lines 300as may not overlap the first semiconductor layer ACT1 in the first circuit area PCA1b.

Each sub-line 300as may include a main line 300am extending in the x direction and a protrusion portion 300ap1 protruding in the -y direction from the main line 300am. The protrusion portion 300ap1 may overlap the data line DL in each circuit area. The sub-line 300as may further include a protrusion portion 300ap2 protruding in the +y direction in the second circuit area PCA2b and the third circuit area PCA3b. In each of the second circuit area PCA2b and the third circuit area PCA3b, the main line 300am and the protrusion portion 300ap2 may overlap the first semiconductor layer ACT1. In each of the second circuit area PCA2b and the third circuit area PCA3b, the main line 300am and the protrusion portion 300ap2 may overlap at least the channel region of the first transistor T1. In an embodiment, an x direction width w25 of the protrusion portion 300ap2 in the third circuit area PCA3b may be greater than an x direction width w24 of the protrusion portion 300ap2 in the second circuit area PCA2b.

The area of the first conductive line 300a may be different for each circuit area. For example, the area of the first conductive line 300a in the third circuit area PCA3b may be greater than the area of the first conductive line 300a in the first circuit area PCA1b and the second circuit area PCA2b. The area of the first conductive line 300a in the second circuit area PCA2b may be greater than the area of the first conductive line 300a in the first circuit area PCA1b. In an embodiment, a y direction width w23 of the main line 300am in the third circuit area PCA3b may be greater than a y direction width w22 of the main line 300am in the second circuit area PCA2b and a y direction width w21 of the main line 300am in the first circuit area PCA1b, and the y direction width w21 of the main line 300am in the first circuit area PCA1b may be greater than the y direction width w22 of the main line 300am in the second circuit area PCA2b.

The second conductive line 300b may extend in the x direction and may be arranged to cross the first circuit area PCA1b, the second circuit area PCA2b, and the third circuit area PCA3b. The second conductive line 300b may be a common voltage line EL to which the common voltage ELVSS is applied. Hereinafter, the second conductive line 300b and the common voltage line EL may be used interchangeably. The second conductive line 300b may be arranged parallel to the first conductive line 300a. The second conductive line 300b may include a main line 300bm extending in the x direction in each circuit area and a protrusion portion 300bp1 protruding in the -y direction from the main line 300bm. The main line 300bm may have a bend and may extend in the x direction. The protrusion portion 300bp1 may overlap the data line DL in each circuit area. The second conductive line 300b may further include a protrusion portion 300bp2 protruding in the -y direction in the third circuit area PCA3b. The protrusion portion 300bp2 may be spaced apart from the protrusion portion 300bp1 with the protrusion portion 300ap2 of the first conductive line 300a therebetween in a plan view in the third circuit area PCA3b.

The repair line EL may extend in the x direction and may be arranged to cross the first circuit area PCA1b, the second circuit area PCA2b, and the third circuit area PCA3b.

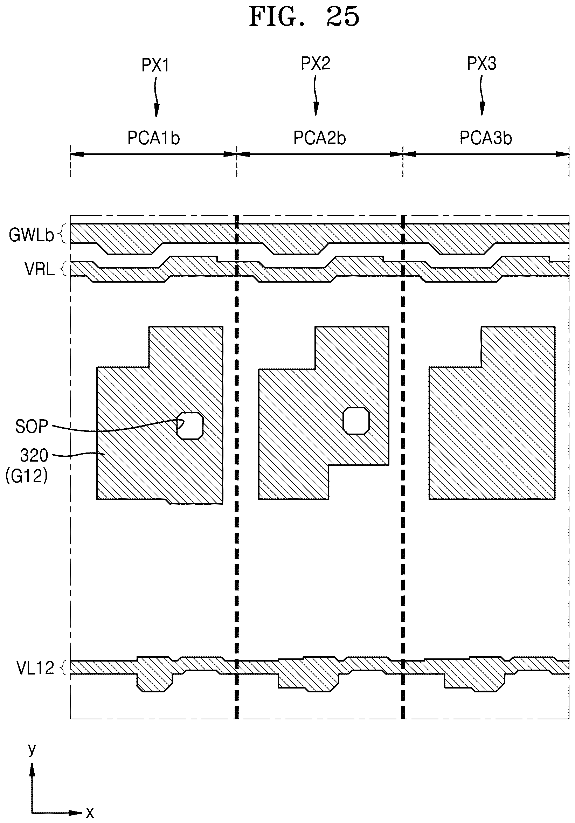

A first insulating layer 111 may be arranged on the substrate 100 to cover or overlap the first conductive layer, and a second conductive layer may be arranged on the first insulating layer 111. As illustrated in FIG. 25, the second conductive layer may include a second electrode 320, a lower first gate line GWLb, a reference voltage line VRL, and/or a 1-2-th initialization voltage line VL12.

The second electrode 320 may be provided as an island type. The second electrode 320 may partially overlap the first conductive line 300a and the second conductive line 300b. The second electrode 320 may overlap the first electrode 310 in the first circuit area PCA1b and the second circuit area PCA2b. In the third circuit area PCA3b, the second electrode 320 may overlap the protrusion portion 300bp2 of the second conductive line 300b. The second electrode 320 may include a second gate electrode G12 and a source electrode of the first transistor T1. An opening SOP overlapping the first electrode 310 may be defined in the second electrode 320 in the first circuit area PCA1b and the second circuit area PCA2b. The area of the second electrode 320 may be different for each circuit area. In an embodiment, the area of the second electrode 320 in the third circuit area PCA3b may be greater than the area of the second electrode 320 in the first circuit area PCA1b, and the area of the second electrode 320 in the first circuit area PCA1b may be greater than the area of the second electrode 320 in the second circuit area PCA2b. The area where the second electrode 320 overlaps the first electrode 310 in the second circuit area PCA2b may be greater than the area where the second electrode 320 overlaps the first electrode 310 in the first circuit area PCA1b.

The lower first gate line GWLb, the reference voltage line VRL, and the 1-2-th initialization voltage line VL12 may extend in the x direction and may be arranged to cross the first circuit area PCA1b, the second circuit area PCA2b, and the third circuit area PCA3b.

A second insulating layer 112 may be arranged on the first insulating layer 111 to cover or overlap the second conductive layer, and a semiconductor layer ACT including an oxide semiconductor may be arranged on the second insulating layer 112 as illustrated in FIG. 26. The semiconductor layer ACT may include a first semiconductor layer ACT1, a second semiconductor layer ACT2, and/or a third semiconductor layer ACT3. The semiconductor layer ACT may include a source region, a drain region and a channel region between the source region and the drain region of each of the first to sixth transistors T1 to T6. The source region or the drain region may also be interpreted as a source electrode or a drain electrode of the transistor, according to embodiments.

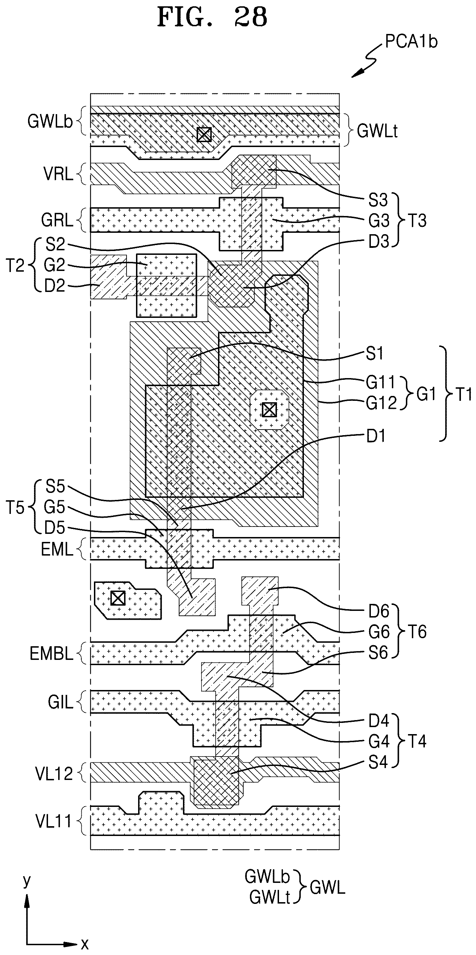

FIG. 28 illustrates the transistors of the first circuit area PCA1b. Referring to FIG. 28, the first semiconductor layer ACT1 may include a source region S1 and a drain region D1 of the first transistor T1 and a source region S5 and a drain region D5 of the fifth transistor T5. The second semiconductor layer ACT2 may include a source region S2 and a drain region D2 of the second transistor T2 and a source region S3 and a drain region D3 of the third transistor T3. The third semiconductor layer ACT3 may include a source region S4 and a drain region D4 of the fourth transistor T4 and a source region S6 and a drain region D6 of the sixth transistor T6.

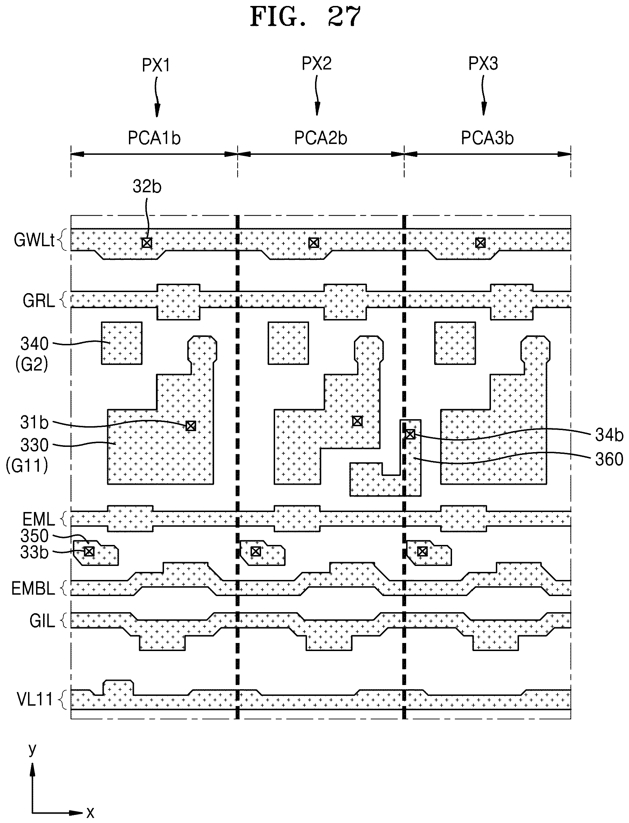

A third insulating layer 113 may be arranged on the second insulating layer 112 to cover or overlap the semiconductor layer ACT, and a third conductive layer may be arranged on the third insulating layer 113. As illustrated in FIG. 27, the third conductive layer may include a third electrode 330, a fourth electrode 340, connection electrodes 350 and 360, an upper first gate line GWLt, the second gate line GIL, the third gate line GRL, the fourth gate line EML, the fifth gate line EMBL, and/or the 1-1-th initialization voltage line VL11.

The third electrode 330, the fourth electrode 340, and the connection electrodes 350 and 360 may be provided in an island type. The third electrode 330, the fourth electrode 340, and the connection electrode 350 may be arranged in each of the first to third circuit areas PCA1b to PCA3b. The connection electrode 360 may be arranged in some of the first circuit area PCA1b, the second circuit area PCA2b, and the third circuit area PCA3b. For example, as illustrated in FIG. 27, the connection electrode 360 may be arranged between the second circuit area PCA2b and the third circuit area PCA3b. A portion of the connection electrode 360 may overlap the data line DL. A portion of the connection electrode 360 may overlap the first conductive line 300a.

The area of the third electrode 330 in the first circuit area PCA1b and the third circuit area PCA3b may be greater than the area of the third electrode 330 in the second circuit area PCA2b. The area where the third electrode 330 overlaps the second electrode 320 in the first circuit area PCA1b and the third circuit area PCA3b may be greater than the area where the third electrode 330 overlaps the second electrode 320 in the second circuit area PCA2b.

In the first and second circuit areas PCA1b and PCA2b, the third electrode 330 may be electrically connected to the first electrode 310 through a contact hole 31b passing through the first to third insulating layers 111 to 113. The contact hole 31b may be insulated from the opening SOP of the second electrode 320 and may be located in the opening SOP.

In the first to third circuit areas PCA1b to PCA3b, the connection electrode 350 may be electrically connected to the protrusion portion 300ap1 of the first conductive line 300a through a contact hole 33b passing through the first to third insulating layers 111 to 113.

Between the second circuit area PCA2b and the third circuit area PCA3b, the connection electrode 360 may be electrically connected to the protrusion portion 300bp1 of the second conductive line 300b through a contact hole 34b passing through the first to third insulating layers 111 to 113.

The upper first gate line GWLt, the second gate line GIL, the third gate line GRL, the fourth gate line EML, the fifth gate line EMBL, and the 1-1-th initialization voltage line VL11 may extend in the x direction and may be arranged to cross the first to third circuit areas PCA1b to PCA3b.

The upper first gate line GWLt may overlap the lower first gate line GWLb and may be electrically connected to the lower first gate line GWLb through a contact hole 32b passing through the second and third insulating layers 112 and 113.

As illustrated in FIG. 28, the third conductive layer may include gate electrodes G1 to G6 of the first to sixth transistors T1 to T6. The gate electrodes G1 to G6 may overlap channel regions of the semiconductor layer ACT.

Referring to FIG. 28, the third electrode 330 may include a first gate electrode G11 of the first transistor T1. The first gate electrode G11 may overlap the first semiconductor layer ACT1. The fourth electrode 340 may correspond to a gate electrode G2 of the second transistor T2. The fourth electrode 340 may overlap the second semiconductor layer ACT2. A gate electrode G3 of the third transistor T3 may be a portion of the third gate line GRL overlapping the second semiconductor layer ACT2. A gate electrode G4 of the fourth transistor T4 may be a portion of the second gate line GIL overlapping the third semiconductor layer ACT3. A gate electrode G5 of the fifth transistor T5 may be a portion of the fourth gate line EML overlapping the first semiconductor layer ACT1. A gate electrode G6 of the sixth transistor T6 may be a portion of the fifth gate line EMBL overlapping the third semiconductor layer ACT3.

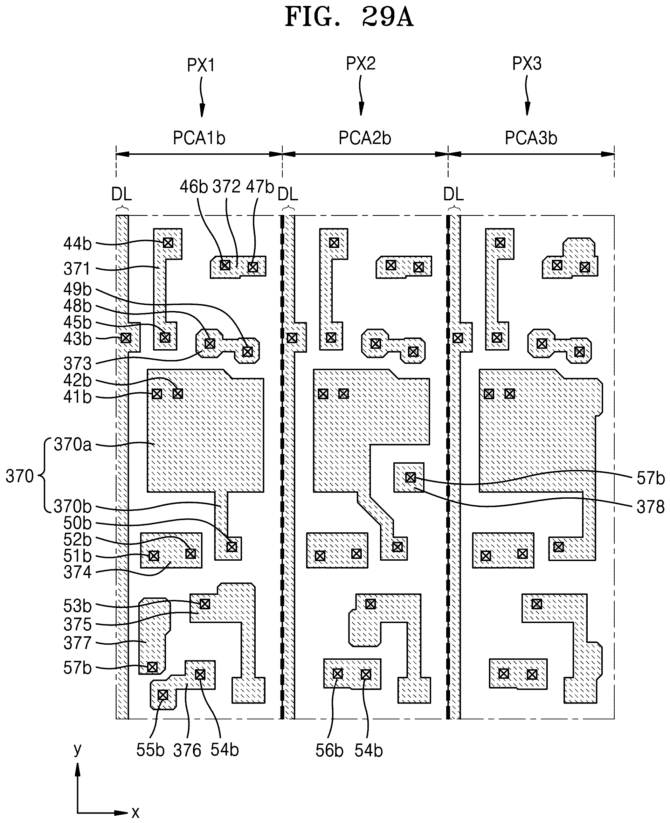

A fourth insulating layer 114 may be arranged on the third insulating layer 113 to cover or overlap the third conductive layer, and a fourth conductive layer may be arranged on the fourth insulating layer 114 . As illustrated in FIG. 29a, the fourth conductive layer may include a data line DL and connection electrodes 370, 371, 372, 373, 374, 375, 376, 377, and 378.

The data line DL may be arranged to extend in the y direction for each circuit area. The data line DL may be electrically connected to the drain region D2 of the second transistor T2 through a contact hole 43b passing through the third insulating layer 113 and the fourth insulating layer 114 .

The connection electrode 370 may include a first area 370a overlapping the first to third electrodes 310 to 330 and a second area 370b protruding from the first area 370a in the -y direction. The connection electrode 370 may electrically connect the source region S1 of the first transistor T1 to the second gate electrode G12 of the first transistor T1 and the sixth transistor T6.

The first area 370a of the connection electrode 370 may be electrically connected to the source region S1 of the first transistor T1 through a contact hole 42b passing through the third and fourth insulating layers 113 and 114. The first region 370a of the connection electrode 370 may be electrically connected to the second electrode 320 through a contact hole 41b passing through the second to fourth insulating layers 112 to 114. Accordingly, the connection electrode 370 may correspond to a source electrode electrically connected to the source region S1 of the first transistor T1. The second electrode 320 may correspond to the second gate electrode G12 of the first transistor T1, and the second gate electrode G12 may face the first gate electrode G11 of the first transistor T1 and overlap the channel region of the first transistor T1. With the connection electrode 370 connected to the second electrode 320, the second gate electrode G12 of the first transistor T1 may be electrically connected to the source region S1 of the first transistor T1.

The second area 370b of the connection electrode 370 may be electrically connected to the drain region D6 of the sixth transistor T6 through a contact hole 50b passing through the third and fourth insulating layers 113 and 114.

The connection electrode 371 may be electrically connected to the gate electrode G2 of the second transistor T2 through a contact hole 45b passing through the fourth insulating layer 114. The connection electrode 371 may be electrically connected to the upper first gate line GWLt through a contact hole 44b passing through the fourth insulating layer 114.

The connection electrode 372 may be electrically connected to the source region S3 of the third transistor T3 through a contact hole 46b passing through the third and fourth insulating layers 113 and 114 and may be electrically connected to the reference voltage line VRL through a contact hole 47b passing through the second to fourth insulating layers 112 to 114.

The connection electrode 373 may be electrically connected to the source region S2 of the second transistor T2 and the drain region D3 of the third transistor T3 through a contact hole 48b passing through the third and fourth insulating layers 113 and 114. The connection electrode 373 may be electrically connected to the third electrode 330 through a contact hole 49b passing through the fourth insulating layer 114 and may be electrically connected to the first gate electrode G11 of the first transistor T1. The connection electrode 373 may correspond to a node electrode corresponding to the first node N1 of FIG. 22. The connection electrode 373 may correspond to a bridge electrode electrically connecting at least two transistors. For example, the connection electrode 373 may correspond to the bridge electrode connecting the first gate electrode G11 of the first transistor T1, the source region S2 of the second transistor T2, and the drain region D3 of the third transistor T3.

The connection electrode 374 may be electrically connected to the protrusion portion 300p1 of the first conductive line 300a through a contact hole 51b passing through the first to fourth insulating layers 111 to 114. The connection electrode 374 may be electrically connected to the drain region D5 of the fifth transistor T5 through a contact hole 52b passing through the third and fourth insulating layers 113 and 114. Accordingly, the drain region D5 of the fifth transistor T5 may be electrically connected to the first conductive line 300a.

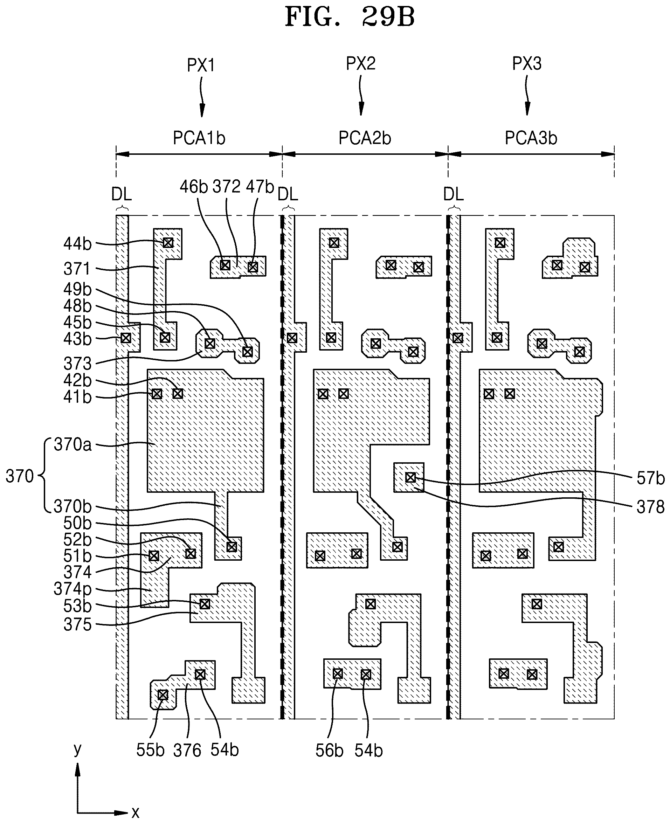

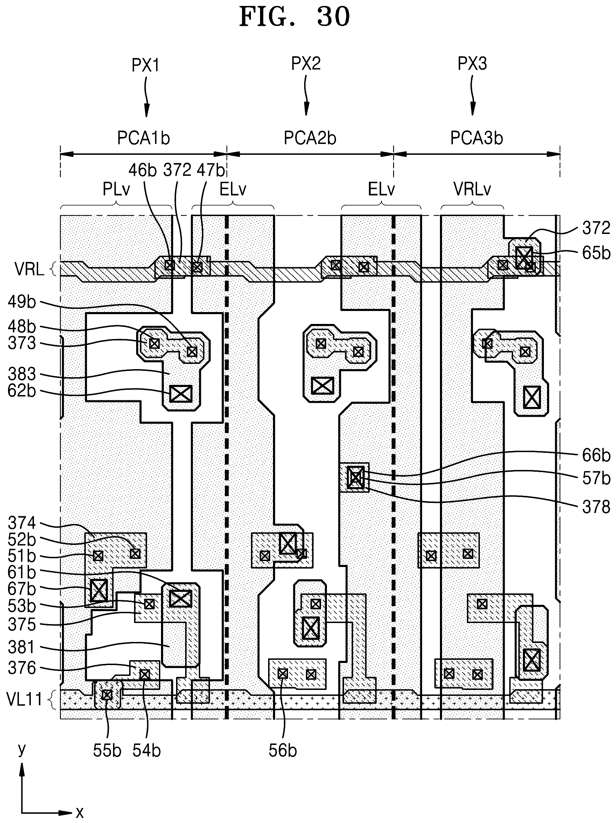

In some of the first circuit areas PCA1b, the connection electrode 374 may further have a protrusion portion 374p, as shown in FIG. 29b. For example, the protrusion portion 374p of the connection electrode 374 may be formed only in the first circuit areas PCA1b where a vertical driving voltage line PLv (see FIG. 30) among the vertical conductive lines described below is arranged.

The connection electrode 375 may be electrically connected to the source region S6 of the sixth transistor T6 and the drain region D4 of the fourth transistor T4 through a contact hole 53b passing through the third and fourth insulating layers 113 and 114. The connection electrode 375 may overlap a portion of the repair line RL. The connection electrode 375 may be insulated from the repair line RL, and in case that defects occur later in the pixel circuit arranged in the circuit area, the connection electrode 375 may be electrically connected to the repair line RL.

In the first circuit area PCA1b, the connection electrode 376 may be electrically connected to the source region S4 of the fourth transistor T4 through a contact hole 54b passing through the third and fourth insulating layers 113 and 114. The connection electrode 376 may be connected to the 1-1-th initialization voltage line VL11 through a contact hole 55b passing through the fourth insulating layer 114.

In the second and third circuit area PCA2b and PCA3b, the connection electrode 376 may be electrically connected to the source region S4 of the fourth transistor T4 through the contact hole 54b passing through the third and fourth insulating layers 113 and 114. The connection electrode 376 may be electrically connected to the 1-2-th initialization voltage line VL12 through a contact hole 56b passing through the second to fourth insulating layers 112 to 114.

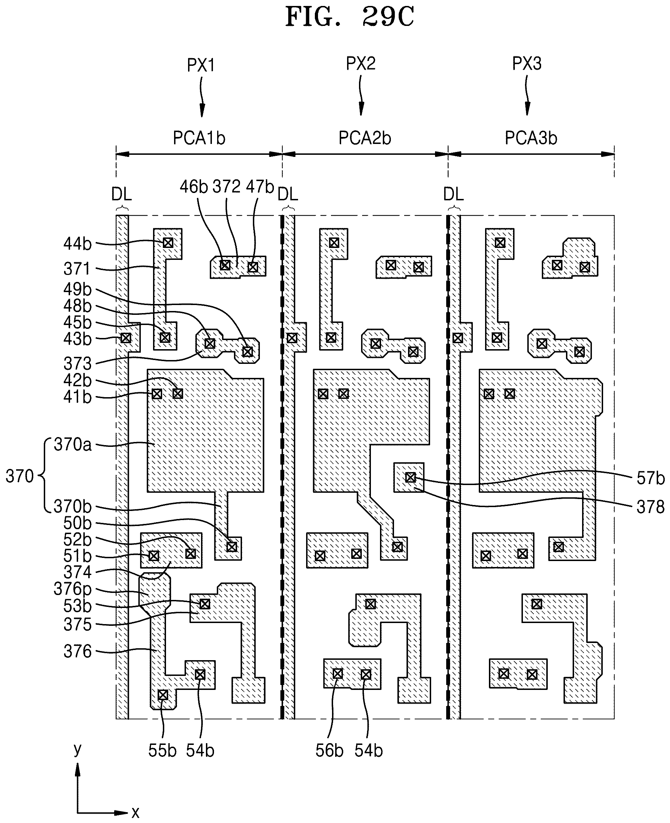

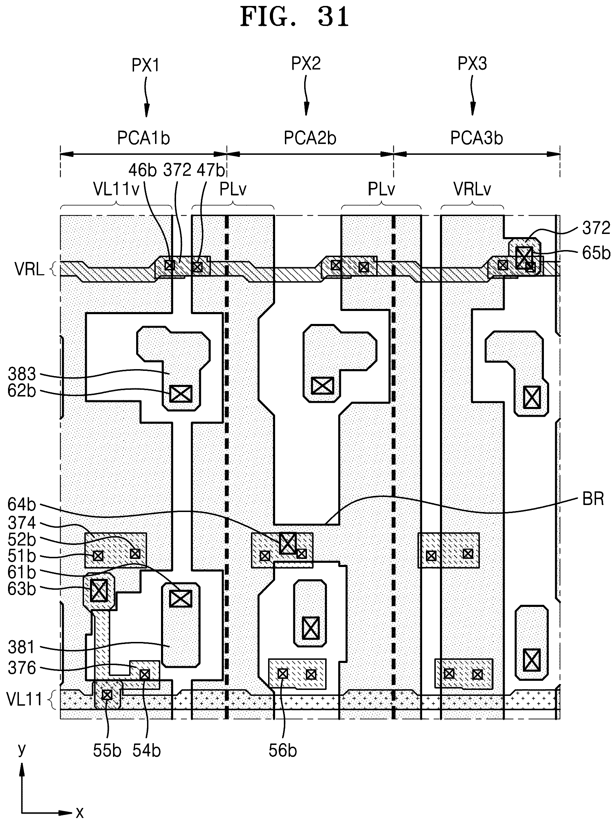

In some of the first circuit areas PCA1b, the connection electrode 376 may further have a protrusion portion 376p, as shown in FIG. 29c. For example, the protrusion portion 376p of the connection electrode 376 may be formed only in the first circuit areas PCA1b where a first vertical initialization voltage line VL11v (see FIG. 31) among the vertical conductive lines described below is arranged.

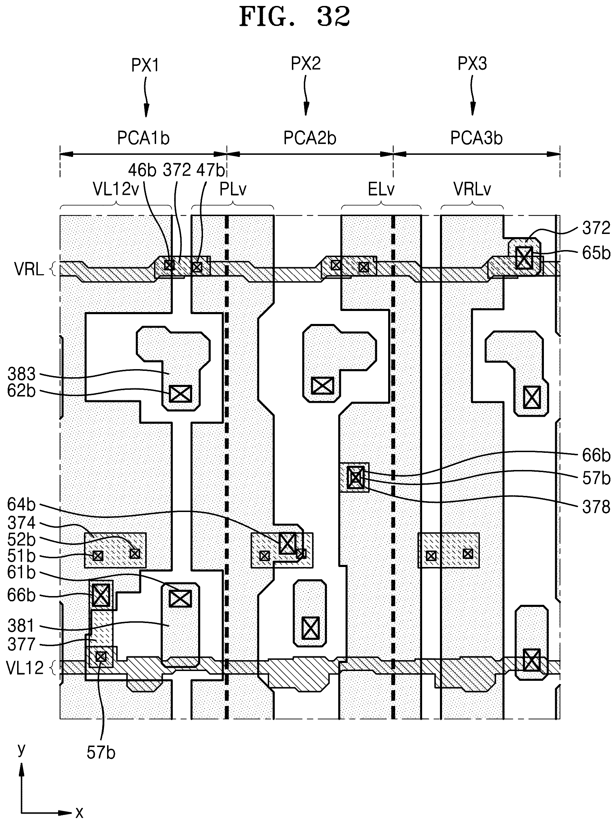

In the first circuit area PCA1b, the connection electrode 377 may be electrically connected to the 1-2-th initialization voltage line VL12 through a contact hole 57b passing through the second to fourth insulating layers 112 to 114. The connection electrode 377 may be arranged in some first circuit areas PCA1b of the first circuit areas PCA1b. For example, the connection electrode 377 may be arranged in only the first circuit areas PCA1b in which a second vertical initialization voltage line VL12v (see FIG. 32) among vertical conductive lines described below is arranged.

In the second circuit area PCA2b, the connection electrode 378 may be electrically connected to the connection electrode 360 through a contact hole 57b passing through the fourth insulating layer 114.

A fifth insulating layer 115 may be arranged above the fourth insulating layer 114 to cover or overlap the fourth conductive layer, and a fifth conductive layer may be arranged above the fifth insulating layer 115. As illustrated in FIGS. 30 to 33, the fifth conductive layer may include vertical conductive lines VCL and connection electrodes 381 and 383. FIGS. 30 to 32 illustrate only some of lower conductive lines connected to the fifth conductive layer, for convenience of illustration and explanation.

The connection electrode 381 may be electrically connected to the connection electrode 375 through a contact hole 61b passing through the fifth insulating layer 115 and may be electrically connected to the source region S6 of the sixth transistor T6.

The connection electrode 383 may be electrically connected to the connection electrode 370 through a contact hole 62b passing through the fifth insulating layer 115. The connection electrode 383 may be arranged to cover and overlap the connection electrode 373, which is a node electrode. The second electrode 320 may be arranged below the connection electrode 373, and the connection electrode 383 may be arranged above the connection electrode 373. The connection electrode 383 may entirely cover the connection electrode 373, and the second electrode 320 may entirely cover the connection electrode 373. The connection electrode 383 may function as an upper shielding layer of the connection electrode 373, and the second electrode 320 may function as a lower shielding layer of the connection electrode 373.

The vertical conductive lines VCL may include a vertical driving voltage line PLv, a first vertical initialization voltage line VL11v, the second vertical initialization voltage line VL12v, a vertical common voltage line ELv, and a vertical reference voltage line VRLv. The vertical conductive lines VCL each may extend in the y direction and may be arranged to be spaced apart from each other in the x direction in the first to third circuit areas PCA1b to PCA3b.

Four vertical conductive lines may be arranged to be spaced apart from each other in the x direction in the first to third circuit areas PCA1b to PCA3b. For example, four vertical conductive lines among the first vertical initialization voltage line VL11v, the second vertical initialization voltage line VL12v, the vertical driving voltage line PLv, the vertical common voltage line ELv, and the vertical reference voltage line VRLv may be arranged to be spaced apart from each other in the x direction. The vertical conductive lines VCL may be electrically connected to horizontal conductive lines extending in the x direction. The horizontal conductive lines may include the first conductive line 300a that is the driving voltage line PL, the second conductive line 300b that is the common voltage line EL, the 1-1-th initialization voltage line VL11, the 1-2-th initialization voltage line VL12, and the reference voltage line VRL.

FIG. 30 illustrates an example in which a vertical driving voltage line PLv, a pair of vertical common voltage lines ELv, and a vertical reference voltage line VRLv are sequentially arranged in the x direction in the first to third circuit areas PCAb to PCA3b.

FIG. 31 illustrates an example in which a first vertical initialization voltage line VL11v, a pair of vertical driving voltage lines PLv, and a vertical reference voltage line VRLv are sequentially arranged in the x direction in the first to third circuit areas PCA1b to PCA3b.

FIG. 32 illustrates an example in which a second vertical initialization voltage line VL12v, a vertical driving voltage line PLv, a vertical common voltage line ELv, and a vertical reference voltage line VRLv are sequentially arranged in the x direction in the first to third circuit areas PCA1b to PCA3b.

The pair of vertical driving voltage lines PLv adjacent to each other may be connected by a connection portion BR. The pair of vertical driving voltage lines PLv may be integral with each other. In an embodiment, the connection portion BR may be arranged in every second row. For example, as illustrated in FIG. 31, the pair of vertical driving voltage lines PLv may be connected to each other by the connection portion BR in odd-numbered rows or even-numbered rows and may be spaced apart from each other without the connection portion BR in even-numbered rows or odd-numbered rows.

In an embodiment, as shown in FIG. 33, a first vertical conductive line VCL of the unit circuit area PCAu may be the first vertical initialization voltage line VL11v, the second vertical initialization voltage line VL12v, or the vertical driving voltage line PLv. A fourth vertical conductive line VCL of the unit circuit area PCAu may be the vertical reference voltage line VRLv. Second and third vertical conductive lines VCL of the unit circuit area PCAu may be the pair of vertical driving voltage lines PLv, the pair of vertical common voltage lines PLv, or the pair of vertical driving voltage lines PLv and the vertical common voltage line ELv.

As illustrated in FIG. 30, the vertical driving voltage line PLv may be electrically connected to the connection electrode 374 arranged in the first circuit area PCA1b through a contact hole 67b passing through the fifth insulating layer 115. As illustrated in FIG. 31, the vertical drive voltage line PLv may be electrically connected to the connection electrode 374 arranged in the second circuit area PCA2b through a contact hole 64b passing through the fifth insulating layer 115. The connection electrode 374 is electrically connected to the first conductive line 300a, and the driving voltage line PL may have a mesh structure in the display area DA.

As illustrated in FIG. 31, the first vertical initialization voltage line VL11v may be electrically connected to the connection electrode 376 arranged in the first circuit area PCA1b through a contact hole 63b passing through the fifth insulating layer 115. The connection electrode 376 is electrically connected to the 1-1-th initialization voltage line VL11, and the 1-1-th initialization voltage line VL11 may have a mesh structure in the display area DA.

As illustrated in FIG. 32, the second vertical initialization voltage line VL12v may be electrically connected to the connection electrode 377 arranged in the first circuit area PCA1b through a contact hole 66b passing through the fifth insulating layer 115. The connection electrode 377 is electrically connected to the 1-2-th initialization voltage line VL12, and the 1-2-th initialization voltage line VL12 may have a mesh structure in the display area DA.

As illustrated in FIGS. 30 and 32, the vertical common voltage line ELv may be electrically connected to the connection electrode 378 arranged in the second circuit area PCA2b through a contact hole 66b passing through the fifth insulating layer 115. The connection electrode 378 is electrically connected to the second conductive line 300b, which is the common voltage line EL, and the common voltage line EL may have a mesh structure in the display area DA. In an embodiment, the vertical common voltage line ELv may be electrically connected to the common voltage supply line 13 (see FIG. 2) arranged in the peripheral area PA.

As illustrated in FIGS. 30 to 32, the vertical reference voltage line VRLv may be electrically connected to the connection electrode 372 arranged in the third circuit area PCA3b through a contact hole 65b passing through the fifth insulating layer 115. The connection electrode 372 may be electrically connected to the reference voltage line VRL, and the reference voltage line VRL may have a mesh structure in the display area DA.

Although not shown in the drawings, voltage supply lines electrically connected to the horizontal conductive lines and/or the vertical conductive lines may be further arranged in the peripheral area PA. The voltage supply lines may be arranged on at least one of an upper side, a lower side, a left side, and a right side of the display area DA.

The connection electrodes having substantially the same functions and corresponding to the first to third circuit areas PCA1b to PCA3b may have different shapes and locations from each other according to locations of the lines arranged in the first to third circuit areas PCA1b to PCA3b.

The pixel electrode 511 may be electrically connected to the connection electrode 381, which is a lower conductive pattern, through a contact hole 71b of the sixth insulating layer 116, and thus may be electrically connected to the first transistor T1. As illustrated in FIG. 34, the pixel electrode 511 connected to the pixel circuit of the first pixel PX1 may be electrically connected to the connection electrode 581 arranged in the first circuit area PCA1b, and thus may be electrically connected to the first transistor T1. The pixel electrode 511 connected to the pixel circuit of the second pixel PX2 may be electrically connected to the connection electrode 381 arranged in the second circuit area PCA2b, and thus may be electrically connected to the first transistor T1. The pixel electrode 511 connected to the pixel circuit of the third pixel PX3 may be electrically connected to the connection electrode 381 arranged in the third circuit area PCA3b, and thus may be electrically connected to the first transistor T1.

As illustrated in FIG. 3, an auxiliary electrode AE may be further arranged on the same layer as the pixel electrode 511.

As illustrated in FIGS. 35 to 37, a seventh insulating layer 117, which is a pixel-defining layer covering an edge of the pixel electrode 511, may be arranged above the pixel electrode 511. An opening 117OP exposing a portion of the pixel electrode 511 and defining an emission area may be defined in the seventh insulating layer 117. The seventh insulating layer 117 may be a single organic insulating layer or organic insulating layers and/or a single inorganic insulating layer or inorganic insulating layers. The intermediate layer may include an emission layer 513 and a first functional layer below the emission layer 513 and/or a second functional layer above the emission layer 513. The opposite electrode 515 may be integral with each other to correspond to the organic light-emitting diodes OLED arranged in the display area DA.

Referring to FIGS. 35 to 37, according to an embodiment of the disclosure, as the first conductive line 300a is arranged or not arranged to correspond to at least the channel region CH1 of the first transistor T1, the disconnection of the channel region CH1 of the first transistor T1 may be minimized (prevented).

According to an embodiment of the disclosure, the ratio of the first capacitor C1, the second capacitor C2, and the third capacitor C3 may be optimized for each pixel by adjusting the degree of overlap between the first conductive line 300a and the second electrode 320, the degree of overlap between the second conductive line 300b and the second electrode 320, the separation distance between the first conductive line 300a and the first electrode 310, and/or the size of the first conductive line 300a and/or the first electrode 310 and/or the width in the y direction of the first conductive line 300a and/or the first electrode 310.

Referring back to FIGS. 35 and 36, the first capacitor C1 of the first pixel PX1 and the second pixel PX2 may include the first electrode C11 and the second electrode C12. The first electrode C11 may include the lower first electrode C11b formed by the first electrode 310, the intermediate first electrode C11m formed by the third electrode 330, and the upper first electrode C11t formed by the connection electrode 373. The lower first electrode C11b and the intermediate first electrode C11m may be electrically connected to each other through the contact hole 31b, and the intermediate first electrode C11m and the upper first electrode C11t may be electrically connected to each other through the contact hole 49b. The second electrode C12 may include the lower second electrode C12b formed by the second electrode 320, the intermediate second electrode C12m formed by the connection electrode 370, and the upper second electrode C12t formed by the connection electrode 383. The lower second electrode C12b and the intermediate second electrode C12m may be electrically connected to each other through the contact hole 41b, and the intermediate second electrode C12m and the upper second electrode C12t may be electrically connected to each other through the contact hole 62b.

A capacitance of the first capacitor C1 may be the sum of a capacitance formed by the lower first electrode C11b and the lower second electrode C12b, a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus, may have (or obtain) an increased capacitance without an increase of the area in the x direction and the y direction.

A y direction width wc2 of the lower first electrode C11b of the first capacitor C1 of the second pixel PX2 may be greater than a y direction width wc2 of the lower first electrode C11b of the first capacitor C1 of the first pixel PX1. The overlapping area between the lower first electrode C11b and the lower second electrode C12b of the first capacitor C1 of the second pixel PX2 may be greater than the overlapping area between the lower first electrode C11b and the lower second electrode C12b of the first capacitor C1 of the first pixel PX1. The sum of the overlapping area between the lower second electrode C12b and the intermediate first electrode C11m of the first capacitor C1 of the first pixel PX1 and the overlapping area between the intermediate first electrode C11m and the intermediate second electrode C12m of the first capacitor C1 of the first pixel PX1 may be greater than the sum of the overlapping area between the lower second electrode C12b and the intermediate first electrode C11m of the first capacitor C1 of the second pixel PX2 and the overlapping area between the intermediate first electrode C11m and the intermediate second electrode C12m of the first capacitor C1 of the second pixel PX2.

The second capacitor C2 of the first pixel PX1 and the second pixel PX2 may include a first electrode C21 formed by the first conductive line 300a and a second electrode C22 formed by the second electrode 320. The area where the second electrode C22 overlaps the first electrode C21 in the second pixel PX2 may be the same as or different from the area where the second electrode C22 overlaps the first electrode C21 in the first pixel PX1.

The third capacitor C3 of the first pixel PX1 and the second pixel PX2 may include a first electrode C31 formed by the second conductive line 300b and a second electrode C32 formed by a portion of the second electrode 320.

Referring to FIG. 37, the first capacitor C1 of the third pixel PX3 may include a first electrode C11 and a second electrode C12. The first electrode C11 may include an intermediate first electrode C11m formed by the third electrode 330 and an upper first electrode C11t formed by the connection electrode 373. The second electrode C12 may include the lower second electrode C12b formed by the second electrode 320, the intermediate second electrode C12m formed by the connection electrode 370, and the upper second electrode C12t formed by the connection electrode 383. A capacitance of the first capacitor C1 may be the sum of a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus may have (obtain) an increased capacitance without an increase of the area in the x direction and the y direction.

The sum of the overlapping area between the lower second electrode C12b and the intermediate first electrode C11m of the first capacitor C1 of the third pixel PX3 and the overlapping area between the intermediate first electrode C11m and the intermediate second electrode C12m of the first capacitor C1 of the third PX3 may be greater than the sum of the overlapping area between the lower second electrode C12b and the intermediate first electrode C11m of the first capacitor C1 of the first pixel PX1 and the overlapping area between the intermediate first electrode C11m and the intermediate second electrode C12m of the first capacitor C1 of the first pixel PX1 and may be greater than the sum of the overlapping area between the lower second electrode C12b and the intermediate first electrode C11m of the first capacitor C1 of the second pixel PX2 and the overlapping area between the intermediate first electrode C11m and the intermediate second electrode C12m of the first capacitor C1 of the second pixel PX2.

The second capacitor C2 of the third pixel PX3 may include the first electrode C21 formed by the first conductive line 300a and the second electrode C22 formed by a portion of the second electrode 320. The area where the second electrode C22 overlaps the first electrode C21 in the third pixel PX3 may be greater than the area where the second electrode C22 overlaps the first electrode C21 in the first pixel PX1 and the second pixel PX2.

The third capacitor C3 of the third pixel PX3 may include the first electrode C31 formed by the second conductive line 300b and the second electrode C32 formed by a portion of the second electrode 320.

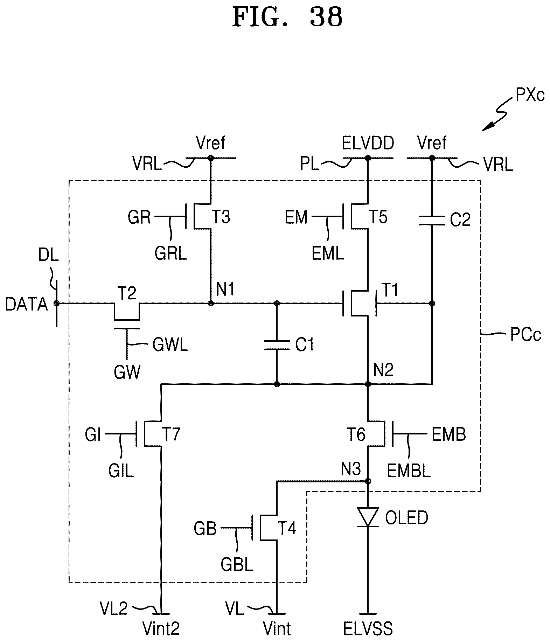

FIG. 38 is a schematic diagrams of equivalent circuits of a pixel PXc according to an embodiment.

A pixel circuit PCc of the pixel PXc shown in FIG. 38 may further include a seventh transistor T7 in addition to the pixel circuit PCa of the pixel PXa shown in FIG. 4.

Referring to FIG. 38, the seventh transistor T7 may be connected between the first transistor T1 and the second initialization voltage line VL2. The seventh transistor T7 may include a gate connected to the second gate line GIL, a first terminal connected to the second node N2, and a second terminal connected to the second initialization voltage line VL2. The first terminal of the seventh transistor T7 may be connected to a second terminal of the first transistor T1, a first terminal of the sixth transistor T6, the first capacitor C1, and the second capacitor C2. The seventh transistor T7 may be turned on by the second gate signal GI transmitted through the second gate line GIL and may be configured to transmit the second initialization voltage Vint2 transmitted through the second initialization voltage line VL2 to the second node N2. The voltage level of the second initialization voltage Vint2 may be lower than that of the initialization voltage Vint.

The fourth transistor T4 of the pixel circuit PCc shown in FIG. 38 may be different from the fourth transistor T4 of the pixel circuit PCa shown in FIG. 4 at least in that the gate of the fourth transistor T4 of the pixel circuit PCc is connected to a sixth gate line GBL to receive a sixth gate signal GB. The gate of the fourth transistor T4 may be connected to the sixth gate line GBL, and the fourth transistor T4 may be configured to be turned on by the sixth gate signal GB transmitted through the sixth gate line GBL and transmit the initialization voltage Vint transmitted through the initialization voltage line VL to the third node N3.

The second capacitor C2 of the pixel circuit PCc shown in FIG. 38 may be different from the second capacitor C2 of the pixel circuit PCa shown in FIG. 4 at least in that the second capacitor C2 of the pixel circuit PCc is connected between the reference voltage line VRL and the second node N2. The first electrode of the second capacitor C2 may be connected to the reference voltage line VRL. The second electrode of the second capacitor C2 may be connected to the second terminal and the second gate of the first transistor T1, the second electrode of the first capacitor C1, the first terminal of the seventh transistor T7, and the first terminal of the sixth transistor T6. A capacitance of each of the first capacitor C1 and the second capacitor C2 may vary according to a color of light emitted from the pixel PXc.

Other configurations of the pixel circuit PCc shown in FIG. 38 may be the same as those of the pixel circuit PCa shown in FIG. 4.

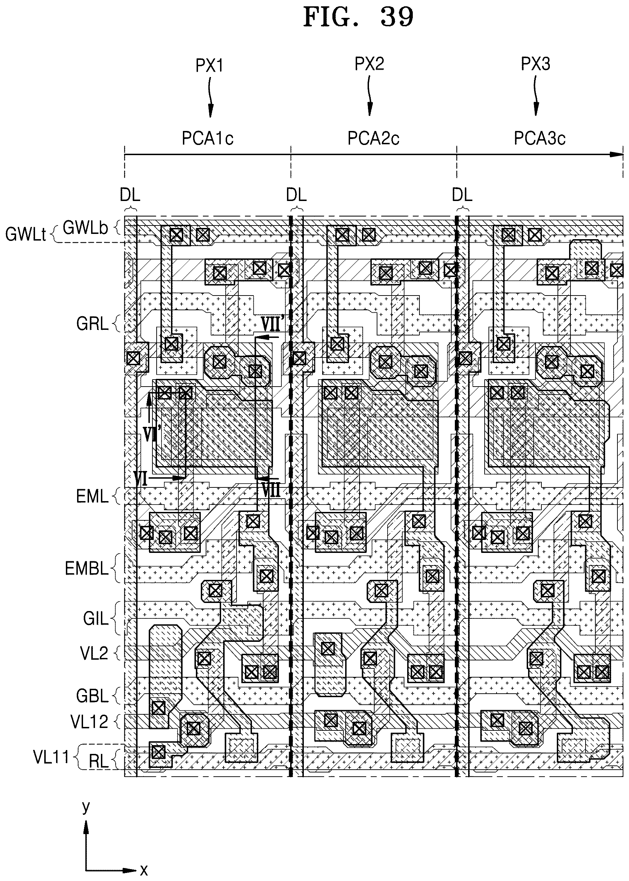

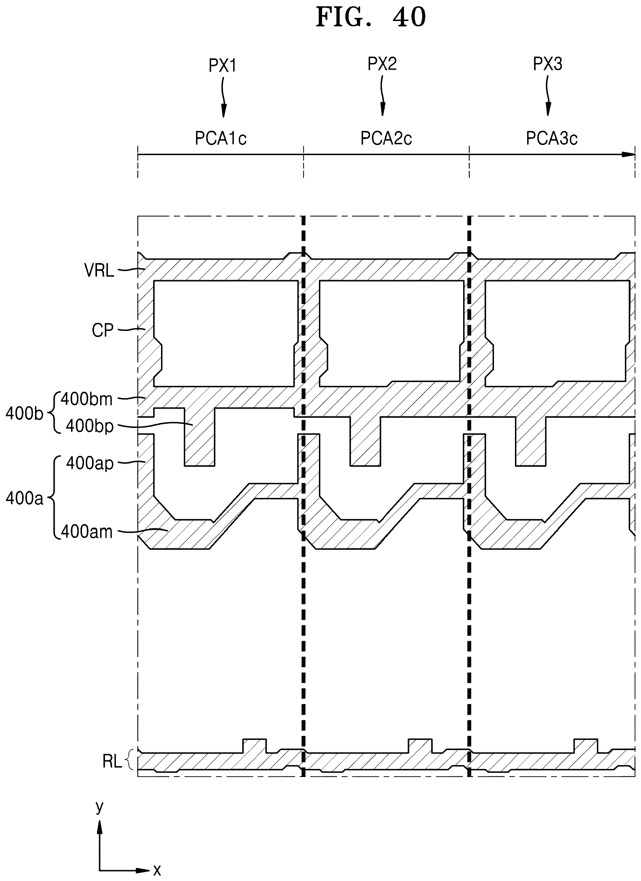

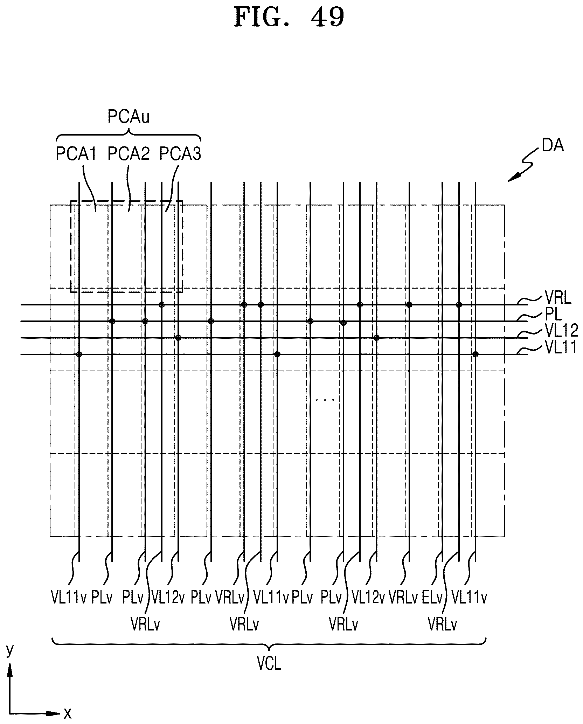

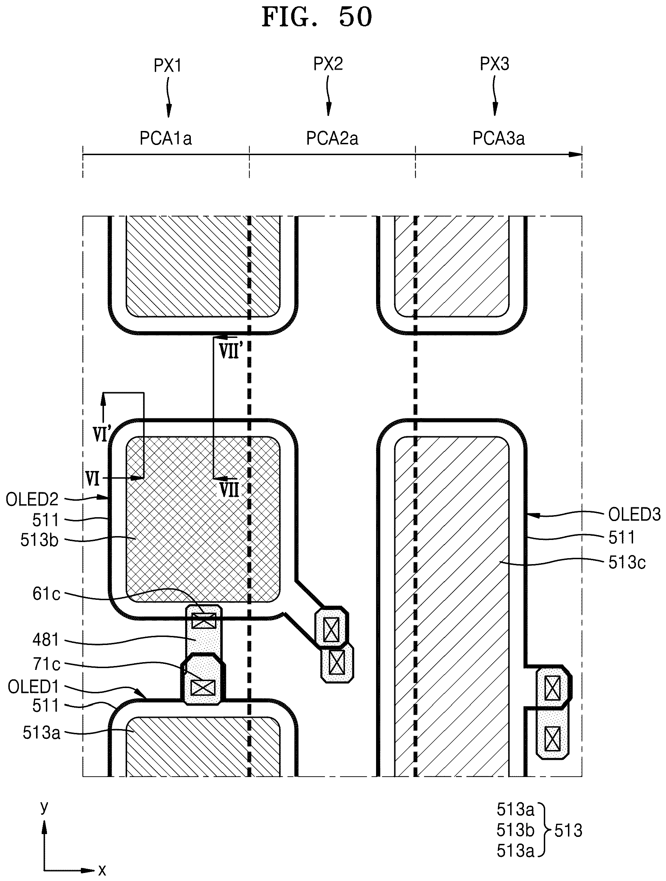

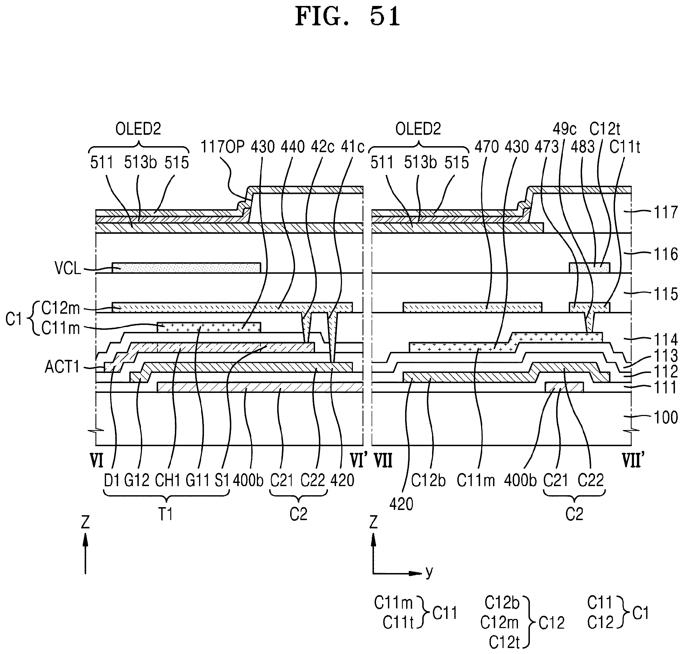

FIG. 39 is a schematic layout view illustrating locations of transistors and capacitors of pixels according to an embodiment. FIGS. 40 to 50 are schematic layout views illustrating elements of a pixel layer for each layer. FIG. 49 is a schematic view illustrating an arrangement of vertical conductive lines according to an embodiment. FIG. 51 is a schematic cross-sectional view of the elements of the pixel, taken along lines VI-VI' and VII-VII' of FIGS. 39 and 50.

In FIG. 39, pixel circuits arranged in a first circuit area PCA1c, a second circuit area PCA2c, and a third circuit area PCA3c may correspond to the pixel circuit PCc of the pixel shown in FIG. 38.

In an embodiment, the pixel circuit PCc of the first pixel PX1 may be connected to a 1-1-th initialization voltage line VL11, and the pixel circuit PCc of the second pixel PX2 and the pixel circuit PCc of the third pixel PX3 may be connected to a 1-2-th initialization voltage line VL12. The initialization voltage supplied to the 1-1-th initialization voltage line VL11 and the initialization voltage supplied to the 1-2-th initialization voltage line VL12 may be different from each other.

Hereinafter, for convenience of illustration and explanation, reference numerals are assigned to the devices of the pixel circuit PCc arranged in the first circuit area PCA1c, and the description is given based on the first circuit area PCA1c. However, the description may be likewise applied to the same elements of the second and third circuit areas PCA2c and PCA3c. Hereinafter, descriptions will be provided with reference to FIGS. 39 to 51.

A first conductive layer may be arranged on the substrate 100. As illustrated in FIG. 40, the first conductive layer may include a first conductive line 400a, a second conductive line 400b, a reference voltage line VRL, and/or a repair line RL. In an embodiment, a barrier layer may be further arranged between the substrate 100 and the first conductive layer.

The first conductive line 400a may extend in the x direction and may be arranged to cross the first circuit area PCA1c, the second circuit area PCA2c, and the third circuit area PCA3c. The first conductive line 400a may be a driving voltage line PL to which the driving voltage ELVDD is applied. The first conductive line 400a may include a main line 400am extending in the x direction and a protrusion portion 400ap protruding in the +y direction from the main line 400am. The protrusion portion 400ap may overlap the data line DL in each circuit area.

The second conductive line 400b may extend in the x direction and may be arranged to cross the first circuit area PCA1c, the second circuit area PCA2c, and the third circuit area PCA3c.

The second conductive line 400b may be a driving voltage line PL to which the reference voltage ELVDD is applied. The second conductive line 400b may include a main line 400bm extending in the x direction and a protrusion portion 400bp protruding in the -y direction from the main line 400bm. The protrusion portion 400bp may overlap the first semiconductor layer ACT1 in each circuit area. The protrusion portion 400bp may overlap the entire channel region of the first transistor T1. The second conductive line 400b may function as the first electrode C21 of the second capacitor C2. For example, the first electrodes C21 of the second capacitors C2 of the first pixel area PCA1c, the second pixel area PCA2c, and the third pixel area PCA3c may be connected to each other.

The reference voltage line VRL may be arranged parallel to the second conductive line 400b, extend in the x direction, and be arranged to cross the first circuit area PCA1c, the second circuit area PCA2c, and the third circuit area PCA3c. The reference voltage line VRL may be connected to the second conductive line 400b through a connection portion CP. Accordingly, the second conductive line 400b may be understood as a portion of the reference voltage line VRL. In an embodiment, the reference voltage line VRL, the second conductive line 400b, and the connection portion CP may be integral with each other as a single body and provided on the same layer. The connection portion CP may overlap the data line DL.

The repair line RL may extend in the x direction and may be arranged to cross the first circuit area PCA1c, the second circuit area PCA2c, and the third circuit area PCA3c.

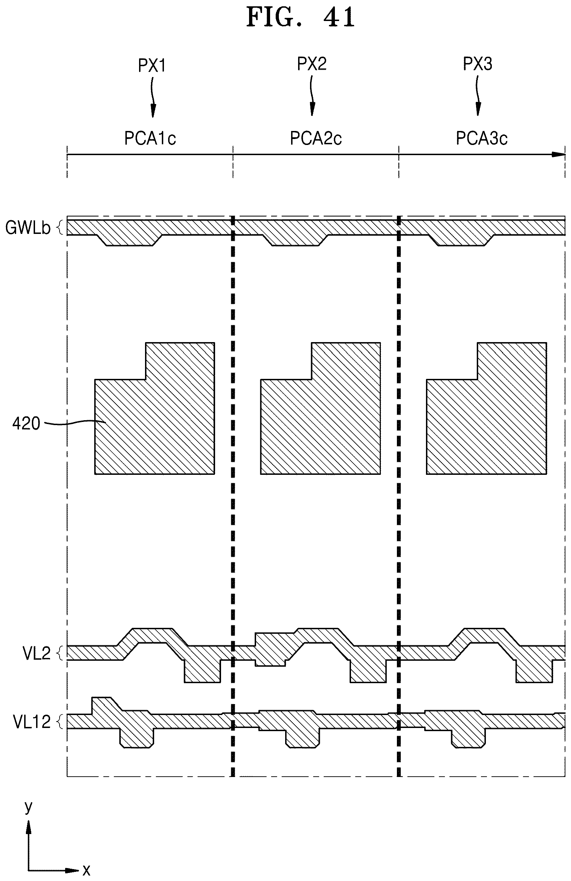

A first insulating layer 111 may be arranged on the substrate 100 to cover the first conductive layer, and a second conductive layer may be arranged on the first insulating layer 111. As illustrated in FIG. 41, the second conductive layer may include a first electrode 420, a lower first gate line GWLb, a second initialization voltage line VL2, and/or a 1-2-th initialization voltage line VL12.

The first electrode 420 may be provided as an island type. The first electrode 420 may overlap the second conductive line 400b and the protrusion portion 400bp. The first electrode 420 may include a second gate electrode G12 and a source electrode of the first transistor T1.

The lower first gate line GWLb, the second initialization voltage line VL2, and the 1-2-th initialization voltage line VL12 may extend in the x direction and may be arranged to cross the first circuit area PCA1c, the second circuit area PCA2c, and the third circuit area PCA3c.

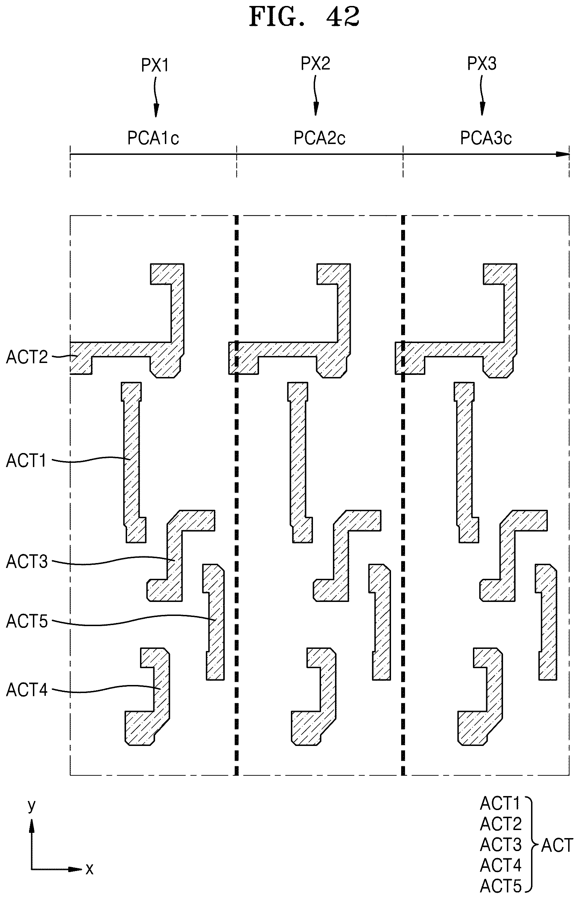

A second insulating layer 112 may be arranged on the first insulating layer 111 to cover the second conductive layer, and on the second insulating layer 112, a semiconductor layer ACT including an oxide semiconductor as shown in FIG. 42 may be arranged. The semiconductor layer ACT may include a first semiconductor layer ACT1, a second semiconductor layer ACT2, a third semiconductor layer ACT3, a fourth semiconductor layer ACT4, and a fifth semiconductor layer ACT5. The semiconductor layer ACT may include a source region, a drain region, and a channel region between the source region and the drain region of each of the first to seventh transistors T1 to T7. The source region or the drain region may also be interpreted as a source electrode or a drain electrode of the transistor, according to embodiments.

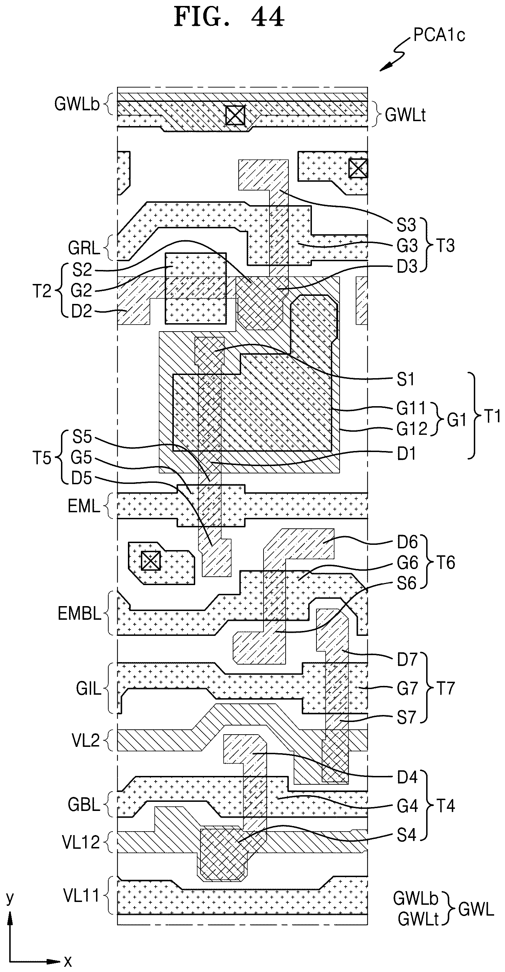

FIG. 44 is a schematic view illustrating transistors of the first circuit area PCA1c. Referring to FIG. 44, the first semiconductor layer ACT1 may include a source region S1 and a drain region D1 of the first transistor T1 and a source region S5 and a drain region D5 of the fifth transistor T5. The second semiconductor layer ACT2 may include a source region S2 and a drain region D2 of the second transistor T2 and a source region S3 and a drain region D3 of the third transistor T3. The third semiconductor layer ACT3 may include a source region S6 and a drain region D6 of the sixth transistor T6. The fourth semiconductor layer ACT4 may include a source region S4 and a drain region D4 of the fourth transistor T4. The fifth semiconductor layer ACT5 may include a source region S7 and a drain region D7 of the seventh transistor T7.

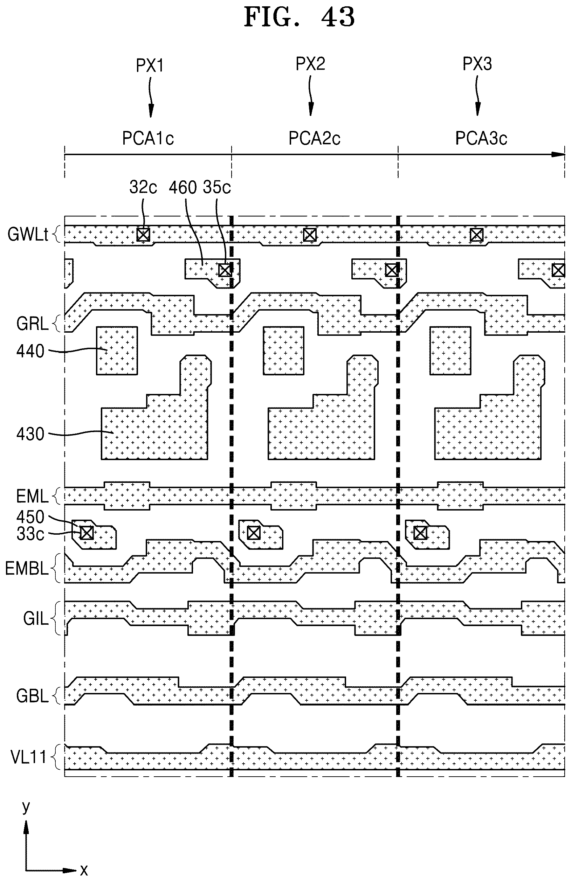

A third insulating layer 113 may be arranged on the second insulating layer 112 to cover the semiconductor layer ACT, and a third conductive layer may be arranged on the third insulating layer 113. As illustrated in FIG. 43, the third conductive layer may include a second electrode 430, a third electrode 440, connection electrodes 450 and 460, an upper first gate line GWLt, a second gate line GIL, a third gate line GRL, a fourth gate line EML, a fifth gate line EMBL, a sixth gate line GBL, and/or a 1-1-th initialization voltage line VL11.

The second electrode 430, the third electrode 440, and the connection electrodes 450 and 460 may be provided as an island type. The second electrode 430, the third electrode 440, and the connection electrodes 450 and 460 may be arranged in each of the first circuit area PCA1c, the second circuit area PCA2c, and the third circuit area PCA3c.

The connection electrode 450 may be electrically connected to a protruding portion 400ap of the first conductive line 400a through a contact hole 33c passing through the first insulating layer 111, the second insulating layer 112, and the third insulating layer 113.

The connection electrode 460 may be electrically connected to a reference voltage line VRL through a contact hole 35c passing through the first insulating layer 111, the second insulating layer 112, and the third insulating layer 113.

The upper first gate line GWLt, the second gate line GIL, the third gate line GRL, the fourth gate line EML, the fifth gate line EMBL, the sixth gate line GBL, and the 1-1-th initialization voltage line VL11 may extend in the x direction and may be arranged to cross the first circuit area PCA1c, the second circuit area PCA2c, and the third circuit area PCA3c.

The upper first gate line GWLt may overlap the lower first gate line GWLb and may be electrically connected to the lower first gate line GWLb through a contact hole 32c passing through the second insulating layer 112 and the third insulating layer 113. The first gate line GWL may have a two-layered structure including a lower first gate line GWLb and an upper first gate line GWLt arranged on different layers.

As illustrated in FIG. 44, the third conductive layer may include gate electrodes G1 to G7 of the first to seventh transistors T1 to T7. The gate electrodes G1 to G7 may overlap channel regions of the semiconductor layer ACT.

Referring to FIG. 44, the second electrode 430 may include the first gate electrode G11 of the first transistor T1. The first gate electrode G11 may overlap the first semiconductor layer ACT1. The third electrode 440 may be the gate electrode G2 of the second transistor T2. The fourth electrode 440 may overlap the second semiconductor layer ACT2. The gate electrode G3 of the third transistor T3 may be a portion of the third gate line GRL overlapping the second semiconductor layer ACT2. The gate electrode G4 of the fourth transistor T4 may be a portion of the sixth gate line GBL overlapping the fourth semiconductor layer ACT4. The gate electrode G5 of the fifth transistor T5 may be a portion of the fourth gate line EML overlapping the first semiconductor layer ACT1. The gate electrode G6 of the sixth transistor T6 may be a portion of the fifth gate line EMBL overlapping the third semiconductor layer ACT3. The gate electrode G7 of the seventh transistor T7 may be a portion of the second gate line GIL overlapping the fifth semiconductor layer ACT5.

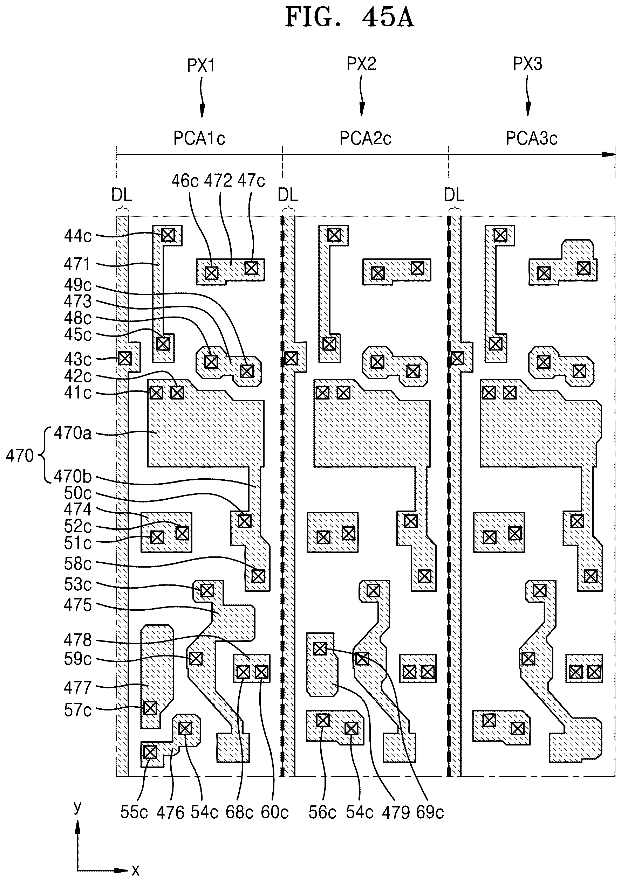

A fourth insulating layer 114 may be arranged on the third insulating layer 113 to cover the third conductive layer, and a fourth conductive layer may be arranged on the fourth insulating layer 114. As illustrated in FIG. 45a, the fourth conductive layer may include a data line DL and connection electrodes 470, 471, 472, 473, 474, 475, 476, 477, 478, and 479.

The data line DL may be arranged to extend in the y direction for each circuit area. The data line DL may be electrically connected to the drain region D2 of the second transistor T2 through a contact hole 43c passing through the third insulating layer 113 and the fourth insulating layer 114.

The connection electrode 470 may include a first area 470a overlapping the second conductive line 400b, the first electrode 420, and the second electrode 430 and a second area 470b protruding in the -y direction from the first area 470a. The connection electrode 470 may electrically connect the source region S1 of the first transistor T1 to the second gate electrode G12 of the first transistor T1 and the sixth transistor T6.

The first area 470a of the connection electrode 470 may be electrically connected to the source region S1 of the first transistor T1 through a contact hole 42c passing through the third insulating layer 113 and the fourth insulating layer 114. The first region 470a of the connection electrode 470 may be electrically connected to the first electrode 420 through a contact hole 41c passing through the second insulating layer 112, the third insulating layer 113, and/or the fourth insulating layer 114. Accordingly, the connection electrode 470 may be a source electrode electrically connected to the source region S1 of the first transistor T1. The first electrode 420 may correspond to the second gate electrode G12 of the first transistor T1, and the second gate electrode G12 may face the first gate electrode G11 of the first transistor T1 and overlap the channel region of the first transistor T1. With the connection electrode 470 connected to the first electrode 420, the second gate electrode G12 of the first transistor T1 may be electrically connected to the source region S1 of the first transistor T1.

The second area 470b of the connection electrode 470 may be electrically connected to the drain region D6 of the sixth transistor T6 through a contact hole 50c passing through the third and fourth insulating layers 113 and 114. The second region 470b of the connection electrode 470 may be electrically connected to the drain region D7 of the seventh transistor T7 through a contact hole 58c passing through the third insulating layer 113 and the fourth insulating layer 114.

The connection electrode 471 may be electrically connected to the gate electrode G2 of the second transistor T2 through a contact hole 45c passing through the fourth insulating layer 114. The connection electrode 471 may be electrically connected to the upper first gate line GWLt through a contact hole 44c passing through the fourth insulating layer 114.

The connection electrode 472 may be electrically connected to the source region S3 of the third transistor T3 through a contact hole 46c passing through the third and fourth insulating layers 113 and 114 and may be electrically connected to the reference voltage line VRL through a contact hole 47c passing through the second to fourth insulating layers 112 to 114.

The connection electrode 473 may be electrically connected to the source region S2 of the second transistor T2 and the drain region D3 of the third transistor T3 through a contact hole 48c passing through the third and fourth insulating layers 113 and 114. The connection electrode 473 may be electrically connected to the second electrode 430 through a contact hole 49c passing through the fourth insulating layer 114 and may be electrically connected to the first gate electrode G11 of the first transistor T1. The connection electrode 473 may correspond to a node electrode corresponding to the first node N1 of FIG. 38. The connection electrode 473 may correspond to a bridge electrode electrically connecting at least two transistors. For example, the connection electrode 473 may correspond to the bridge electrode connecting the first gate electrode G11 of the first transistor T1, the source region S2 of the second transistor T2, and the drain region D3 of the third transistor T3.

The connection electrode 474 may be electrically connected to the protrusion portion 400ap of the first conductive line 400a through a contact hole 51c passing through the first to fourth insulating layers 111 to 114. The connection electrode 474 may be electrically connected to the drain region D5 of the fifth transistor T5 through a contact hole 52c passing through the third insulating layer 113 and the fourth insulating layer 114. Accordingly, the drain region D5 of the fifth transistor T5 may be electrically connected to the first conductive line 400a.

The connection electrode 475 may be electrically connected to the source region S6 of the sixth transistor T6 through a contact hole 53c passing through the third insulating layer 113 and the fourth insulating layer 114. The connection electrode 475 may be electrically connected to the drain region D4 of the fourth transistor T4 through a contact hole 59c passing through the third insulating layer 113 and the fourth insulating layer 114. The connection electrode 475 may overlap a portion of the repair line RL. The connection electrode 475 may be insulated from the repair line RL, and in case that defects occur later in the pixel circuit arranged in the circuit area, the connection electrode 475 may be electrically connected to the repair line RL.

In the first circuit area PCA1c, the connection electrode 476 may be electrically connected to the source region S4 of the fourth transistor T4 through a contact hole 54c passing through the third and fourth insulating layers 113 and 114. The connection electrode 476 may be connected to the 1-1-th initialization voltage line VL11 through a contact hole 55c passing through the fourth insulating layer 114.

In the second and third circuit area PCA2c and PCA3c, the connection electrode 476 may be electrically connected to the source region S4 of the fourth transistor T4 through a contact hole 54c passing through the third and fourth insulating layers 113 and 114. The connection electrode 476 may be electrically connected to the 1-2-th initialization voltage line VL12 through a contact hole 56c passing through the second to fourth insulating layers 112 to 114.

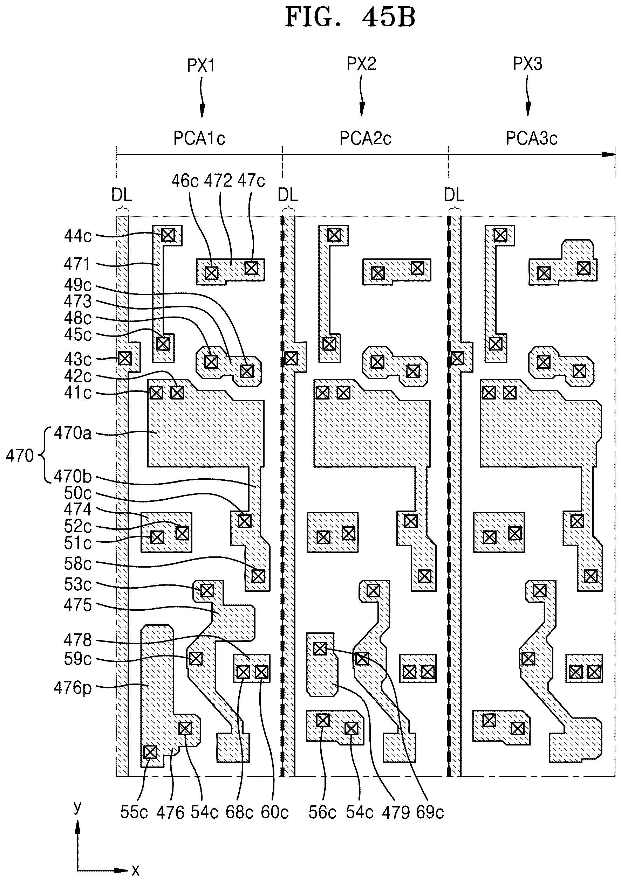

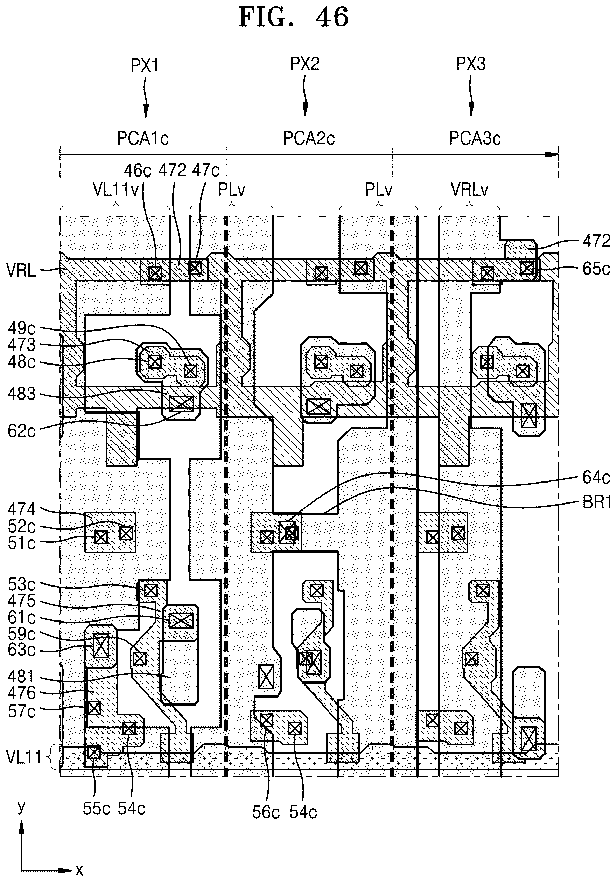

In some of the first circuit areas PCA1c, the connection electrode 476 may further have a protrusion portion 476p, as shown in FIG. 45b. For example, the protrusion portion 476p of the connection electrode 476 may be formed only in the first circuit areas PCA1c where a first vertical initialization voltage line VL11v (see FIG. 46) among the vertical conductive lines described below is arranged.

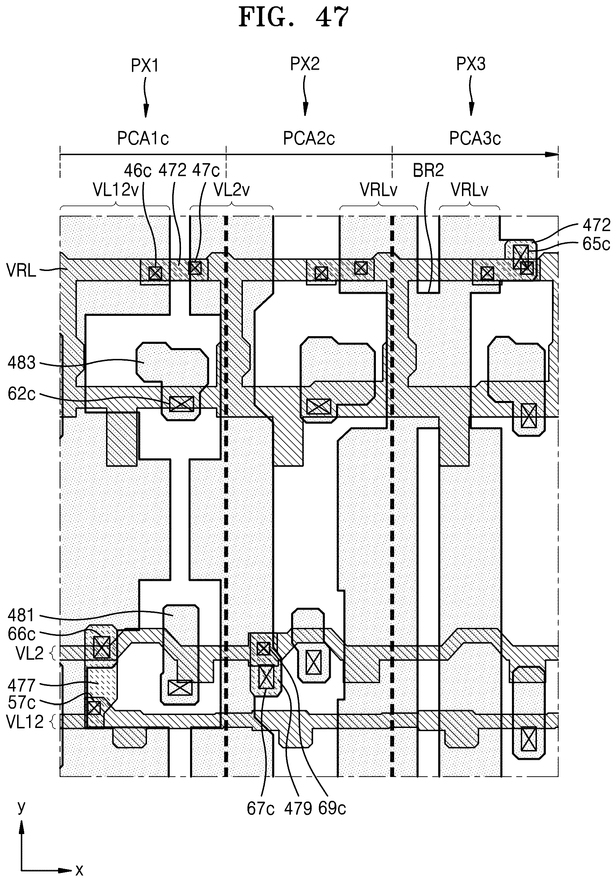

In the first circuit area PCA1c, the connection electrode 477 may be electrically connected to the 1-2-th initialization voltage line VL12 through a contact hole 57c passing through the second to fourth insulating layers 112 to 114. The connection electrode 477 may be arranged in some first circuit areas PCA1c of the first circuit areas PCA1c. For example, the connection electrode 477 may be arranged in only the first circuit areas PCA1c in which a second vertical initialization voltage line VL12v (see FIG. 47) among vertical conductive lines described below is arranged.

The connection electrode 478 may be electrically connected to the source region S7 of the seventh transistor T7 through a contact hole 60c passing through the third insulating layer 113 and the fourth insulating layer 114. The connection electrode 478 may be electrically connected to the second initialization voltage line VL2 through a contact hole 68c passing through the second insulating layer 112, the third insulating layer 113, and the fourth insulating layer 114.

In the second circuit area PCA2c, the connection electrode 479 may be electrically connected to the second initialization voltage line VL12 through a contact hole 69c passing through the second to fourth insulating layers 112 to 114. The connection electrode 479 may be arranged only in some of the second circuit areas PCA2c. For example, the connection electrode 479 may be arranged only in the second circuit areas PCA2c where a third vertical initialization voltage line VL2v (see FIG. 47) among vertical conductive lines described below is arranged.

A fifth insulating layer 115 may be arranged above the fourth insulating layer 114 to cover or overlap the fourth conductive layer, and a fifth conductive layer may be arranged above the fifth insulating layer 115. As illustrated in FIGS. 46 to 49, the fifth conductive layer may include vertical conductive lines VCL and connection electrodes 481 and 483. FIGS. 46 to 48 illustrate only some of lower conductive lines connected to the fifth conductive layer, for convenience of illustration and explanation.

The connection electrode 481 may be electrically connected to the connection electrode 475 through a contact hole 61c passing through the fifth insulating layer 115 and may be electrically connected to the source region S6 of the sixth transistor T6.

The connection electrode 483 may be electrically connected to the connection electrode 470 through a contact hole 62c passing through the fifth insulating layer 115. The connection electrode 483 may be arranged to cover and overlap the connection electrode 473, which is a node electrode. The first electrode 420 may be arranged below the connection electrode 473, and the connection electrode 483 may be arranged above the connection electrode 473. The connection electrode 483 may entirely cover the connection electrode 473, and the first electrode 420 may entirely cover or overlap the connection electrode 473. The connection electrode 483 may function as an upper shielding layer of the connection electrode 473, and the first electrode 420 may function as a lower shielding layer of the connection electrode 473.

The vertical conductive lines VCL may include a vertical driving voltage line PLv, a first vertical initialization voltage line VL11v, a second vertical initialization voltage line VL12v, a third vertical initialization voltage line VL2v, a vertical common voltage line ELv, and a vertical reference voltage line VRLv. The vertical conductive lines VCL each may extend in the y direction and may be arranged to be spaced apart from each other in the x direction in the first to third circuit areas PCA1c to PCA3c.

Four vertical conductive lines may be arranged to be spaced apart from each other in the x direction in the first to third circuit areas PCA1c to PCA3c. For example, four vertical conductive lines among the first vertical initialization voltage line VL11v, the second vertical initialization voltage line VL12v, the third vertical initialization voltage line VL2v, the vertical driving voltage line PLv, the vertical common voltage line ELv, and the vertical reference voltage line VRLv may be arranged to be spaced apart from each other in the x direction. The vertical conductive lines VCL may be electrically connected to horizontal conductive lines extending in the x direction. The horizontal conductive lines VCL may include the conductive line 400 that is the driving voltage line PL, the 1-1-th initialization voltage line VL11, the 1-2-th initialization voltage line VL12, and the reference voltage line VRL.

FIG. 46 illustrate an example in which a first vertical initialization voltage line VL11v, a pair of vertical driving voltage lines PLv, and a vertical reference voltage line VRLv are sequentially arranged in the x direction in the first to third circuit areas PCA1c to PCA3c.

FIG. 47 illustrates an example in which a second vertical initialization voltage line VL12v, a third vertical initialization voltage line VL2v, a pair of vertical reference voltage lines VRLv are sequentially arranged in the x direction in the first to third circuit areas PCA1c to PCA3c.

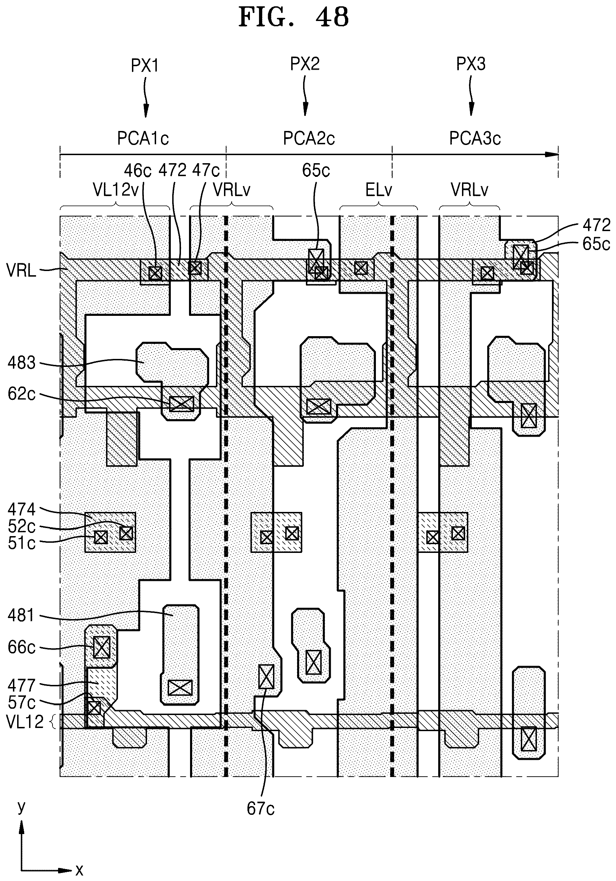

FIG. 48 illustrates an example in which a second vertical initialization voltage line VL12v, a vertical reference voltage line VRLv, a vertical common voltage line ELv, and a vertical reference voltage line VRLv are sequentially arranged in the x direction in the first to third circuit areas PCA1c to PCA3c.

A pair of vertical conductive lines VCL adjacent to each other may be connected by a connection portion. The pair of vertical conductive lines VCL may be integral with each other. For example, as illustrated in FIG. 46, a pair of vertical driving voltage lines PLv adjacent to each other may be connected by a connection portion BR1. The pair of vertical driving voltage lines PLv may be integral with each other. As illustrated in FIG. 47, a pair of vertical reference voltage lines VRLv adjacent to each other may be connected by a connection portion BR2. The pair of vertical reference voltage lines VRLv may be integral with each other. In an embodiment, the connecting portions BR1 and BR2 may be located in every two rows. For example, as illustrated in FIG. 46, the pair of vertical driving voltage lines PLv may be connected to each other by the connection portion BR1 in odd-numbered rows or even-numbered rows and may be spaced apart from each other without the connection portion BR1 in even-numbered rows or odd-numbered rows.

In an embodiment, as shown in FIG. 49, a first vertical conductive line VCL of the unit circuit area PCAu may be the first vertical initialization voltage line VL11v or a second vertical initialization voltage line VL12v. A fourth vertical conductive line VCL of the unit circuit area PCAu may be the vertical reference voltage line VRLv. Second and third vertical conductive lines VCL of the unit circuit area PCAu may be the pair of vertical driving voltage lines PLv, the pair of vertical driving voltage lines PLv and the vertical reference voltage line VRLv, or the pair of vertical reference voltage lines VRLv and the vertical common voltage line ELv.

As illustrated in FIG. 46, the vertical driving voltage line PLv may be electrically connected to the connection electrode 474 arranged in the second circuit area PCA2c through a contact hole 64c passing through the fifth insulating layer 115. The connection electrode 474 may be electrically connected to the first conductive line 400a, which is the driving voltage line PL, and the driving voltage line PL may have a mesh structure in the display area DA.

As illustrated in FIG. 46, the first vertical initialization voltage line VL11v may be electrically connected to the connection electrode 476 arranged in the first circuit area PCA1c through a contact hole 63c passing through the fifth insulating layer 115. The connection electrode 476 may be electrically connected to the 1-1-th initialization voltage line VL11, and the 1-1-th initialization voltage line VL11 may have a mesh structure in the display area DA.

As illustrated in FIG. 47, the second vertical initialization voltage line VL12v may be electrically connected to the connection electrode 477 arranged in the first circuit area PCA1c through a contact hole 66c passing through the fifth insulating layer 115. The connection electrode 477 may be electrically connected to the 1-2-th initialization voltage line VL12, and the 1-2-th initialization voltage line VL12 may have a mesh structure in the display area DA.

As illustrated in FIG. 47, the third vertical initialization voltage line VL2v may be electrically connected to the connection electrode 479 arranged in the second circuit area PCA2c through a contact hole 67c passing through the fifth insulating layer 115. The connection electrode 479 may be electrically connected to the second initialization voltage line VL2, and the second initialization voltage line VL2 may have a mesh structure in the display area DA.

As illustrated in FIGS. 46 to 48, the vertical reference voltage line VRLv may be electrically connected to the connection electrode 472 arranged in the second circuit area PCA2c and/or the third circuit area PCA3c through a contact hole 65c passing through the fifth insulating layer 115. The connection electrode 472 may be electrically connected to the reference voltage line VRL, and the reference voltage line VRL may have a mesh structure in the display area DA.

The vertical common voltage line ELv may be electrically connected to the common voltage supply line 13 (see FIG. 2) arranged in the peripheral area PA.

Although not shown in the drawings, voltage supply lines electrically connected to the horizontal conductive lines and/or the vertical conductive lines may be further arranged in the peripheral area PA. The voltage supply lines may be arranged on at least one of an upper side, a lower side, a left side, and a right side of the display area DA.

The connection electrodes having the same functions and corresponding to the first to third circuit areas PCA1a to PCA3a may have different shapes and locations from each other according to locations of the lines arranged in the first to third circuit areas PCA1c to PCA3c.

A sixth insulating layer 116 may be arranged above the fifth insulating layer 115 to cover or overlap the fifth conductive layer, and an organic light-emitting diode OLED may be arranged above the sixth insulating layer 116 as a display element. The organic light-emitting diode OLED may include a pixel electrode 511, an opposite electrode 515, and an intermediate layer between the pixel electrode 511 and the opposite electrode 515.

The pixel electrode 511 may be electrically connected to the connection electrode 481, which is a lower conductive pattern, through a contact hole 71c of the sixth insulating layer 116, and thus may be electrically connected to the first transistor T1. As illustrated in FIG. 50, the pixel electrode 511 connected to the pixel circuit of the first pixel PX1 may be electrically connected to the connection electrode 481 arranged in the first circuit area PCA1c, and thus may be electrically connected to the first transistor T1. The pixel electrode 511 connected to the pixel circuit of the second pixel PX2 may be electrically connected to the connection electrode 481 arranged in the second circuit area PCA2c, and thus may be electrically connected to the first transistor T1. The pixel electrode 511 connected to the pixel circuit of the third pixel PX3 may be electrically connected to the connection electrode 481 arranged in the third circuit area PCA3c, and thus may be electrically connected to the first transistor T1.

As shown in FIG. 3, an auxiliary electrode AE may be further arranged on the same layer as the pixel electrode 511.

As illustrated in FIG. 51, a seventh insulating layer 117, which is a pixel-defining layer covering an edge of the pixel electrode 511, may be arranged above the pixel electrode 511. An opening 117OP exposing a portion of the pixel electrode 511 and defining an emission area may be defined in the seventh insulating layer 117. The seventh insulating layer 117 may be a single organic insulating layer or organic insulating layers and/or a single inorganic insulating layer or inorganic insulating layers. The intermediate layer may include an emission layer 513 and a first functional layer below the emission layer 513 and/or a second functional layer above the emission layer 513. The opposite electrode 515 may be integral with each other to correspond to the organic light-emitting diodes OLED arranged in the display area DA.

Referring to FIG. 51, the protrusion portion 400bp of the second conductive line 400b may correspond to the entire channel region CH1 of the first transistor T1 in each circuit area. According to an embodiment of the disclosure, as the protruding portion 400bp of the second conductive line 400b is arranged to correspond to at least the channel region CH1 of the first transistor T1, the disconnection of the channel region CH1 of the first transistor T1 due to a step may be minimized (prevented).

The first capacitor C1 of the first pixel PX1, the second pixel PX2, and the third pixel PX3 may include a first electrode C11 and a second electrode C12. The first electrode C11 may include an intermediate first electrode C11m formed by the second electrode 430 and an upper first electrode C11t formed by the connection electrode 473. The intermediate first electrode C11m and the upper first electrode C11t may be electrically connected to each other through a contact hole 49c. The second electrode C12 may include the lower second electrode C12b formed by the first electrode 420, the intermediate second electrode C12m formed by the connection electrode 470, and/or the upper second electrode C12t formed by the connection electrode 483. The lower second electrode C12b and the intermediate second electrode C12m may be electrically connected to each other through the contact hole 41c, and the intermediate second electrode C12m and the upper second electrode C12t may be electrically connected to each other through the contact hole 62c.

A capacitance of the first capacitor C1 may be the sum of a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus may have (obtain) an increased capacitance without an increase of the area in the x direction and the y direction.

The second capacitor C2 may include a first electrode C21 formed by the second conductive line 400b connected to the reference voltage line VRL and a second electrode C22 formed by the first electrode 420. The capacitance of the second capacitor C2 for each pixel may be adjusted according to the y direction width of the second conductive line 400b including the first electrode C21 and the area where the second electrode C22 overlaps the first electrode C21.

In the display apparatus according to an embodiment of the disclosure, the disconnection of a semiconductor layer due to a lower step may be prevented as at least a conductive layer arranged under the semiconductor layer of a driving transistor corresponds to at least a channel region of the semiconductor layer of the driving transistor.

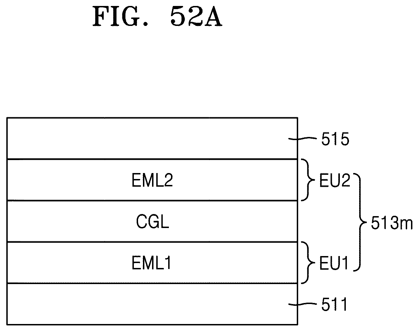

FIGS. 52a to 53b are schematic cross-sectional views illustrating a structure of a display element according to an embodiment.

An organic light-emitting diode OLED as the display element according to an embodiment may include the pixel electrode 511, the opposite electrode 515, and an intermediate layer 513m between the pixel electrode 511 (a first electrode, an anode) and the opposite electrode 515 (a second electrode, a cathode).

The pixel electrode 511 may include a transmissive conductive oxide, such as indium tin oxide (ITO), indium zinc oxide (IZO), zinc oxide (ZnO), indium oxide (In₂O₃), indium gallium oxide (IGO), or aluminum zinc oxide (AZO). The pixel electrode 511 may include a reflective layer including Ag, Mg, Al, Pt, Pd, Au, Ni, Nd, Ir, Cr, or a compound thereof. For example, the pixel electrode 511 may have a triple-layered structure of ITO/Ag/ITO.

The opposite electrode 515 may be arranged on the intermediate layer 513m. The opposite electrode 515 may include a metal having a low work function, an alloy, an electrically conductive compound, or an arbitrary combination thereof. For example, the opposite electrode 515 may include Li, Ag, Mg, Al, Al-Li, Ca, Mg-In, Mg-Ag, Yb, Ag-Yb, ITO, IZO, or an arbitrary combination thereof. The opposite electrode 515 may include a transmissive electrode, a transflective electrode, or a reflection electrode.

The intermediate layer 513m may include a high molecular-weight organic material or a low molecular-weight organic material emitting a certain color of light. The intermediate layer 513m may further include a metal-containing compound, such as an organic metal compound, and an inorganic material, such as quantum dots, in addition to various organic materials.

In an embodiment, the intermediate layer 513m may include an emission layer and a first functional layer and a second functional layer below and above the emission layer, respectively. The first functional layer may include, for example, a hole transport layer HTL, or a hole transport layer HTL and a hole injection layer HIL. The second functional layer may include an electron transport layer ETL and/or an electron injection layer EIL. The first functional layer or the second functional layer may be omitted. The first functional layer and the second functional layer may be integral with each other to correspond to the organic light-emitting diodes OLEDs included in the display area DA.

In an embodiment, the intermediate layer 513m may include at least two emitting parts and a charge generation layer CGL, the at least two emitting parts may be sequentially stacked between the pixel electrode 511 and the opposite electrode 515, and the charge generation layer CGL may be arranged between the at least two emitting parts. In case that the intermediate layer 513m includes the emitting part and the charge generation layer CGL, the organic light-emitting diode OLED may be a tandem light-emitting device. In case that the organic light-emitting diode OLED has the stacked structure of the emitting parts, the organic light-emitting diode OLED may have improved color purity and emission efficiency.

An emitting part may include an emission layer and a first functional layer and a second functional layer below and above the emission layer, respectively. The charge generation layer CGL may include a negative charge generation layer and a positive charge generation layer. Based on the negative charge generation layer and the positive charge generation layer, the emission efficiency of the organic light-emitting diode OLED, which is the tandem light-emitting device including the emission layers, may be further increased.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

In an embodiment, as illustrated in FIG. 52a, the organic light-emitting diode OLED may include a first emitting part EU1 including a first emission layer EML1 and a second emitting part EU2 including a second emission layer EML2, and the first emitting part EU1 and the second emitting part EU2 may be sequentially stacked each other. The charge generation layer CGL may be provided between the first emitting part EU1 and the second emitting part EU2. For example, the organic light-emitting diode OLED may include the pixel electrode 511, the first emission layer EML1, the charge generation layer CGL, the second emission layer EML2, and the opposite electrode 515 that are sequentially stacked each other. The first functional layer and the second functional layer may be included below and above the first emission layer EML1, respectively. The first functional layer and the second functional layer may be included below and above the second emission layer EML2, respectively. The first emission layer EML1 may be a blue emission layer, and the second emission layer EML2 may be a yellow emission layer.

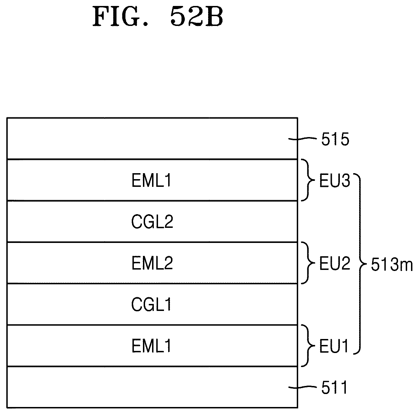

In an embodiment, as illustrated in FIG. 52b, the organic light-emitting diode OLED may include the first emitting part EU1 and a third emitting part EU3 including the first emission layer EML1 and the second emitting part EU2 including the second emission layer EML2. A first charge generation layer CGL1 may be provided between the first emitting part EU1 and the second emitting part EU2, and a second charge generation layer CGL2 may be provided between the second emitting part EU2 and the third emitting part EU3. For example, the organic light-emitting diode OLED may include the pixel electrode 511, the first emission layer EML1, the first charge generation layer CGL1, the second emission layer EML2, the second charge generation layer CGL2, the first emission layer EML1, and the opposite electrode 515 that are sequentially stacked each other. The first functional layer and the second functional layer may be included below and above the first emission layer EML1, respectively. The first functional layer and the second functional layer may be included below and above the second emission layer EML2, respectively. The first emission layer EML1 may be a blue emission layer, and the second emission layer EML2 may be a yellow emission layer.

In an embodiment, the organic light-emitting diode OLED may include the second emitting part EU2 that may further include a third emission layer EML3 and/or a fourth emission layer EML4 directly contacting the second emission layer EML2 below and/or above the second emission layer EML2, in addition to the second emission layer EML2. Here, directly contacting may denote that no layer may be arranged between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

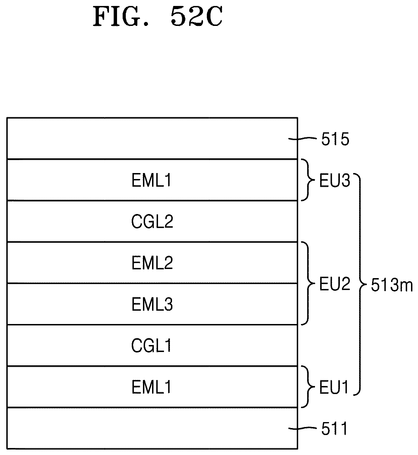

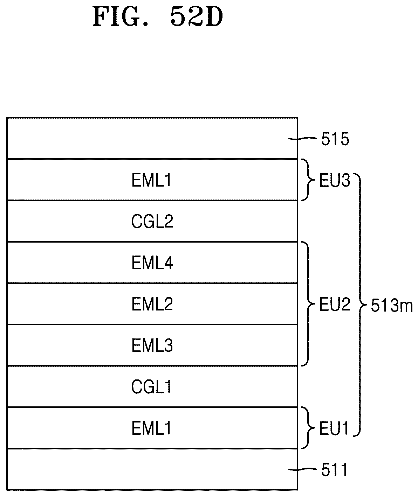

For example, as illustrated in FIG. 52c, the organic light-emitting diode OLED may include the pixel electrode 511, the first emission layer EML1, the first charge generation layer CGL1, the third emission layer EML3, the second emission layer EML2, the second charge generation layer CGL2, the first emission layer EML1, and the opposite electrode 515 that are sequentially stacked each other. As another example, as illustrated in FIG. 52D, the organic light-emitting diode OLED may include the pixel electrode 511, the first emission layer EML1, the first charge generation layer CGL1, the third emission layer EML3, the second emission layer EML2, the fourth emission layer EML4, the second charge generation layer CGL2, the first emission layer EML1, and the opposite electrode 515 that are sequentially stacked each other.

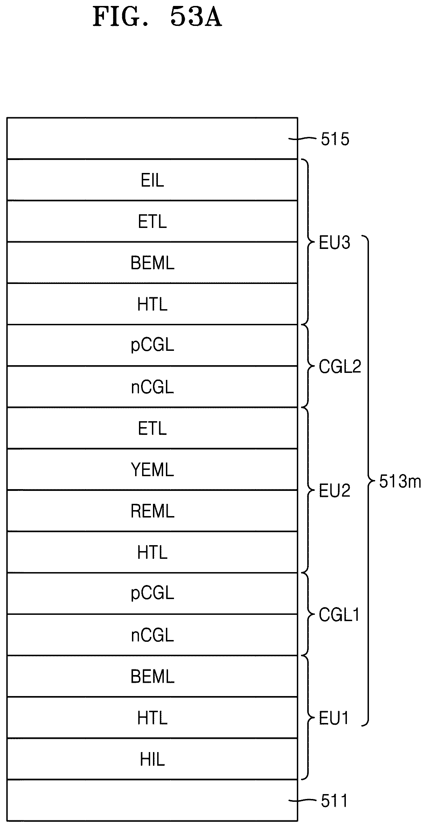

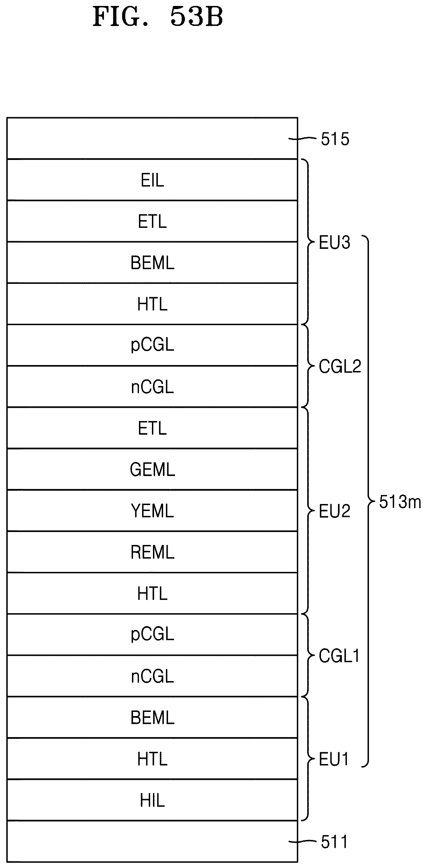

FIG. 53a is a schematic cross-sectional view illustrating an example of the organic light-emitting diode OLED of FIG. 52c, and FIG. 53b is a schematic cross-sectional view illustrating an example of the organic light-emitting diode OLED of FIG. 52D.

Referring to FIG. 53a, the organic light-emitting diode OLED may include the first emitting part EU1, the second emitting part EU2, and the third emitting part EU3 that are sequentially stacked each other. The first charge generation layer CGL1 may be provided between the first emitting part EU1 and the second emitting part EU2, and the second charge generation layer CGL2 may be provided between the second emitting part EU2 and the third emitting part EU3. Each of the first charge generation layer CGL1 and the second charge generation layer CGL2 may include a negative charge generation layer nCGL and a positive charge generation layer pCGL.

The first emitting part EU1 may include a blue emission layer BEML. The first emitting part EU1 may further include a hole injection layer HIL and a hole transport layer HTL between the pixel electrode 511 and the blue emission layer BEML. In an embodiment, a p-doping layer may be further included between the hole injection layer HIL and the hole transport layer HTL. The p-doping layer may be formed by doping the hole injection layer HIL with a p-type doing material. In an embodiment, at least one of a blue light auxiliary layer, an electron block layer, and a buffer layer may be further included between the blue emission layer BEML and the hole transport layer HTL. The blue light auxiliary layer may increase the emission efficiency of the blue emission layer BEML. The blue light auxiliary layer may increase the emission efficiency of the blue emission layer BEML by adjusting a hole charge balance. The electron block layer may prevent the injection of electrons into the hole transport layer HTL. The buffer layer may compensate for a resonance distance according to a wavelength of the light emitted from the emission layer.

The second emitting part EU2 may include a yellow emission layer YEML and a red emission layer REML directly contacting the yellow emission layer YEML below the yellow emission layer YEML. The second emitting part EU2 may further include a hole transport layer HTL between the positive charge generation layer pCGL of the first charge generation layer CGL1 and the red emission layer REML and may further include an electron transport layer ETL between the yellow emission layer YEML and the negative charge generation layer nCGL of the second charge generation layer CGL2.

The third emitting part EU3 may include the blue emission layer BEML. The third emitting part EU3 may further include a hole transport layer HTL between the positive charge generation layer pCGL of the second charge generation layer CGL2 and the blue emission layer BEML. The third emitting part EU3 may further include an electron transport layer ETL and an electron injection layer EIL between the blue emission layer BEML and the opposite electrode 515. The electron transport layer ETL may include a single layer or layers. In an embodiment, at least one of a blue light auxiliary layer, an electron block layer, and a buffer layer may be further included between the blue emission layer BEML and the hole transport layer HTL. At least one of a hole block layer and a buffer layer may be further included between the blue emission layer BEML and the electron transport layer ETL. The hole block layer may prevent the injection of holes into the electron transport layer ETL.

The organic light-emitting diode OLED illustrated in FIG. 53b may have a different stack structure of the second emitting part EU2 from the organic light-emitting diode OLED illustrated in FIG. 53a, and except for the stack structure of the second emitting part EU2, may have the same structure as the organic light-emitting diode OLED illustrated in FIG. 53a. Referring to FIG. 53b, the second emitting part EU2 may include the yellow emission layer YEML, the red emission layer REML directly contacting the yellow emission layer YEML below the yellow emission layer YEML, and a green emission layer GEML directly contacting the yellow emission layer YEML above the yellow emission layer YEML. The second emitting part EU2 may further include a hole transport layer HTL between the positive charge generation layer pCGL of the first charge generation layer CGL1 and the red emission layer REML and may further include an electron transport layer ETL between the green emission layer GEML and the negative charge generation layer nCGL of the second charge generation layer CGL2.

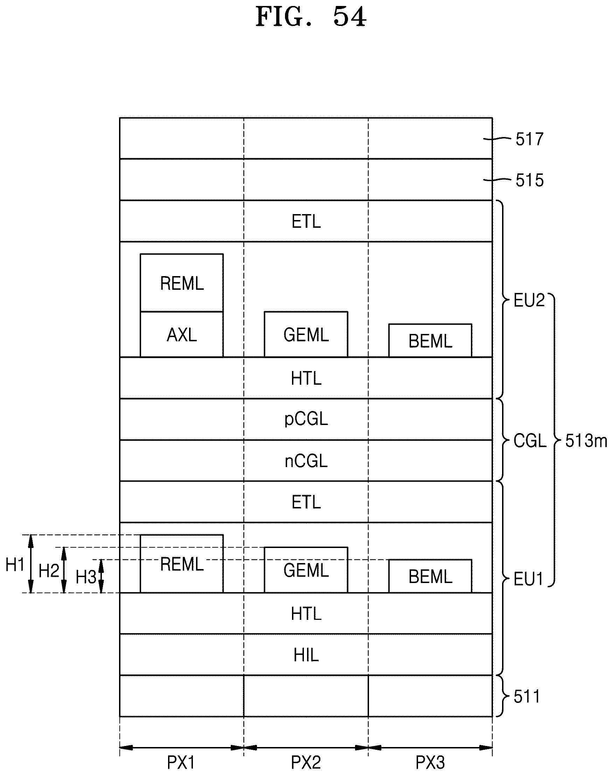

FIG. 54 is a schematic cross-sectional view illustrating a structure of a pixel of a display apparatus according to an embodiment.

Referring to FIG. 54, the display apparatus may include pixels. The pixels may include a first pixel PX1, a second pixel PX2, and a third pixel PX3. Each of the first to third pixels PX1 to PX3 may include the pixel electrode 511, the opposite electrode 515, and the intermediate layer 513m. In an embodiment, the first pixel PX1 may include a red pixel, the second pixel PX2 may include a green pixel, and the third pixel PX3 may include a blue pixel. Here, the pixel may include an organic light-emitting diode OLED as a display element, and the organic light-emitting diode OLED of each pixel may be electrically connected to a pixel circuit.

The pixel electrode 511 may be separately provided in each of the first pixel PX1, the second pixel PX2, and the third pixel PX3.

The intermediate layer 513m of the organic light-emitting diode OLED of each of the first to third pixels PX1 to PX3 may include a first emitting part EU1 and a second emitting part EU2 that are sequentially stacked each other, and a charge generation layer CGL between the first emitting part EU1 and the second emitting part EU2. The charge generation layer CGL may include a negative charge generation layer nCGL and a positive charge generation layer pCGL. The charge generation layer CGL may be a common layer continually formed throughout the first to third pixels PX1 to PX3.

The first emitting part EU1 of the first pixel PX1 may include a hole injection layer HIL, a hole transport layer HTL, a red emission layer REML, and an electron transport layer ETL that are sequentially stacked each other on the pixel electrode 511. The first emitting part EU1 of the second pixel PX2 may include a hole injection layer HIL, a hole transport layer HTL, a green emission layer GEML, and an electron transport layer ETL that are sequentially stacked each other on the pixel electrode 511. The first emitting part EU1 of the third pixel PX3 may include a hole injection layer HIL, a hole transport layer HTL, a blue emission layer BEML, and an electron transport layer ETL that are sequentially stacked each other on the pixel electrode 511. Each of the hole injection layer HIL, the hole transport layer HTL, and the electron transport layer ETL of each of the first emitting parts EU1 may be a common layer continually formed throughout the first to third pixels PX1 to PX3.

The second emitting part EU2 of the first pixel PX1 may include a hole transport layer HTL, an auxiliary layer AXL, a red emission layer REML, and an electron transport layer ETL that are sequentially stacked each other on the charge generation layer CGL. The second emitting part EU2 of the second pixel PX2 may include a hole transport layer HTL, a green emission layer GEML, and an electron transport layer ETL that are sequentially stacked each other on the charge generation layer CGL. The second emitting part EU2 of the third pixel PX3 may include a hole transport layer HTL, a blue emission layer BEML, and an electron transport layer ETL that are sequentially stacked each other on the charge generation layer CGL. Each of the hole transport layer HTL and the electron transport layer ETL of each of the second emitting parts EU2 may be a common layer continually formed throughout the first to third pixels PX1 through PX3. In an embodiment, in the second emitting parts EU2 of the first to third pixels PX1 to PX3, at least one of a hole block layer and a buffer layer may be further included between the emission layer and the electron transport layer ETL.

A thickness H1 of the red emission layer REML, a thickness H2 of the green emission layer GEML, and a thickness H3 of the blue emission layer BEML may be determined according to a resonance distance. The auxiliary layer AXL may be an area added to adjust the resonance distance and may include a resonance auxiliary material. For example, the auxiliary layer AXL may include the same material as the hole transport layer HTL.

FIG. 54 illustrates that the auxiliary layer AXL may be included in only the first sub-pixel PX1. However, an embodiment of the disclosure is not limited thereto. For example, the auxiliary layer AXL may be provided in at least one of the first to third pixels PX1 to PX3 to adjust the resonance distance of the at least one of the first to third pixels PX1 to PX3.

The display apparatus may further include a capping layer 517 arranged outside the opposite electrode 515. The capping layer 517 may increase emission efficiency based on a constructive interference principle. Therefore, because the light extraction efficiency of the organic light-emitting diode OLED is increased, the emission efficiency of the organic light-emitting diode OLED may be increased.

It should be understood that embodiments described herein should be considered in a descriptive sense only and not for purposes of limitation. Descriptions of features or aspects within each embodiment should be considered as available for other similar features or aspects in other embodiments. While one or more embodiments have been described with reference to the figures, it will be understood by those of ordinary skill in the art that various changes in form and details may be made therein without departing from the spirit and scope of the disclosure and as defined by the following claims.

## Claims

1. A display apparatus comprising:
a first conductive line;
a first electrode arranged on the first conductive line and overlapping the first conductive line;
a semiconductor layer arranged on the first electrode and overlapping the first electrode;
a second electrode arranged on the semiconductor layer and overlapping the first electrode; and
a third electrode arranged on the second electrode, overlapping the second electrode, and electrically connected to the semiconductor layer and the first electrode,
wherein an area of the semiconductor layer which overlaps the second electrode, overlaps the first conductive line.

2. The display apparatus of claim 1, further comprising:
a fourth electrode electrically connected to the second electrode, the fourth electrode and the third electrode being arranged on a same layer; and
a fifth electrode arranged on the fourth electrode, overlapping the fourth electrode, and electrically connected to the third electrode.

3. The display apparatus of claim 1, further comprising:
a sixth electrode, the sixth electrode and the first conductive line being arranged on a same layer, wherein
the first electrode, the second electrode, and the third electrode overlap the sixth electrode, and
the second electrode is electrically connected to the sixth electrode.

4. The display apparatus of claim 3, wherein
an opening overlapping the sixth electrode is defined in the first electrode, and
the second electrode is electrically connected to the sixth electrode through the opening.

5. The display apparatus of claim 3, further comprising:
a seventh electrode electrically connected to the second electrode, the seventh electrode and the third electrode being arranged on a same layer; and
an eighth electrode arranged on the seventh electrode, overlapping the seventh electrode, and electrically connected to the third electrode.

6. The display apparatus of claim 1, further comprising:
a second conductive line spaced apart from the first conductive line, the second conductive line and the first conductive line being disposed on a same layer,
wherein a voltage applied to the second conductive line is different from a voltage applied to the first conductive line.

7. The display apparatus of claim 6, wherein the first electrode overlaps the second conductive line.

8. A display apparatus comprising:
a first circuit area where a pixel circuit of a first pixel is arranged and a second circuit area where a pixel circuit of a second pixel is arranged;
a first conductive line arranged in the first circuit area and the second circuit area;
a first electrode arranged on the first conductive line and overlapping the first conductive line, the first electrode being arranged in each of the first circuit area and the second circuit area;
a semiconductor layer arranged on the first electrode and overlapping the first electrode, the semiconductor layer being arranged in each of the first circuit area and the second circuit area;
a second electrode arranged on the semiconductor layer and overlapping the first electrode, the second electrode being arranged in each of the first circuit area and the second circuit area; and
a third electrode arranged on the second electrode, overlapping the second electrode, and electrically connected to the semiconductor layer and the first electrode, the third electrode being arranged in each of the first circuit area and the second circuit area,
wherein an area of the semiconductor layer which overlaps the second electrode, overlaps the first conductive line.

9. The display apparatus of claim 8, further comprising:
a fourth electrode electrically connected to the second electrode, the fourth electrode being arranged in each of the first circuit area and the second circuit area, the fourth electrode and the third electrode being arranged on a same layer; and
a fifth electrode arranged on the fourth electrode, overlapping the fourth electrode, and electrically connected to the third electrode, the fifth electrode being arranged in each of the first circuit area and the second circuit area.

10. The display apparatus of claim 8, further comprising:
a sixth electrode, the sixth electrode and the first conductive line being arranged on a same layer in the first circuit area, wherein
the first electrode, the second electrode, and the third electrode overlap the sixth electrode, and
the second electrode is electrically connected to the sixth electrode.

11. The display apparatus of claim 10, wherein, in the first circuit area, an opening overlapping the sixth electrode is defined in the first electrode, and the second electrode is electrically connected to the sixth electrode through the opening.

12. The display apparatus of claim 10, further comprising:
a seventh electrode electrically connected to the second electrode, the seventh electrode being arranged in each of the first circuit area and the second circuit area, the seventh electrode and the third electrode being arranged on a same layer; and
an eighth electrode arranged on the seventh electrode, overlapping the seventh electrode, and electrically connected to the third electrode, the eighth electrode being arranged in each of the first circuit area and the second circuit area.

13. A display apparatus comprising:
a first circuit area where a pixel circuit of a first pixel is arranged and a second circuit area where a pixel circuit of a second pixel is arranged;
a first conductive line arranged in the first circuit area and the second circuit area;
a second conductive line spaced apart from the first conductive line, the second conductive line and the first conductive line being disposed on a same layer in the first circuit area and the second circuit area;
a first electrode arranged on the first conductive line and overlapping the first conductive line, the first electrode being arranged in each of the first circuit area and the second circuit area;
a semiconductor layer arranged on the first electrode and overlapping the first electrode, the semiconductor layer being arranged in each of the first circuit area and the second circuit area;
a second electrode arranged on the semiconductor layer and overlapping the first electrode, the second electrode being arranged in each of the first circuit area and the second circuit area; and
a third electrode arranged on the second electrode, overlapping the second electrode, and electrically connected to the semiconductor layer and the first electrode, the third electrode being arranged in each of the first circuit area and the second circuit area,
wherein an area of the semiconductor layer which overlaps the second electrode, overlaps the first conductive line.

14. The display apparatus of claim 13, further comprising:
a fourth electrode electrically connected to the second electrode, the fourth electrode being arranged in each of the first circuit area and the second circuit area, the fourth electrode and the third electrode being arranged on a same layer; and
a fifth electrode arranged on the fourth electrode, overlapping the fourth electrode, and electrically connected to the third electrode, the fifth electrode being arranged in each of the first circuit area and the second circuit area.

15. The display apparatus of claim 13, further comprising:
a sixth electrode, the sixth electrode and the first conductive line being arranged on a same layer in the first circuit area, wherein
the first electrode, the second electrode, and the third electrode overlap the sixth electrode, and
the second electrode is electrically connected to the sixth electrode.

16. The display apparatus of claim 15, wherein, in the first circuit area, an opening overlapping the sixth electrode is defined in the first electrode, and the second electrode is electrically connected to the sixth electrode through the opening.

17. The display apparatus of claim 15, further comprising:
a seventh electrode electrically connected to the second electrode, the seventh electrode being arranged in each of the first circuit area and the second circuit area, the seventh electrode and the third electrode being arranged on a same layer; and
an eighth electrode arranged on the seventh electrode, overlapping the seventh electrode, and electrically connected to the third electrode, the eighth electrode being arranged in each of the first circuit area and the second circuit area.

18. The display apparatus of claim 17, further comprising:
a third circuit area where a pixel circuit of a third pixel is arranged, wherein the first conductive line and the second conductive line extend into the third circuit area,
the first conductive line includes a plurality of sub-conductive lines spaced apart from each other, and
an area which overlaps the second electrode, of the semiconductor layer arranged in the third circuit area is located between the sub-conductive lines.

19. The display apparatus of claim 13, wherein the first electrode overlaps the second conductive line.

20. The display apparatus of claim 19, wherein an area where the first electrode arranged in the first circuit area overlaps the second conductive line is different from an area where the first electrode arranged in the second circuit area overlaps the second conductive line.
